(19) Europäisches Patentamt
European Patent Office
Office européen des brevets

(11) EP 4 117 050 A1

(12) EUROPEAN PATENT APPLICATION

(43) Date of publication:
**11.01.2023 Bulletin 2023/02**

(21) Application number: **22183727.1**

(22) Date of filing: **08.07.2022**

(51) International Patent Classification (IPC):
***H01L 51/50*** $^{(2006.01)}$ *H01L 51/30* $^{(2006.01)}$

(52) Cooperative Patent Classification (CPC):
**H01L 51/5088; H01L 51/506;** H01L 51/006; H01L 51/0071; H01L 51/0085; H01L 2251/552

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.07.2021 CN 202110771635**

(71) Applicant: **Beijing Summer Sprout Technology Co., Ltd.**
**Beijing 102308 (CN)**

(72) Inventors:
- **XIE, Menglan**
  **Beijing, 102308 (CN)**
- **KWON, Chi Yuen Raymond**
  **Beijing, 102308 (CN)**
- **PANG, Huiqing**
  **Beijing, 102308 (CN)**
- **CUI, Zhihao**
  **Beijing, 102308 (CN)**
- **WANG, Jing**
  **Beijing, 102308 (CN)**
- **DING, Hualong**
  **Beijing, 102308 (CN)**
- **XIA, Chuanjun**
  **Beijing, 102308 (CN)**

(74) Representative: **Ricker, Mathias**
**Wallinger Ricker Schlotter Tostmann**
**Patent- und Rechtsanwälte Partnerschaft mbB**
**Zweibrückenstrasse 5-7**
**80331 München (DE)**

# (54) ORGANIC ELECTROLUMINESCENT DEVICE

(57) Provided is an organic electroluminescent device. The organic electroluminescent device comprises an anode, a cathode and an organic layer disposed between the anode and the cathode, wherein the organic layer comprises a first organic layer, the first organic layer contains a first organic material and a second organic material that satisfy particular energy level requirements, and the first organic layer has a conductivity greater than or equal to $3 \times 10^{-5}$ S/m. The novel organic electroluminescent device effectively controls a hole injection ability so that the overall performance of the device is effectively improved. Further provided are an organic electroluminescent device and a first organic electroluminescent device.

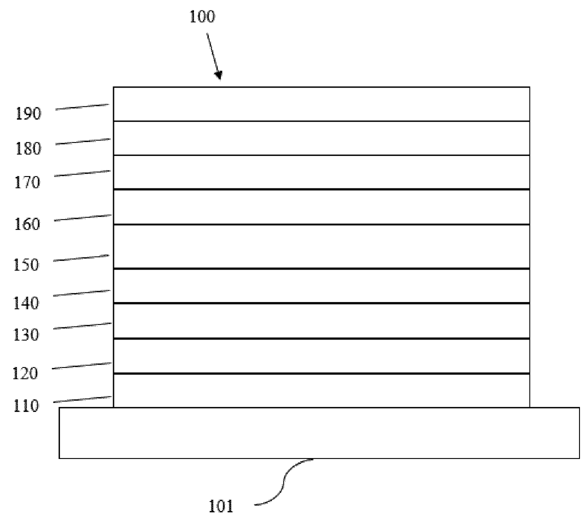


FIG. 1

EP 4 117 050 A1

## Description

TECHNICAL FIELD

The present disclosure relates to organic electronic devices, for example, organic electroluminescent devices. More particularly, the present disclosure relates to an organic electroluminescent device having a first organic layer, wherein the first organic layer contains a first organic material and a second organic material that satisfy particular energy level requirements and the first organic layer has a conductivity greater than or equal to $3\times10^{-5}$ S/m.

BACKGROUND

Organic electronic devices include, but are not limited to, the following types: organic light-emitting diodes (OLEDs), organic field-effect transistors (O-FETs), organic light-emitting transistors (OLETs), organic photovoltaic devices (OPVs), dye-sensitized solar cells (DSSCs), organic optical detectors, organic photoreceptors, organic field-quench devices (OFQDs), light-emitting electrochemical cells (LECs), organic laser diodes and organic plasmon emitting devices.

An organic electroluminescent device (OLED) is composed of a cathode, an anode and a series of organic light-emitting materials stacked between the cathode and the anode, converts electrical energy into light through a voltage applied at both the cathode and the anode of the device, and has the advantages of a wide viewing angle, a high contrast and a faster response time. In 1987, Tang and Van Slyke of Eastman Kodak reported an organic light-emitting device, which includes an arylamine hole transporting layer and a tris-8-hydroxyquinolato-aluminum layer as an electron transporting layer and a light-emitting layer (Applied Physics Letters, 1987, 51 (12): 913-915). Once a voltage is applied across the device, green light was emitted from the device. This device laid a foundation for the development of modern OLEDs. State-of-the-art OLEDs may each include multiple layers such as a charge injection and transporting layer, a charge and exciton blocking layer and one or more emissive layers between the cathode and the anode. Since the OLED is a self-luminous solid-state device, it offers tremendous potential for display and lighting applications. In addition, the inherent properties of organic materials, such as their flexibility, may make them well suited for particular applications such as fabrication on flexible substrates. The OLED has the advantages of a low cost, low power consumption, high brightness, a wide viewing angle, a small thickness, etc. and has been widely applied in the fields of display and lighting after decades of development.

The OLED can be categorized as three different types according to its emitting mechanism. The OLED invented by Tang and van Slyke is a fluorescent OLED. It only utilizes singlet emission. The triplets generated in the device are wasted through nonradiative decay channels. Therefore, the internal quantum efficiency (IQE) of the fluorescent OLED is only 25%. This limitation hindered the commercialization of OLED. In 1997, Forrest and Thompson reported phosphorescent OLED, which uses triplet emission from heavy metal containing complexes as the emitter. As a result, both singlet and triplets can be harvested, achieving 100% IQE. The discovery and development of phosphorescent OLED contributed directly to the commercialization of active-matrix OLED (AMOLED) due to its high efficiency. Recently, Adachi achieved high efficiency through thermally activated delayed fluorescence (TADF) of organic compounds. These emitters have small singlet-triplet gap that makes the transition from triplet back to singlet possible. In the TADF device, the triplet excitons can go through reverse intersystem crossing to generate singlet excitons, resulting in high IQE.

OLEDs can also be classified as small molecule and polymer OLEDs according to the forms of the materials used. A small molecule refers to any organic or organometallic material that is not a polymer. The molecular weight of the small molecule can be large as long as it has well defined structure. Dendrimers with well-defined structures are considered as small molecules. Polymer OLEDs include conjugated polymers and non-conjugated polymers with pendant emitting groups. Small molecule OLED can become the polymer OLED if post polymerization occurred during the fabrication process.

There are various methods for OLED fabrication. Small molecule OLEDs are generally fabricated by vacuum thermal evaporation. Polymer OLEDs are fabricated by solution process such as spin-coating, inkjet printing, and slit printing. If the material can be dissolved or dispersed in a solvent, the small molecule OLED can also be produced by solution process.

An OLED device is generally composed of multiple organic functional layers stacked. In addition to an emissive layer (EML), the OLED device also includes a hole injection layer (HIL), a hole transporting layer (HTL), an electron blocking layer (EBL), a hole blocking layer (HBL), an electron transporting layer (ETL), an electron injection layer (EIL) and other functional layers. The hole injection layer and the electron injection layer inject holes and electrons into the device from an anode and a cathode, respectively. Then, two kinds of charge carriers are migrated to the emissive layer through transporting layers and recombined to form excitons in the emissive layer, and radiation occurs when the excitons fall back from an excited state to a ground state, thereby achieving light emission.

The effective recombination of electrons and holes is an important factor affecting the quantum efficiency of light emission of the device. At present, the balance of the charge carriers in the OLED device is mainly improved by

the following three methods: the first is to use appropriate electron and hole injection materials to balance injected charge carriers, the second is to improve electron and hole transporting materials to change the abilities of organic transporting materials to transport charge carriers to achieve the balance, and the third is to improve a device structure to achieve the balance of the charge carriers. Organic hole transporting materials (HTMs) in the existing OLED device are mostly aromatic amine compounds which have relatively strong electron donating abilities and thus can achieve good hole injection. However, on the side of electron injection and transport, there are relatively a few types of organic materials to select from. Assuming that electrons and holes injected from the cathode and the anode have the same concentration, due to differences in performance between materials themselves, a hole mobility ($10^{-6}$-$10^{-4}$ $cm^2/Vs$) in the OLED structure is 1-3 orders of magnitude higher than an electron mobility ($10^{-5}$-$10^{-3}$ $cm^2/Vs$), that is, the concentration of holes transported to the emissive layer is much greater than that of electrons transported to the emissive layer, resulting in an unbalanced charge carrier concentration. A charge carrier imbalance easily causes charge carriers to accumulate at an interface between film layers and generate heat, accelerating the aging of the device and reducing a lifetime, but also the charge carrier imbalance reduces the recombination probability of excitons, resulting in a decrease in device efficiency. Therefore, it is an effective manner of improving device efficiency to effectively delay the arrival of holes at a light-emitting region.

In order to control the hole injection ability, M. A. Abkowitz et al. studied and compared, in their paper (J. Phys. Chem. B 2000, 104, 3948-3952), the hole injection ability from ITO to a hole transporting layer NPB and the hole injection ability from ITO to NPB with a layer of CuPc having a different thickness added therebetween. It was found that the introduction of CuPc weakened the hole injection ability of the device, but the efficiency of the device was significantly improved and the voltage of the device was also increased. M. A. Abkowitz et al. believe that since the reduced hole injection ability can better balance charge carriers, that is, the number of holes reaching the light-emitting region is relatively reduced, the device efficiency is improved; however, since CuPc that hinders hole injection is used for reducing hole injection efficiency, the voltage of the device is sharply increased although the device efficiency is improved. In practical application, too high a voltage will increase the power consumption of the device and the device is manufactured by too complicated a process.

The hole injection layer (HIL) in the existing OLED device generally controls the hole injection ability by using a hole transporting material (HTM) doped with an appropriate amount of p-type conductive doping material (PD) so that the anode is in ohmic contact with the HIL. The conductivity of the HIL can reflect the strength of the hole injection ability to a certain extent. Usually, an appropriate p-type conductive doping material is selected and a doping proportion is adjusted to control the conductivity of the thin film and control the hole injection ability of the HIL. Commonly used p-type conductive doping materials are organic materials. For example, TWI330047 discloses a combination of HTM:PD, where the conductivity of its HIL doped with PD ranges from $10^{-6}$ S/m to 1 S/m. However, in current researches, a difference between a LUMO energy level of the p-type conductive doping material and a HOMO energy level of the hole transporting material is relatively small. In this manner, the HIL with a high conductivity can be obtained at a relatively low doping concentration (for example, 1-3 wt%). Too high a conductivity is easy to exacerbate the imbalance between holes and electrons, which is not conducive to improving device performance. On the other hand, a smaller amount of p-type dopants is difficult to be precisely controlled in a device preparation process and then the conductivity of the HIL is difficult to control.

## SUMMARY

The present disclosure aims to provide a novel organic electroluminescent device to solve at least part of the above problems. The novel organic electroluminescent device includes an anode, a cathode and an organic layer disposed between the anode and the cathode, the organic layer includes a first organic layer, the first organic layer contains a first organic material and a second organic material that satisfy particular energy level requirements, and the first organic layer has a conductivity greater than or equal to $3\times10^{-5}$ S/m. The novel organic electroluminescent device effectively controls a hole injection ability so that the overall performance of the device is effectively improved.

According to an embodiment of the present disclosure, an organic electroluminescent device is disclosed, which comprises:

an anode, a cathode and an organic layer disposed between the anode and the cathode;
wherein the organic layer comprises a first organic layer containing a first organic material and a second organic material;
the LUMO energy level of the first organic material is denoted as $LUMO_{first_organic_material}$, the HOMO energy level of the second organic material is denoted as $HOMO_{second_organic_material}$, $HOMO_{second_organic_material} \leq -5.1$ eV, and $LUMO_{first_organic_material} - HOMO_{second_organic_material} \geq 0.3$ eV; and
the first organic layer has a conductivity greater than or equal to $3\times10^{-5}$ S/m.

According to another embodiment of the present disclosure, an organic electroluminescent device is further disclosed, which comprises:

an anode, a cathode and an organic layer disposed between the anode and the cathode;
wherein the organic layer comprises a first organic layer containing a first organic material and a second organic material, wherein the LUMO energy level of the first organic material is denoted as $LUMO_{first_organic_material}$, the HOMO energy level of the second organic material is denoted as $HOMO_{second_organic_material}$, and $LUMO_{first_organic_material} - HOMO_{second_organic_material} \geq 0.3$ eV; the first organic layer has a conductivity greater than or equal to $3\times10^{-5}$ S/m; and the second organic material has a structure represented by Formula H:

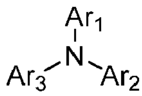

Formula H ;

wherein in Formula H,

$Ar_1$, $Ar_2$ and $Ar_3$ are, at each occurrence identically or differently, selected from substituted or unsubstituted aryl having 6 to 30 carbon atoms or substituted or unsubstituted heteroaryl having 3 to 30 carbon atoms;
when $Ar_1$, $Ar_2$ and $Ar_3$ are, at each occurrence identically or differently, selected from substituted aryl having 6 to 30 carbon atoms or substituted heteroaryl having 3 to 30 carbon atoms, the aryl or heteroaryl is substituted with one or more groups selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents $Ar_1$, $Ar_2$ and $Ar_3$ can be optionally joined to form a ring.

According to another embodiment of the present disclosure, a first organic electroluminescent device is further disclosed, which comprises:

an anode, a cathode and an organic layer disposed between the anode and the cathode;
wherein the organic layer comprises a first organic layer being in contact with the anode and containing a first organic material and a second organic material;
the first organic layer has a conductivity greater than or equal to $3\times10^{-5}$ S/m;
an efficiency-to-voltage ratio $\eta$ of the first organic electroluminescent device is greater than or equal to 104% of an efficiency-to-voltage ratio $\eta$ of a second organic electroluminescent device at the same current density; wherein $\eta = EQE/(voltage \times \xi)$, and $\xi$ denotes a proportion of excitons allowed to be emitted in quantum mechanics; the second organic electroluminescent device has the same device structure as the first organic electroluminescent device except that: the organic layer that is in contact with the anode in the second organic electroluminescent device is a third organic layer containing a third organic material and a fourth organic material, and materials in at least one of the following two groups are the same: group (i): the first organic material and the third organic material, and group (ii): the second organic material and the fourth organic material; and
the third organic layer in the second organic electroluminescent device at least satisfies one of the following requirements:

(1) the HOMO energy level of the fourth organic material is denoted as $HOMO_{fourth_organic_material}$, and $HOMO_{fourth_organic_material} > -5.1$ eV;

(2) the LUMO energy level of the third organic material is denoted as $LUMO_{third_organic_material}$, the HOMO energy level of the fourth organic material is denoted as $HOMO_{fourth_organic_material}$, and $LUMO_{third_organic_material}$ - $HOMO_{fourth_organic_material}$ < 0.3 eV;
(3) the third organic layer has a conductivity of less than $3\times10^{-5}$ S/m.

The novel organic electroluminescent device disclosed in the present disclosure includes the anode, the cathode and the organic layer disposed between the anode and the cathode, the organic layer includes the first organic layer, the first organic layer contains the first organic material and the second organic material that satisfy particular energy level requirements, and the first organic layer has a conductivity greater than or equal to $3\times10^{-5}$ S/m. The novel organic electroluminescent device effectively controls the hole injection ability so that the overall performance of the device is effectively improved.

BRIEF DESCRIPTION OF DRAWINGS

FIG. 1 is a schematic diagram of an organic light-emitting apparatus that may include an organic electroluminescent device of the present disclosure.
FIG. 2 is a schematic diagram of another organic light-emitting apparatus that may include an organic electroluminescent device of the present disclosure.
FIG. 3 is a trend graph of a change of the conductivity of an organic thin film formed by Compound 1-2 and Compound HT-7 with a doping proportion of Compound 1-2.
FIG. 4 is a trend graph of a change of the conductivity of an organic thin film formed by Compound 3-2 and Compound HT-7 with a doping proportion of Compound 3-2.

DETAILED DESCRIPTION

OLEDs can be fabricated on various types of substrates such as glass, plastic, and metal foil. FIG. 1 schematically shows an organic light-emitting device 100 without limitation. The figures are not necessarily drawn to scale. Some of the layers in the figures can also be omitted as needed. Device 100 may include a substrate 101, an anode 110, a hole injection layer 120, a hole transport layer 130, an electron blocking layer 140, an emissive layer 150, a hole blocking layer 160, an electron transport layer 170, an electron injection layer 180 and a cathode 190. Device 100 may be fabricated by depositing the layers described in order. The properties and functions of these various layers, as well as example materials, are described in more detail in U.S. Pat. No. 7,279,704 at cols. 6-10, the contents of which are incorporated by reference herein in its entirety.

More examples for each of these layers are available. For example, a flexible and transparent substrate-anode combination is disclosed in U.S. Pat. No. 5,844,363, which is incorporated by reference herein in its entirety. An example of a p-doped hole transport layer is m-MTDATA doped with F4-TCNQ at a molar ratio of 50:1, as disclosed in U.S. Patent Application Publication No. 2003/0230980, which is incorporated by reference herein in its entirety. Examples of host materials are disclosed in U.S. Pat. No. 6,303,238 to Thompson et al., which is incorporated by reference herein in its entirety. An example of an n-doped electron transport layer is BPhen doped with Li at a molar ratio of 1:1, as disclosed in U.S. Patent Application Publication No. 2003/0230980, which is incorporated by reference herein in its entirety. U.S. Pat. Nos. 5,703,436 and 5,707,745, which are incorporated by reference herein in their entireties, disclose examples of cathodes including composite cathodes having a thin layer of metal such as Mg:Ag with an overlying transparent, electrically-conductive, sputter-deposited ITO layer. The theory and use of blocking layers are described in more detail in U.S. Pat. No. 6,097,147 and U.S. Patent Application Publication No. 2003/0230980, which are incorporated by reference herein in their entireties. Examples of injection layers are provided in U.S. Patent Application Publication No. 2004/0174116, which is incorporated by reference herein in its entirety. A description of protective layers may be found in U.S. Patent Application Publication No. 2004/0174116, which is incorporated by reference herein in its entirety.

The layered structure described above is provided by way of non-limiting examples. Functional OLEDs may be achieved by combining the various layers described in different ways, or layers may be omitted entirely. It may also include other layers not specifically described. Within each layer, a single material or a mixture of multiple materials can be used to achieve optimum performance. Any functional layer may include several sublayers. For example, the emissive layer may have two layers of different emitting materials to achieve desired emission spectrum.

In one embodiment, an OLED may be described as having an "organic layer" disposed between a cathode and an anode. This organic layer may include a single layer or multiple layers.

An OLED can be encapsulated by a barrier layer. FIG. 2 schematically shows an organic light emitting device 200 without limitation. FIG. 2 differs from FIG. 1 in that the organic light emitting device include a barrier layer 102, which

is above the cathode 190, to protect it from harmful species from the environment such as moisture and oxygen. Any material that can provide the barrier function can be used as the barrier layer such as glass or organic-inorganic hybrid layers. The barrier layer should be placed directly or indirectly outside of the OLED device. Multilayer thin film encapsulation was described in U.S. Pat. No. 7,968,146, which is incorporated by reference herein in its entirety.

Devices fabricated in accordance with embodiments of the present disclosure can be incorporated into a wide variety of consumer products that have one or more of the electronic component modules (or units) incorporated therein. Some examples of such consumer products include flat panel displays, monitors, medical monitors, televisions, billboards, lights for interior or exterior illumination and/or signaling, heads-up displays, fully or partially transparent displays, flexible displays, smart phones, tablets, phablets, wearable devices, smart watches, laptop computers, digital cameras, camcorders, viewfinders, micro-displays, 3-D displays, vehicles displays, and vehicle tail lights.

The materials and structures described herein may be used in other organic electronic devices listed above.

As used herein, "top" means furthest away from the substrate, while "bottom" means closest to the substrate. Where a first layer is described as "disposed over" a second layer, the first layer is disposed further away from the substrate. There may be other layers between the first and second layers, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the transition between the triplet states and the singlet excited states. Compounds that are capable of generating E-type delayed fluorescence are required to have very small singlet-triplet gaps to convert between energy states. Thermal energy can activate the transition from the triplet state back to the singlet state. This type of delayed fluorescence is also known as thermally activated delayed fluorescence (TADF). A distinctive feature of TADF is that the delayed component increases as temperature rises. If the reverse intersystem crossing (RISC) rate is fast enough to minimize the non-radiative decay from the triplet state, the fraction of back populated singlet excited states can potentially reach 75%. The total singlet fraction can be 100%, far exceeding 25% of the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap ($\Delta E_{S-T}$). Organic, non-metal containing, donor-acceptor luminescent materials may be able to achieve this. The emission in these materials is generally characterized as a donor-acceptor charge-transfer (CT) type emission. The spatial separation of the HOMO and LUMO in these donor-acceptor type compounds generally results in small $\Delta E_{S-T}$. These states may involve CT states. Generally, donor-acceptor luminescent materials are constructed by connecting an electron donor moiety such as amino- or carbazole-derivatives and an electron acceptor moiety such as N-containing six-membered aromatic rings.

In the present disclosure, the highest occupied molecular orbital (HOMO) energy level and the lowest unoccupied molecular orbital (LUMO) energy level of an organic material are measured by an electrochemical cyclic voltammetry method. In the present disclosure, all "HOMO energy levels" and "LUMO energy levels" are expressed as negative values, and the smaller the numerical value (i.e., the larger the absolute value), the deeper the energy level. In the present disclosure, the expression that the energy level is smaller than a certain number means that the numerical value of the energy level is smaller than this number, i.e., is more negative. For example, the expression that "the HOMO energy level of the second organic material is less than or equal to -5.1 eV" means that the numerical value of the HOMO energy level of the second organic material is equal to -5.1 eV or more negative than -5.1 eV, for example, the HOMO energy level of the second organic material is -5.13 eV. In the present disclosure, the difference between the LUMO energy level of a first organic material (p-type conductive doping material, PD) and the HOMO energy level of the second organic material (hole transporting material (HTM)) is defined as $LUMO_{PD} - HOMO_{HTM}$, which is positive since the HOMO energy level of the transporting material is generally deeper.

In the present disclosure, only when the HOMO energy level of the HTM in an HIL and/or an HTL is $\leq$ -5.1 eV, can an expected effect be achieved. In an OLED device, the HOMO energy level of a host material is usually -5.4 eV or deeper. To better match with the host material, the HOMO energy level of the HTM is required to be relatively deep. In addition, limited by the structure, currently the HOMO energy level of the existing HTM is generally not smaller than

- 5.9 eV, that is, greater than or equal to -5.9 eV.

The term "hole injection ability" refers to the efficiency of hole injection from an anode into an organic layer in a device and may be characterized by conductivity.

The term "conductivity" refers to that in a high vacuum (for example, $10^{-6}$ Torr) environment, to-be-tested sample materials are co-deposited through evaporation at a certain doping proportion on a test substrate pre-prepared with aluminum electrodes to form a to-be-tested region with a thickness of 100 nm, a length of 6 mm and a width of 1 mm, the resistance value of the to-be-tested region is obtained by applying a voltage to the electrodes and measuring a current at room temperature, and the conductivity of the given thin film is calculated according to the Ohm's law and the geometric dimensions. It is to be noted that even if the HTM and the PD material are kept unchanged, that is, their energy level difference remains unchanged, the hole injection ability can be adjusted to a certain extent by adjusting the doping proportion. Since the conductivity of an organic semiconductor thin film is directly related to the materials used for forming the thin film and a doping proportion, an organic thin film formed by two or more organic materials having determined structures at a certain determined doping proportion has determined conductivity. In the researches of the present application, the conductivity of an organic layer formed by a first organic material and a second organic material having determined structures at a determined doping proportion is measured by the above method.

The term "doping proportion" refers to the percentage of a material in an organic thin film to the total mass of the thin film.

FIG. 3 shows a trend curve of a change of the conductivity of an organic thin film formed by Compound 1-2 and Compound HT-7 with a doping proportion of Compound 1-2. The difference between the LUMO energy level of Compound 1-2 and the HOMO energy level of HT-7 is 0.5 eV. As the doping proportion of Compound 1-2 increases, the conductivity of the obtained organic layer also increases: when the doping proportion of Compound 1-2 is 0%, the conductivity of the obtained organic layer is $8.1\times10^{-6}$ S/m; when the doping proportion of Compound 1-2 is 3%, the conductivity of the obtained organic layer is $2.4\times10^{-5}$ S/m; when the doping proportion of Compound 1-2 is 20%, the conductivity of the obtained organic layer is $8.9\times10^{-4}$ S/m; when the doping proportion of Compound 1-2 is 25%, the conductivity of the obtained organic layer is $9.2\times10^{-4}$ S/m. When the doping proportion of Compound 1-2 reaches 20% to 25%, it can be seen that the conductivity of the obtained organic layer is basically stable and is two orders of magnitude higher than that of the obtained organic layer without doping. Therefore, the conductivity of the obtained organic layer can be effectively adjusted by adjusting the doping proportion of Compound 1-2 so that the conductivity of the obtained organic layer is greater than or equal to $3\times10^{-5}$ S/m.

FIG. 4 shows a trend curve of a change of the conductivity of an organic thin film formed by Compound 3-2 and Compound HT-7 with a doping proportion of Compound 3-2. The difference between the LUMO energy level of Compound 3-2 and the HOMO energy level of HT-7 is 0.33 eV. As the doping proportion of Compound 3-2 increases, the conductivity of the obtained organic layer also increases: when the doping proportion of Compound 3-2 is 2%, the conductivity of the obtained organic layer is $2.6\times10^{-5}$ S/m; when the doping proportion of Compound 3-2 is 3%, the conductivity of the obtained organic layer is $8.0\times10^{-5}$ S/m; when the doping proportion of Compound 3-2 is 5%, the conductivity of the obtained organic layer is $3.9\times10^{-4}$ S/m. Likewise, the conductivity of the obtained organic layer can be effectively adjusted by adjusting the doping proportion of Compound 3-2 so that the conductivity of the obtained organic layer is greater than or equal to $3\times10^{-5}$ S/m.

Generally speaking, in an OLED device, as the doping proportion of a p-type conductive doping material (PD) in a HIL increases, the conductivity of the HIL also increases. However, for the OLED device, the conductivity can just range from $3\times10^{-5}$ S/m to $1\times10^{-2}$ S/m. Too low a conductivity affects hole injection and increases the voltage of the device, increasing power consumption. Too high a conductivity easily causes lateral crosstalk in a display. Moreover, too high a conductivity often means too high a doping concentration of the PD, which is likely to cause charge carrier accumulation to reduce the lifetime of the device and also greatly increases the manufacturing cost of the device.

When a forward bias voltage is applied to the device, a current begins to flow through the device. When the voltage reaches a turn-on voltage of the device, the device starts to emit light. Therefore, the lower the voltage at the same current density, the lower the power consumption of the device.

The "external quantum efficiency (EQE)" of the OLED device refers to a proportion of the number of photons emitted from the surface of the device in an observation direction to the number of injected electrons. Since OLEDs are current-driven (electrons and holes are injected and then recombined), the EQE may be used for reflecting the quality of a luminescence mechanism of the OLEDs to a certain extent. It is to be noted that blindly pursuing high EQE is not the first choice in the industry. More importantly, the overall performance of the device affected by various factors such as EQE, voltage and lifetime is to be comprehensively considered.

The current-voltage-luminescence (I-V-L) photoelectric characteristics of the OLED device are tested using an instrument modelled FS-1000GA3 provided by Suzhou Fstar Scientific Instrument Co., Ltd. The EQE of the device is calculated by the following built-in formula:

$$EQE = \frac{Photorad \times \pi \times LightingArea}{Current \times 6.25 \times 10^{18}}$$

$$Photorad = \frac{Energy}{Photon\ E} = \int_{380}^{780} \frac{Radiant\ intensity\ \times\ 10^{-9}}{Planck\ constant\ \times Speed\ of\ light\ \div Wavelength}$$

wherein *LightingArea* denotes a light emission area of the device, and *Current* denotes a current measured by Keithley2400 in amperes (A).

*Photorad* (radiant intensity) is a sum of a radiant intensity value at each wavelength from 380 nm to 780 nm multiplied by the wavelength, and the radiant intensity is measured by a built-in spectrometer FS-1000GA3.

Definition of terms of substituents

Halogen or halide - as used herein includes fluorine, chlorine, bromine, and iodine.

Alkyl - as used herein includes both straight and branched chain alkyl groups. Alkyl may be alkyl having 1 to 20 carbon atoms, preferably alkyl having 1 to 12 carbon atoms, and more preferably alkyl having 1 to 6 carbon atoms. Examples of alkyl groups include a methyl group, an ethyl group, a propyl group, an isopropyl group, a n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neopentyl group, a 1-methylpentyl group, a 2-methylpentyl group, a 1-pentylhexyl group, a 1-butylpentyl group, a 1-heptyloctyl group, and a 3-methylpentyl group. Of the above, preferred are a methyl group, an ethyl group, a propyl group, an isopropyl group, a n-butyl group, an s-butyl group, an isobutyl group, a t-butyl group, an n-pentyl group, a neopentyl group, and an n-hexyl group. Additionally, the alkyl group may be optionally substituted.

Cycloalkyl - as used herein includes cyclic alkyl groups. The cycloalkyl groups may be those having 3 to 20 ring carbon atoms, preferably those having 4 to 10 carbon atoms. Examples of cycloalkyl include cyclobutyl, cyclopentyl, cyclohexyl, 4-methylcyclohexyl, 4,4-dimethylcylcohexyl, 1-adamantyl, 2-adamantyl, 1-norbornyl, 2-norbornyl, and the like. Of the above, preferred are cyclopentyl, cyclohexyl, 4-methylcyclohexyl, and 4,4-dimethylcylcohexyl. Additionally, the cycloalkyl group may be optionally substituted.

Heteroalkyl - as used herein, includes a group formed by replacing one or more carbons in an alkyl chain with a hetero-atom(s) selected from the group consisting of a nitrogen atom, an oxygen atom, a sulfur atom, a selenium atom, a phosphorus atom, a silicon atom, a germanium atom, and a boron atom. Heteroalkyl may be those having 1 to 20 carbon atoms, preferably those having 1 to 10 carbon atoms, and more preferably those having 1 to 6 carbon atoms. Examples of heteroalkyl include methoxymethyl, ethoxymethyl, ethoxyethyl, methylthiomethyl, ethylthiomethyl, ethylthioethyl, methoxymethoxymethyl, ethoxymethoxymethyl, ethoxyethoxyethyl, hydroxymethyl, hydroxyethyl, hydroxypropyl, mercaptomethyl, mercaptoethyl, mercaptopropyl, aminomethyl, aminoethyl, aminopropyl, dimethylaminomethyl, trimethylgermanylmethyl, trimethylgermanylethyl, trimethylgermanylisopropyl, dimethylethylgermanylmethyl, dimethylisopropylgermanylmethyl, tertbutyldimethylgermanylmethyl, triethylgermanylmethyl, triethylgermanylethyl, triisopropylgermanylmethyl, triisopropylgermanylethyl, trimethylsilylmethyl, trimethylsilylethyl, trimethylsilylisopropyl, triisopropylsilylmethyl, and triisopropylsilylethyl. Additionally, the heteroalkyl group may be optionally substituted.

Alkenyl - as used herein includes straight chain, branched chain, and cyclic alkene groups. Alkenyl may be those having 2 to 20 carbon atoms, preferably those having 2 to 10 carbon atoms. Examples of alkenyl include vinyl, 1-propenyl group, 1-butenyl, 2-butenyl, 3-butenyl, 1,3-butandienyl, 1-methylvinyl, styryl, 2,2-diphenylvinyl, 1,2-diphenylvinyl, 1-methylallyl, 1,1-dimethylallyl, 2-methylallyl, 1-phenylallyl, 2-phenylallyl, 3-phenylallyl, 3,3-diphenylallyl, 1,2-dimethylallyl, 1-phenyl-1-butenyl, 3-phenyl-1-butenyl, cyclopentenyl, cyclopentadienyl, cyclohexenyl, cycloheptenyl, cycloheptatrienyl, cyclooctenyl, cyclooctatetraenyl, and norbornenyl. Additionally, the alkenyl group may be optionally substituted.

Alkynyl - as used herein includes straight chain alkynyl groups. Alkynyl may be those having 2 to 20 carbon atoms, preferably those having 2 to 10 carbon atoms. Examples of alkynyl groups include ethynyl, propynyl, propargyl, 1-butynyl, 2-butynyl, 3-butynyl, 1-pentynyl, 2-pentynyl, 3,3-dimethyl-1-butynyl, 3-ethyl-3-methyl-1-pentynyl, 3,3-diisopropyl-1-pentynyl, phenylethynyl, phenylpropynyl, etc. Of the above, preferred are ethynyl, propynyl, propargyl, 1-butynyl, 2-butynyl, 3-butynyl, 1-pentynyl, and phenylethynyl. Additionally, the alkynyl group may be optionally substituted.

Aryl or an aromatic group - as used herein includes non-condensed and condensed systems. Aryl may be those having 6 to 30 carbon atoms, preferably those having 6 to 20 carbon atoms, and more preferably those having 6 to 12 carbon atoms. Examples of aryl groups include phenyl, biphenyl, terphenyl, triphenylene, tetraphenylene, naphthalene, anthracene, phenalene, phenanthrene, fluorene, pyrene, chrysene, perylene, and azulene, preferably phenyl, biphenyl, terphenyl, triphenylene, fluorene, and naphthalene. Examples of non-condensed aryl groups include phenyl, biphenyl-2-yl, biphenyl-3-yl, biphenyl-4-yl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-(2-phenylpropyl)phenyl, 4'-methylbiphenylyl, 4"-t-butyl-p-terphenyl-4-yl, o-cumenyl, m-cumenyl, p-cumenyl, 2,3-xylyl, 3,4-xylyl, 2,5-xylyl, mesityl, and m-quarterphenyl. Additionally, the aryl group may be optionally substituted.

Heterocyclic groups or heterocycle - as used herein include non-aromatic cyclic groups. Non-aromatic heterocyclic groups include saturated heterocyclic groups having 3 to 20 ring atoms and unsaturated non-aromatic heterocyclic groups having 3 to 20 ring atoms, where at least one ring atom is selected from the group consisting of a nitrogen atom, an oxygen atom, a sulfur atom, a selenium atom, a silicon atom, a phosphorus atom, a germanium atom, and a boron atom. Preferred non-aromatic heterocyclic groups are those having 3 to 7 ring atoms, each of which includes at least one hetero-atom such as nitrogen, oxygen, silicon, or sulfur. Examples of non-aromatic heterocyclic groups include oxiranyl, oxetanyl, tetrahydrofuranyl, tetrahydropyranyl, dioxolanyl, dioxanyl, aziridinyl, dihydropyrrolyl, tetrahydropyrrolyl, piperidinyl, oxazolidinyl, morpholinyl, piperazinyl, oxepinyl, thiepinyl, azepinyl, and tetrahydrosilolyl. Additionally, the heterocyclic group may be optionally substituted.

Heteroaryl - as used herein, includes non-condensed and condensed hetero-aromatic groups having 1 to 5 hetero-atoms, where at least one hetero-atom is selected from the group consisting of a nitrogen atom, an oxygen atom, a sulfur atom, a selenium atom, a silicon atom, a phosphorus atom, a germanium atom, and a boron atom. A hetero-aromatic group is also referred to as heteroaryl. Heteroaryl may be those having 3 to 30 carbon atoms, preferably those having 3 to 20 carbon atoms, and more preferably those having 3 to 12 carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridoindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Alkoxy - as used herein, is represented by -O-alkyl, -O-cycloalkyl, -O-heteroalkyl, or - O-heterocyclic group. Examples and preferred examples of alkyl, cycloalkyl, heteroalkyl, and heterocyclic groups are the same as those described above. Alkoxy groups may be those having 1 to 20 carbon atoms, preferably those having 1 to 6 carbon atoms. Examples of alkoxy groups include methoxy, ethoxy, propoxy, butoxy, pentyloxy, hexyloxy, cyclopropyloxy, cyclobutyloxy, cyclopentyloxy, cyclohexyloxy, tetrahydrofuranyloxy, tetrahydropyranyloxy, methoxypropyloxy, ethoxyethyloxy, methoxymethyloxy, and ethoxymethyloxy. Additionally, the alkoxy group may be optionally substituted.

Aryloxy - as used herein, is represented by -O-aryl or -O-heteroaryl. Examples and preferred examples of aryl and heteroaryl are the same as those described above. Aryloxy groups may be those having 6 to 30 carbon atoms, preferably those having 6 to 20 carbon atoms. Examples of aryloxy groups include phenoxy and biphenyloxy. Additionally, the aryloxy group may be optionally substituted.

Arylalkyl - as used herein, contemplates alkyl substituted with an aryl group. Arylalkyl may be those having 7 to 30 carbon atoms, preferably those having 7 to 20 carbon atoms, and more preferably those having 7 to 13 carbon atoms. Examples of arylalkyl groups include benzyl, 1-phenylethyl, 2-phenylethyl, 1-phenylisopropyl, 2-phenylisopropyl, phenyl-t-butyl, alpha-naphthylmethyl, 1-alpha-naphthylethyl, 2-alpha-naphthylethyl, 1-alpha-naphthylisopropyl, 2-alpha-naphthylisopropyl, beta-naphthylmethyl, 1-beta-naphthylethyl, 2-beta-naphthylethyl, 1-beta-naphthylisopropyl, 2-beta-naphthylisopropyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl. Of the above, preferred are benzyl, p-cyanobenzyl, m-cyanobenzyl, o-cyanobenzyl, 1-phenylethyl, 2-phenylethyl, 1-phenylisopropyl, and 2-phenylisopropyl. Additionally, the arylalkyl group may be optionally substituted.

Alkylsilyl - as used herein, contemplates a silyl group substituted with an alkyl group. Alkylsilyl groups may be those having 3 to 20 carbon atoms, preferably those having 3 to 10 carbon atoms. Examples of alkylsilyl groups include trimethylsilyl, triethylsilyl, methyldiethylsilyl, ethyldimethylsilyl, tripropylsilyl, tributylsilyl, triisopropylsilyl, methyldiisopropylsilyl, dimethylisopropylsilyl, tri-t-butylsilyl, triisobutylsilyl, dimethyl t-butylsilyl, and methyldi-t-butylsilyl. Additionally, the alkylsilyl group may be optionally substituted.

Arylsilyl - as used herein, contemplates a silyl group substituted with an aryl group. Arylsilyl groups may be those having 6 to 30 carbon atoms, preferably those having 8 to 20 carbon atoms. Examples of arylsilyl groups include triphenylsilyl, phenyldibiphenylylsilyl, diphenylbiphenylsilyl, phenyldiethylsilyl, diphenylethylsilyl, phenyldimethylsilyl,

diphenylmethylsilyl, phenyldiisopropylsilyl, diphenylisopropylsilyl, diphenylbutylsilyl, diphenylisobutylsilyl, diphenyl t-butylsilyl. Additionally, the arylsilyl group may be optionally substituted.

Alkylgermanyl - as used herein contemplates a germanyl substituted with an alkyl group. The alkylgermanyl may be those having 3 to 20 carbon atoms, preferably those having 3 to 10 carbon atoms. Examples of alkylgermanyl include trimethylgermanyl, triethylgermanyl, methyldiethylgermanyl, ethyldimethylgermanyl, tripropylgermanyl, tributylgermanyl, triisopropylgermanyl, methyldiisopropylgermanyl, dimethylisopropylgermanyl, tri-t-butylgermanyl, triisobutylgermanyl, dimethyl-t-butylgermanyl, and methyldi-t-butylgermanyl. Additionally, the alkylgermanyl may be optionally substituted.

Arylgermanyl - as used herein contemplates a germanyl substituted with at least one aryl group or heteroaryl group. Arylgermanyl may be those having 6 to 30 carbon atoms, preferably those having 8 to 20 carbon atoms. Examples of arylgermanyl include triphenylgermanyl, phenyldibiphenylylgermanyl, diphenylbiphenylgermanyl, phenyldiethylgermanyl, diphenylethylgermanyl, phenyldimethylgermanyl, diphenylmethylgermanyl, phenyldiisopropylgermanyl, diphenylisopropylgermanyl, diphenylbutylgermanyl, diphenylisobutylgermanyl, and diphenyl-t-butylgermanyl. Additionally, the arylgermanyl may be optionally substituted.

The term "aza" in azadibenzofuran, azadibenzothiophene, etc. means that one or more of C-H groups in the respective aromatic fragment are replaced by a nitrogen atom. For example, azatriphenylene encompasses dibenzo[f,h]quinoxaline, dibenzo[f,h]quinoline and other analogs with two or more nitrogens in the ring system. One of ordinary skill in the art can readily envision other nitrogen analogs of the aza-derivatives described above, and all such analogs are intended to be encompassed by the terms as set forth herein.

In the present disclosure, unless otherwise defined, when any term of the group consisting of substituted alkyl, substituted cycloalkyl, substituted heteroalkyl, substituted heterocyclic group, substituted arylalkyl, substituted alkoxy, substituted aryloxy, substituted alkenyl, substituted alkynyl, substituted aryl, substituted heteroaryl, substituted alkylsilyl, substituted arylsilyl, substituted alkylgermanyl, substituted arylgermanyl, substituted amino, substituted acyl, substituted carbonyl, a substituted carboxylic acid group, a substituted ester group, substituted sulfinyl, substituted sulfonyl, and substituted phosphino is used, it means that any group of alkyl, cycloalkyl, heteroalkyl, heterocyclic group, arylalkyl, alkoxy, aryloxy, alkenyl, alkynyl, aryl, heteroaryl, alkylsilyl, arylsilyl, amino, acyl, carbonyl, a carboxylic acid group, an ester group, sulfinyl, sulfonyl, and phosphino may be substituted with one or more groups selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl group having 6 to 20 carbon atoms, unsubstituted alkylgermanyl group having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or an attached fragment are considered to be equivalent.

In the compounds mentioned in the present disclosure, hydrogen atoms may be partially or fully replaced by deuterium. Other atoms such as carbon and nitrogen may also be replaced by their other stable isotopes. The replacement by other stable isotopes in the compounds may be preferred due to its enhancements of device efficiency and stability.

In the compounds mentioned in the present disclosure, multiple substitutions refer to a range that includes di-substitutions, up to the maximum available substitutions. When substitution in the compounds mentioned in the present disclosure represents multiple substitutions (including di-, tri-, and tetra-substitutions etc.), that means the substituent may exist at a plurality of available substitution positions on its linking structure, the substituents present at a plurality of available substitution positions may have the same structure or different structures.

In the compounds mentioned in the present disclosure, adjacent substituents in the compounds cannot be joined to form a ring unless otherwise explicitly defined, for example, adjacent substituents can be optionally joined to form a ring. In the compounds mentioned in the present disclosure, the expression that adjacent substituents can be optionally joined to form a ring includes a case where adjacent substituents may be joined to form a ring and a case where adjacent substituents are not joined to form a ring. When adjacent substituents can be optionally joined to form a ring, the ring formed may be monocyclic or polycyclic (including spirocyclic, endocyclic, fusedcyclic, and etc.), as well as alicyclic, heteroalicyclic, aromatic, or heteroaromatic. In such expression, adjacent substituents may refer to substituents bonded to the same atom, substituents bonded to carbon atoms which are directly bonded to each other, or substituents bonded to carbon atoms which are more distant from each other. Preferably, adjacent substituents refer to

substituents bonded to the same carbon atom and substituents bonded to carbon atoms which are directly bonded to each other.

The expression that adjacent substituents can be optionally joined to form a ring is also intended to mean that two substituents bonded to the same carbon atom are joined to each other via a chemical bond to form a ring, which can be exemplified by the following formula:

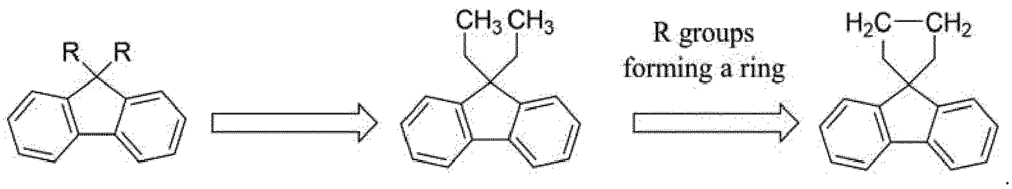


The expression that adjacent substituents can be optionally joined to form a ring is also intended to mean that two substituents bonded to carbon atoms which are directly bonded to each other are joined to each other via a chemical bond to form a ring, which can be exemplified by the following formula:

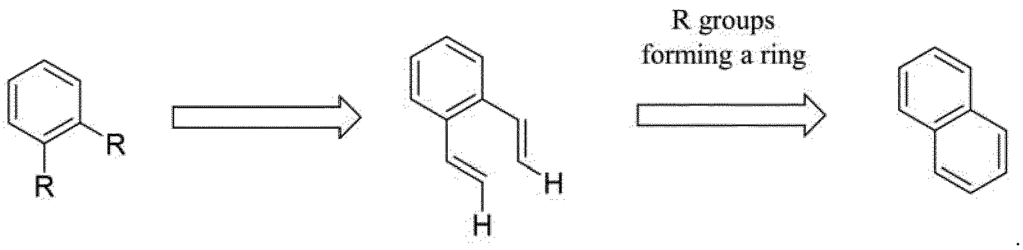


The expression that adjacent substituents can be optionally joined to form a ring is also intended to mean that two substituents bonded to further distant carbon atoms are joined to each other via a chemical bond to form a ring, which can be exemplified by the following formula:

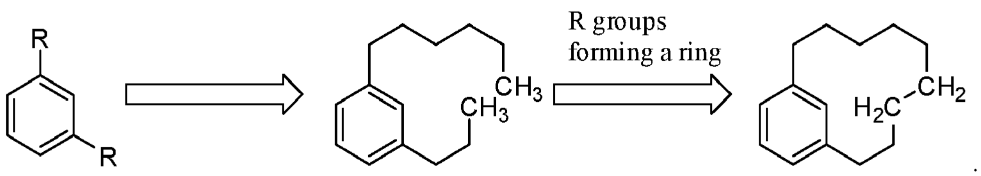


Furthermore, the expression that adjacent substituents can be optionally joined to form a ring is also intended to mean that, in the case where one of the two substituents bonded to carbon atoms which are directly bonded to each other represents hydrogen, the second substituent is bonded at a position at which the hydrogen atom is bonded, thereby forming a ring. This is exemplified by the following formula:

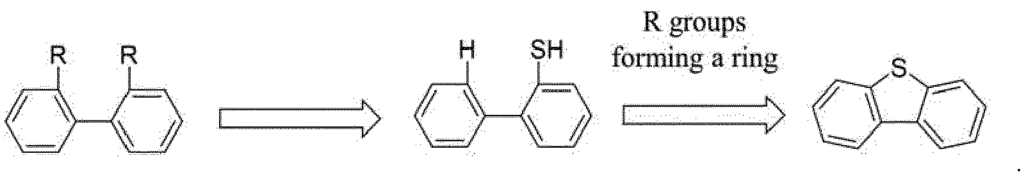


According to an embodiment of the present disclosure, an organic electroluminescent device is disclosed, which comprises:

an anode, a cathode and an organic layer disposed between the anode and the cathode;
wherein the organic layer comprises a first organic layer containing a first organic material and a second organic material;
the LUMO energy level of the first organic material is denoted as $LUMO_{first_organic_material}$, the HOMO energy level of the second organic material is denoted as $HOMO_{second_organic_material}$, $HOMO_{second_organic_material} \leq -5.1$ eV, and $LUMO_{first_organic_material} - HOMO_{second_organic_material} \geq 0.3$ eV; and

the first organic layer has a conductivity greater than or equal to $3\times10^{-5}$ S/m.

According to an embodiment of the present disclosure, an organic electroluminescent device is further disclosed, which comprises:

an anode, a cathode and an organic layer disposed between the anode and the cathode;

wherein the organic layer comprises a first organic layer containing a first organic material and a second organic material, wherein the LUMO energy level of the first organic material is denoted as $LUMO_{first_organic_material}$, the HOMO energy level of the second organic material is denoted as $HOMO_{second_organic_material}$, and $LUMO_{first_organic_material}$ - $HOMO_{second_organic\ material} \geq 0.3$ eV; the first organic layer has a conductivity greater than or equal to $3\times10^{-5}$ S/m; and the second organic material has a structure represented by Formula H:

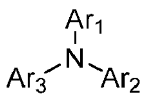

Formula H ;

wherein in Formula H,

$Ar_1$, $Ar_2$ and $Ar_3$ are, at each occurrence identically or differently, selected from substituted or unsubstituted aryl having 6 to 30 carbon atoms or substituted or unsubstituted heteroaryl having 3 to 30 carbon atoms;

when $Ar_1$, $Ar_2$ and $Ar_3$ are, at each occurrence identically or differently, selected from substituted aryl having 6 to 30 carbon atoms or substituted heteroaryl having 3 to 30 carbon atoms, the aryl or heteroaryl is substituted with one or more groups selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and

adjacent substituents $Ar_1$, $Ar_2$ and $Ar_3$ can be optionally joined to form a ring.

In this embodiment, the expression that adjacent substituents $Ar_1$, $Ar_2$ and $Ar_3$ can be optionally joined to form a ring is intended to mean that any one or more of groups of adjacent substituents, such as adjacent substituents $Ar_1$ and $Ar_2$, adjacent substituents $Ar_1$ and $Ar_3$, and adjacent substituents $Ar_2$ and $Ar_3$, can be joined to form a ring. Obviously, it is possible that none of these adjacent substituents are joined to form a ring.

According to an embodiment of the present disclosure, wherein, the second organic material having the structure represented by Formula H is a monoarylamine compound.

According to an embodiment of the present disclosure, wherein, $LUMO_{first_organic_material}$ - HOMO second organic material $\geq 0.33$ eV.

According to an embodiment of the present disclosure, wherein, $LUMO_{first_organic_material}$ - $HOMO_{second_organic_material} \geq 0.4$ eV.

According to an embodiment of the present disclosure, wherein, $LUMO_{first_organic_material}$ - $HOMO_{second_organic_material} \geq 0.45$ eV.

According to an embodiment of the present disclosure, wherein, $HOMO_{second_organic_material} \leq -5.13$ eV.

According to an embodiment of the present disclosure, wherein, $HOMO_{second_organic_material} \leq -5.2$ eV.

According to an embodiment of the present disclosure, wherein, the first organic layer has a conductivity greater than or equal to $5\times10^{-5}$ S/m.

According to an embodiment of the present disclosure, wherein, the first organic layer has a conductivity greater than or equal to $7\times10^{-5}$ S/m.

According to an embodiment of the present disclosure, wherein, the first organic layer has a conductivity greater than or equal to $10\times10^{-5}$ S/m.

According to an embodiment of the present disclosure, wherein, the first organic layer has a conductivity greater than or equal to $30\times10^{-5}$ S/m.

According to an embodiment of the present disclosure, wherein, the first organic layer has a conductivity greater than or equal to $50\times10^{-5}$ S/m.

According to an embodiment of the present disclosure, wherein, the weight ratio of the first organic material to the first organic layer is 0.1% to 90%.

According to an embodiment of the present disclosure, wherein, the weight ratio of the first organic material to the first organic layer is 1% to 50%.

According to an embodiment of the present disclosure, wherein, the weight ratio of the first organic material to the first organic layer is 2% to 30%.

According to an embodiment of the present disclosure, wherein, the first organic layer has a thickness of 1-30 nm.

According to an embodiment of the present disclosure, wherein, the first organic layer has a thickness of 5-15 nm.

According to an embodiment of the present disclosure, wherein, when the organic electroluminescent device emits red light, the organic electroluminescent device has EQE not lower than 22% and a voltage not higher than 4.5 V at 15 $mA/cm^2$; when the organic electroluminescent device emits green light, the organic electroluminescent device has EQE not lower than 21% and a voltage not higher than 4.5 V at 15 $mA/cm^2$; when the organic electroluminescent device emits blue light, the organic electroluminescent device has EQE not lower than 6% and a voltage not higher than 5 V at 15 $mA/cm^2$.

According to an embodiment of the present disclosure, wherein, when the organic electroluminescent device emits red light, the organic electroluminescent device has EQE not lower than 24% and a voltage not higher than 4.8 V at 15 $mA/cm^2$; when the organic electroluminescent device emits green light, the organic electroluminescent device has EQE not lower than 23% and a voltage not higher than 4.8 V at 15 $mA/cm^2$; when the organic electroluminescent device emits blue light, the organic electroluminescent device has EQE not lower than 7% and a voltage not higher than 5.3 V at 15 $mA/cm^2$.

According to an embodiment of the present disclosure, wherein, when the organic electroluminescent device emits red light, the organic electroluminescent device has EQE not lower than 25% and a voltage not higher than 4.5 V at 15 $mA/cm^2$; when the organic electroluminescent device emits green light, the organic electroluminescent device has EQE not lower than 24% and a voltage not higher than 4.5 V at 15 $mA/cm^2$; when the organic electroluminescent device emits blue light, the organic electroluminescent device has EQE not lower than 8% and a voltage not higher than 5.5 V at 15 $mA/cm^2$.

According to an embodiment of the present disclosure, wherein, the first organic layer is in contact with the anode.

According to an embodiment of the present disclosure, wherein, the organic electroluminescent device further comprises a second organic layer containing the second organic material.

According to an embodiment of the present disclosure, wherein, the second organic layer has a thickness of 10-200 nm.

According to an embodiment of the present disclosure, wherein, the second organic material is selected from the following:

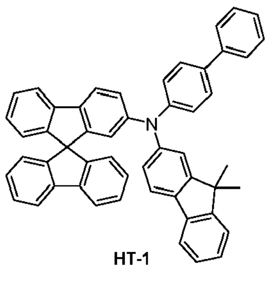
HT-1 ,
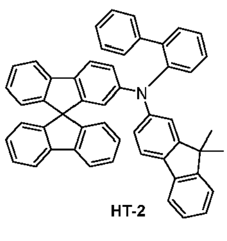
HT-2 ,
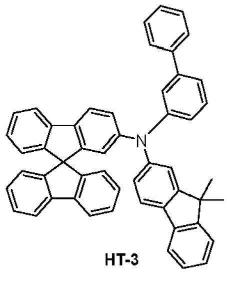
HT-3 ,
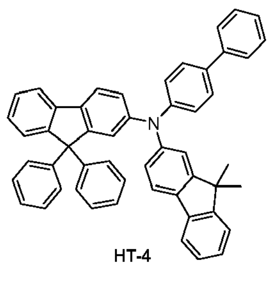
HT-4 ,

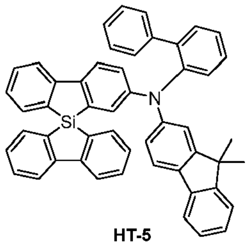
HT-5 ,
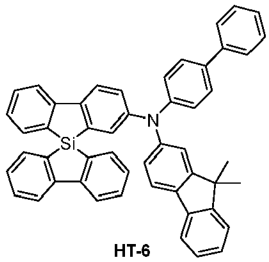
HT-6 ,
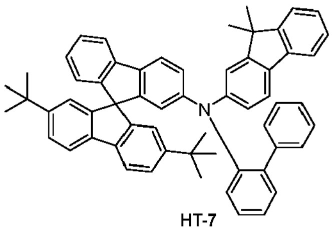
HT-7 ,
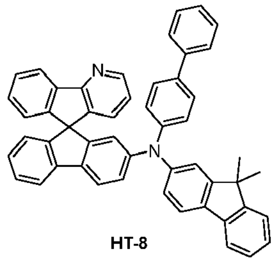
HT-8 ,

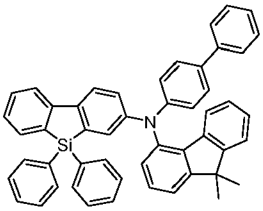
HT-9 ,
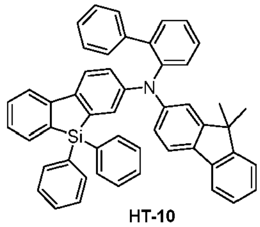
HT-10 ,
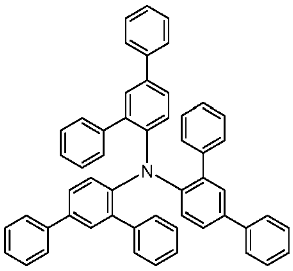
HT-11 ,
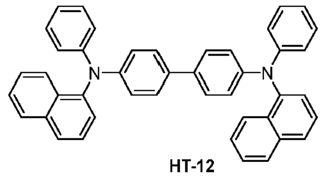
HT-12 ,

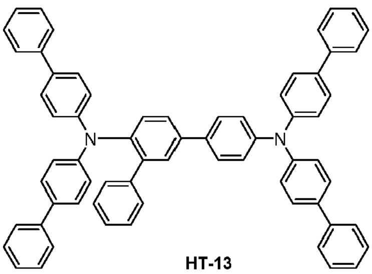
HT-13 ,
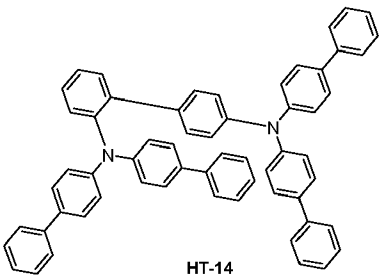
HT-14 ,
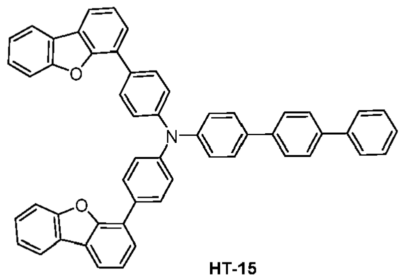
HT-15 ,

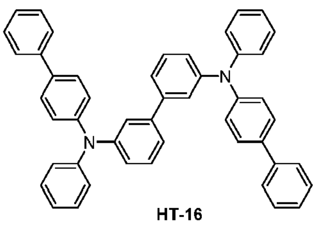
HT-16 ,
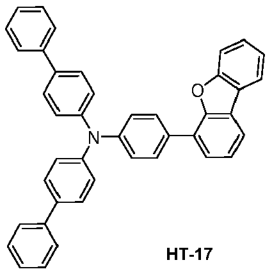
HT-17 ,
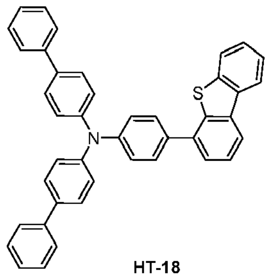
HT-18 ,

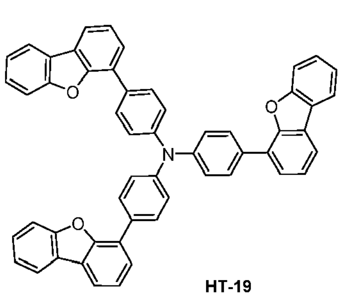
HT-19 ,
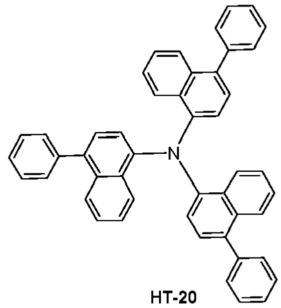
HT-20 ,
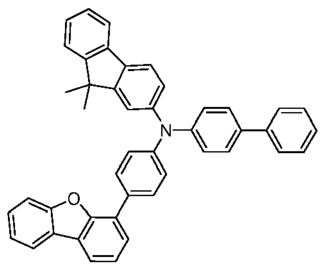
HT-21 .

According to an embodiment of the present disclosure, a first organic electroluminescent device is further disclosed, which comprises:

an anode, a cathode and an organic layer disposed between the anode and the cathode;

wherein the organic layer comprises a first organic layer being in contact with the anode and containing a first organic material and a second organic material;

the first organic layer has a conductivity greater than or equal to $3\times10^{-5}$ S/m;

an efficiency-to-voltage ratio $\eta$ of the first organic electroluminescent device is greater than or equal to 104% of an efficiency-to-voltage ratio $\eta$ of a second organic electroluminescent device at the same current density; wherein $\eta$ = EQE/(voltage $\times$ $\xi$), and $\xi$ denotes a proportion of excitons allowed to be emitted in quantum mechanics; the second organic electroluminescent device has the same device structure as the first organic electroluminescent device except that: the organic layer that is in contact with the anode in the second organic electroluminescent device is a third organic layer containing a third organic material and a fourth organic material, and materials in at least one of the following two groups are the same: group (i): the first organic material and the third organic material, and group (ii): the second organic material and the fourth organic material; and

the third organic layer in the second organic electroluminescent device at least satisfies one of the following requirements:

(1) the HOMO energy level of the fourth organic material is denoted as $HOMO_{fourth_organic_material}$, and $HOMO_{fourth_organic_material}$ > -5.1 eV;

(2) the LUMO energy level of the third organic material is denoted as $LUMO_{third_organic_material}$, the HOMO energy level of the fourth organic material is denoted as $HOMO_{fourth_organic_material}$, and $LUMO_{third_organic_material}$ - $HOMO_{fourth_organic_material}$ < 0.3 eV;

(3) the third organic layer has a conductivity of less than $3\times10^{-5}$ S/m.

According to an embodiment of the present disclosure, wherein, in the first organic electroluminescent device, the LUMO energy level of the first organic material is denoted as $LUMO_{first_organic_material}$, the HOMO energy level of the second organic material is denoted as $HOMO_{second_organic_material}$, and $LUMO_{first_organic_material}$ - $HOMO_{second_organic_material} \geq 0.3$ eV.

According to an embodiment of the present disclosure, wherein, in the first organic electroluminescent device, the HOMO energy level of the second organic material is denoted as $HOMO_{second_organic_material}$, and $HOMO_{second_organic_material} \leq -5.1$eV.

According to an embodiment of the present disclosure, wherein, EQE of the first organic electroluminescent device is higher than 103% of EQE of the second organic electroluminescent device at the same current density.

According to an embodiment of the present disclosure, wherein, the EQE of the first organic electroluminescent device is higher than 110% of the EQE of the second organic electroluminescent device at the same current density.

According to an embodiment of the present disclosure, wherein, the EQE of the first organic electroluminescent device is higher than 120% of the EQE of the second organic electroluminescent device at the same current density.

According to an embodiment of the present disclosure, wherein, $\eta$ of the first organic electroluminescent device at 15 $mA/cm^2$ is > 7.19.

According to an embodiment of the present disclosure, wherein, $\eta$ of the first organic electroluminescent device at 15 $mA/cm^2$ is > 7.2.

According to an embodiment of the present disclosure, wherein, $\eta$ of the first organic electroluminescent device at 15 $mA/cm^2$ is > 7.3.

According to an embodiment of the present disclosure, wherein, $\eta$ of the first organic electroluminescent device at 15 $mA/cm^2$ is > 7.4.

According to an embodiment of the present disclosure, wherein, $\eta$ of the first organic electroluminescent device is greater than or equal to 106% of $\eta$ of the second organic electroluminescent device at the same current density.

According to an embodiment of the present disclosure, wherein, $\eta$ of the first organic electroluminescent device is greater than or equal to 110% of $\eta$ of the second organic electroluminescent device at the same current density.

According to an embodiment of the present disclosure, wherein, $\eta$ of the first organic electroluminescent device is greater than or equal to 120% of $\eta$ of the second organic electroluminescent device at the same current density.

According to an embodiment of the present disclosure, wherein, $\eta$ of the first organic electroluminescent device is greater than or equal to 130% of $\eta$ of the second organic electroluminescent device at the same current density.

According to an embodiment of the present disclosure, wherein, the first organic material is a p-type conductive doping material and the second organic material is a hole transporting material.

According to an embodiment of the present disclosure, wherein, the first organic material has a structure represented by one of Formula 1 to Formula 3:

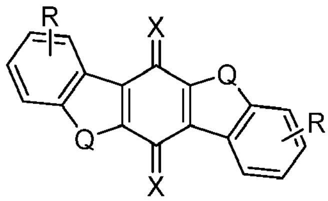
Formula 1
,
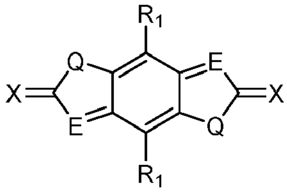
Formula 2
or
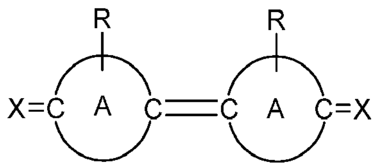
Formula 3
;

wherein in Formula 1, Formula 2 or Formula 3,

E is, at each occurrence identically or differently, selected from N or $CR_1$;
X is, at each occurrence identically or differently, selected from the group consisting of: NR', CR″R‴, O, S and Se;
the ring A is, at each occurrence identically or differently, a five-membered heterocyclic ring containing one intracyclic double bond, at least one N atom and at least one Q;
Q is, at each occurrence identically or differently, selected from the group consisting of O, S, Se and $NR_N$;
R represents, at each occurrence identically or differently, mono-substitution, multiple substitutions or non-substitution;
R, $R_1$, R', R", R‴ and $R_N$ are, at each occurrence identically or differently, selected from the group consisting of: hydrogen, deuterium, halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group, a phosphoroso group, a hydroxyl group, a sulfanyl group, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms and combinations thereof;
at least one of substituents R, $R_1$, R', R" and R‴ is a group having at least one electron withdrawing group; and
adjacent substituents R, R', R", R'" can be optionally joined to form a ring.

In this embodiment, the expression that adjacent substituents R, R', R", R‴ can be optionally joined to form a ring is intended to mean that any one or more of groups of adjacent substituents, such as adjacent substituents R, adjacent substituents R" and R‴, adjacent substituents R and R", adjacent substituents R and R‴, and adjacent substituents R and R', can be joined to form a ring. Obviously, it is possible that none of these adjacent substituents are joined to form a ring.

According to an embodiment of the present disclosure, wherein, in Formula 2, E is, at each occurrence identically or differently, selected from $CR_1$.

According to an embodiment of the present disclosure, wherein, the first organic material has a structure represented by Formula 1 or Formula 3.

According to an embodiment of the present disclosure, wherein, the first organic material has a structure represented by Formula 3-1:

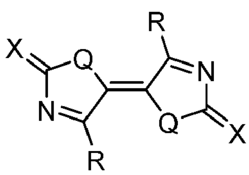
Formula 3-1
;

wherein X is, at each occurrence identically or differently, selected from NR', CR″R‴, O, S or Se;

at least one of R, R’, R" and R‴ is a group having at least one electron withdrawing group;
Q is, at each occurrence identically or differently, selected from the group consisting of O, S, Se and $NR_N$;
R, R’, R", R‴ and $R_N$ are, at each occurrence identically or differently, selected from the group consisting of: hydrogen, deuterium, halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group, a phosphoroso group, a hydroxyl group, a sulfanyl group, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms and combinations thereof.

According to an embodiment of the present disclosure, wherein, in Formula 1, Formula 2, Formula 3 or Formula 3-1, X is, at each occurrence identically or differently, selected from CR″R‴ or NR’, and each of R’, R" and R‴ is a group having at least one electron withdrawing group.

According to an embodiment of the present disclosure, wherein, in Formula 1, Formula 2, Formula 3 or Formula 3-1, X is, at each occurrence identically or differently, selected from CR″R‴ or NR’, and each of R, R’, R" and R‴ is a group having at least one electron withdrawing group.

According to an embodiment of the present disclosure, wherein, in Formula 1, Formula 2, Formula 3 or Formula 3-1, X is, at each occurrence identically or differently, selected from the group consisting of the following structures:

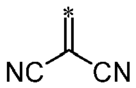
**X-1** ,

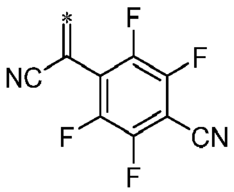
**X-2** ,

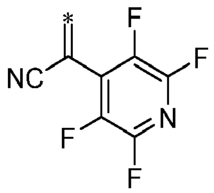
**X-3** ,

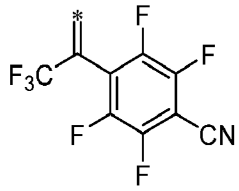
**X-4** ,

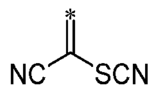
**X-5** ,

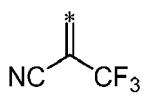
**X-6** ,

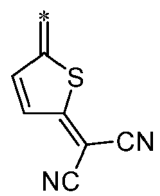
**X-7** .

According to an embodiment of the present disclosure, wherein, in Formula 1, Formula 2, Formula 3 or Formula 3-1, X is selected from X-1.

According to an embodiment of the present disclosure, wherein, in Formula 1, Formula 2, Formula 3 or Formula 3-1, Q is, at each occurrence identically or differently, selected from O or S.

According to an embodiment of the present disclosure, wherein, in Formula 1, Formula 2, Formula 3 or Formula 3-1, R and $R_1$ are, at each occurrence identically or differently, selected from the group consisting of: hydrogen, deuterium, halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group, a phosphoroso group, unsubstituted alkyl having 1 to 20 carbon atoms, unsubstituted cycloalkyl having 3 to 20 ring carbon atoms, unsubstituted alkoxy having 1 to 20 carbon atoms, unsubstituted alkenyl having 2 to 20 carbon atoms, unsubstituted aryl having 6 to 30 carbon atoms, unsubstituted heteroaryl having 3 to 30 carbon atoms, any one of the following groups substituted with one or more of halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group and a phosphoroso group: alkyl having 1 to 20 carbon atoms, cycloalkyl having 3 to 20 ring carbon atoms, alkoxy having 1 to 20 carbon atoms, alkenyl having 2 to 20 carbon atoms, aryl having 6 to 30 carbon atoms and heteroaryl having 3 to

30 carbon atoms, and combinations thereof.

According to an embodiment of the present disclosure, wherein, in Formula 1, Formula 2, Formula 3 or Formula 3-1, R and $R_1$ are, at each occurrence identically or differently, selected from the group consisting of: hydrogen, deuterium, methyl, isopropyl, $NO_2$, $SO_2CH_3$, $SCF_3$, $C_2F_5$, $OC_2F_5$, $OCH_3$, diphenylmethylsilyl, phenyl, methoxyphenyl, *p*-methylphenyl, 2,6-diisopropylphenyl, biphenyl, polyfluorophenyl, difluoropyridyl, nitrophenyl, dimethylthiazolyl, vinyl substituted with one or more of CN or $CF_3$, acetenyl substituted with one of CN or $CF_3$, dimethylphosphoroso, diphenylphosphoroso, F, $CF_3$, $OCF_3$, $SF_5$, $SO_2CF_3$, cyano, isocyano, SCN, OCN, trifluoromethylphenyl, trifluoromethoxyphenyl, bis(trifluoromethyl)phenyl, bis(trifluoromethoxy)phenyl, 4-cyanotetrafluorophenyl, phenyl or biphenyl substituted with one or more of F, CN or $CF_3$, tetrafluoropyridyl, pyrimidinyl, triazinyl, diphenylboryl, oxaboraanthryl and combinations thereof.

According to an embodiment of the present disclosure, wherein, the first organic material is selected from the group consisting of the following structures:

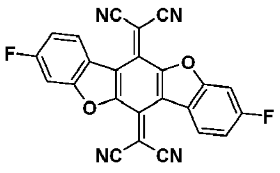
1-1 ,

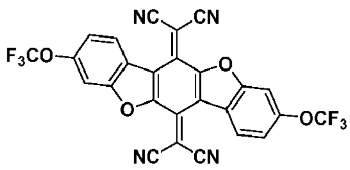
1-2 ,

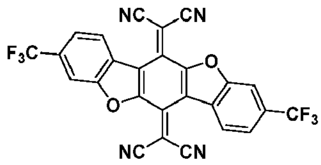
1-3 ,

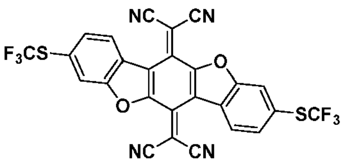
1-4 ,

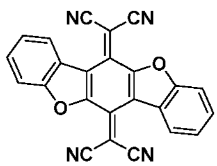
1-5 ,

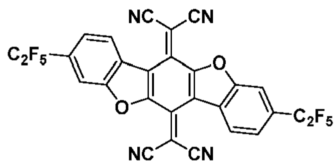
1-6 ,

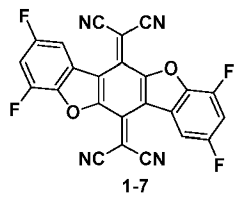
1-7 ,

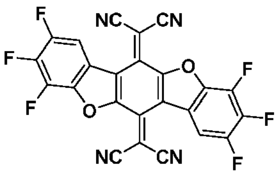
1-8 ,

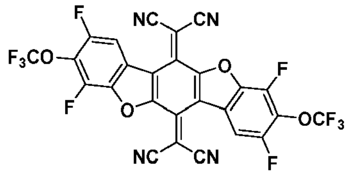
1-9 ,

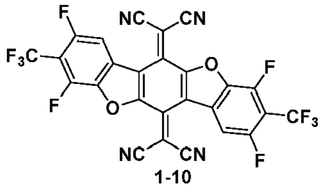
1-10 ,

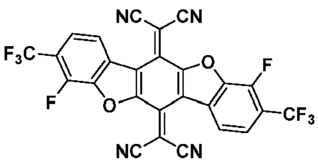
1-11 ,

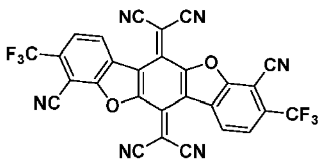
1-12 ,

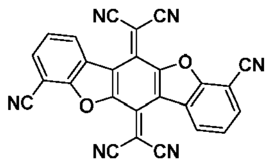
1-13 ,

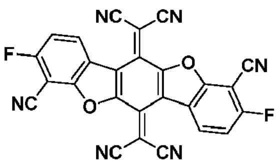
1-14 ,

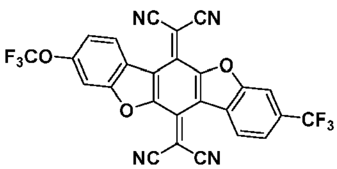
1-15 ,

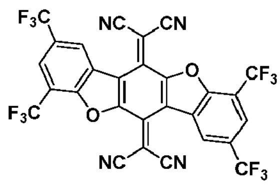
1-16 ,

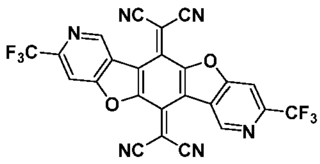

1-17

,

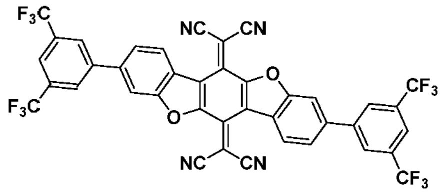

1-18

,

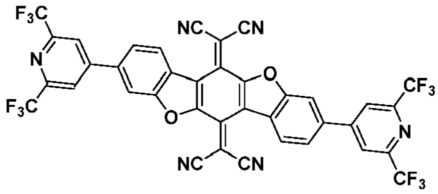

1-19

,

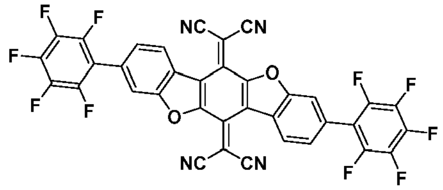

1-20

,

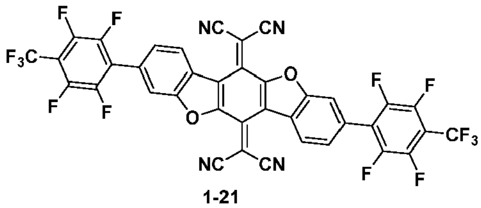

1-21

,

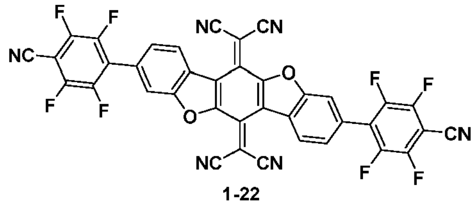

1-22

;

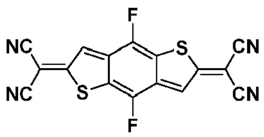

2-1

,

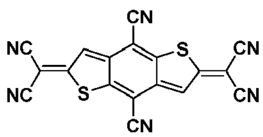

2-2

,

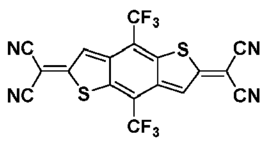

2-3

,

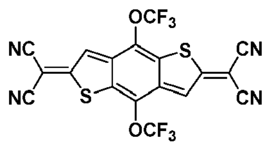

2-4

,

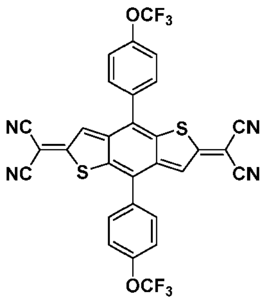

2-5

,

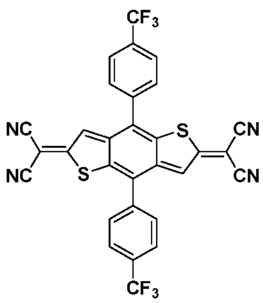

2-6

,

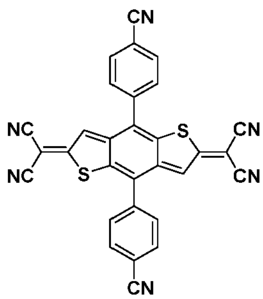

2-7

,

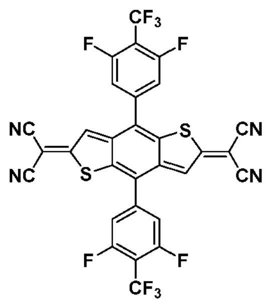

2-8

,

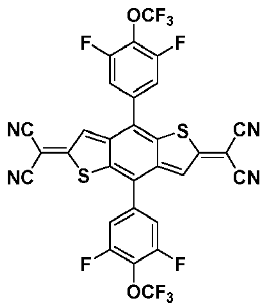
2-9 ,

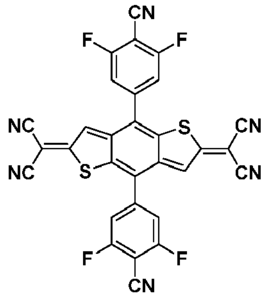
2-10 ,

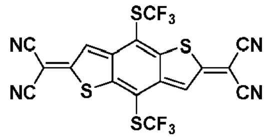
2-11 ,

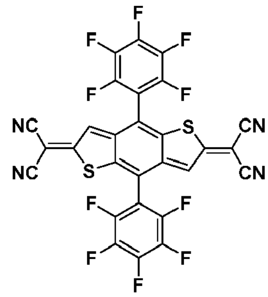
2-12 ,

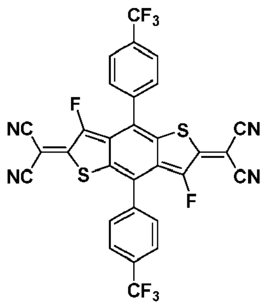
2-13 ,

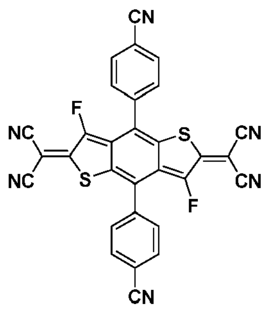
2-14 ,

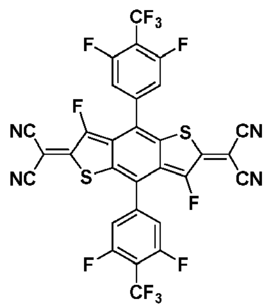
2-15 ,

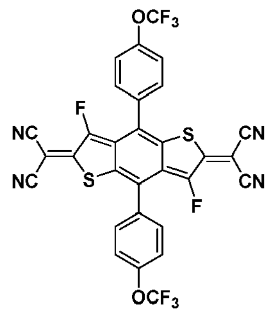
2-16 ,

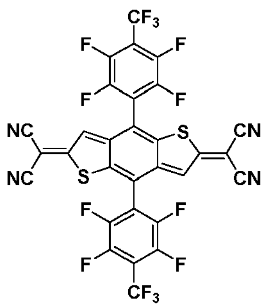
2-17 ,

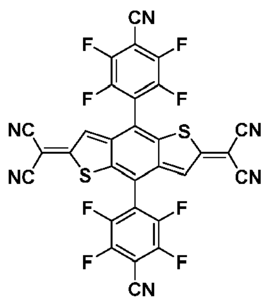
2-18 ,

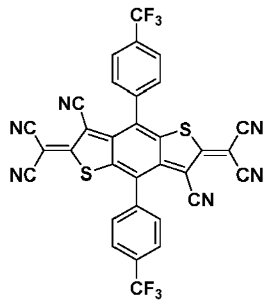
2-19 ,

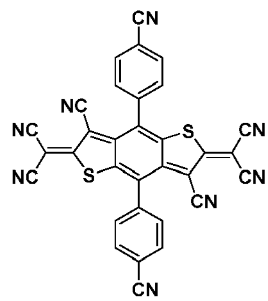
2-20 ,

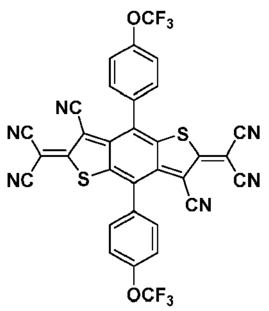
2-21 ,

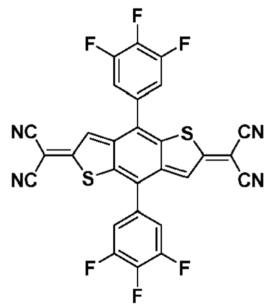
2-22 ,

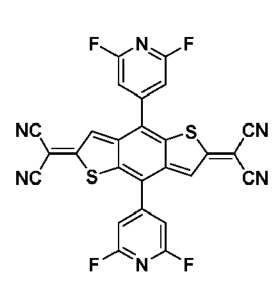
2-23 ;

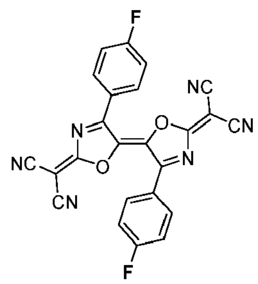
3-1 ,

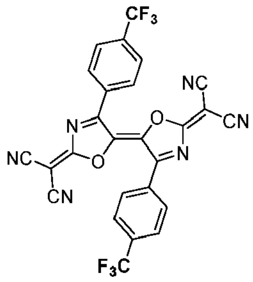
3-2
,

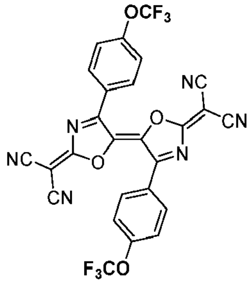
3-3
,

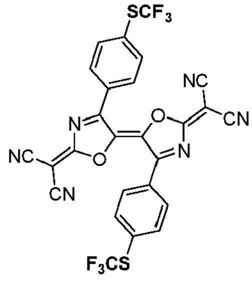
3-4
,

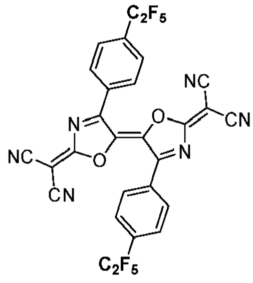
3-5
,

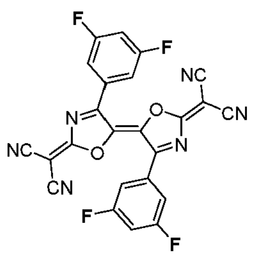
3-6
,

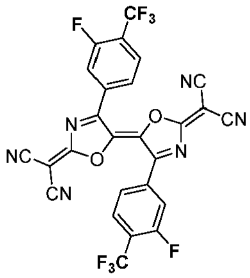
3-7
,

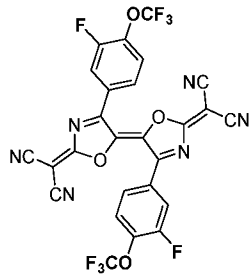
3-8
,

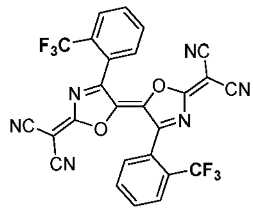
3-9
,

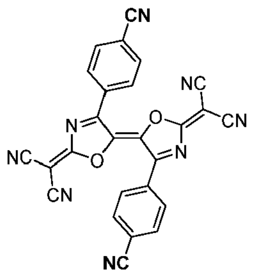
3-10
,

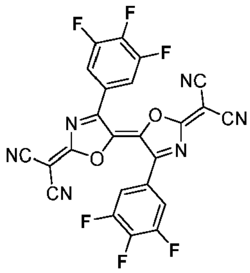
3-11
,

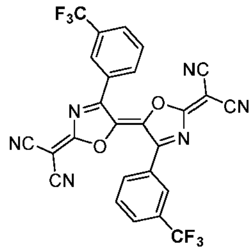
3-12
,

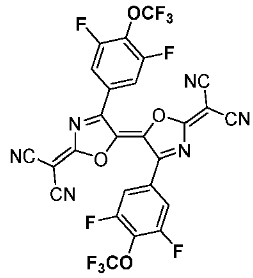
3-13
,

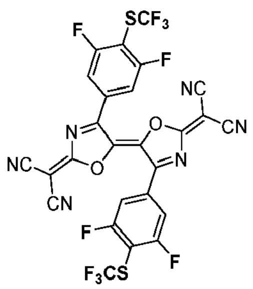
3-14
,

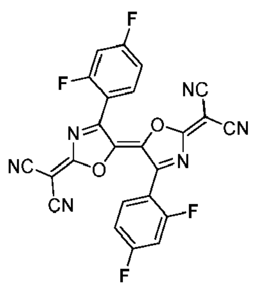
3-15
,

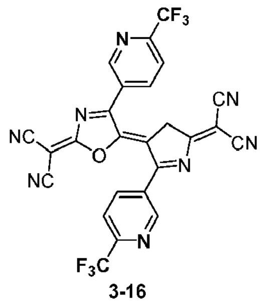
3-16
,

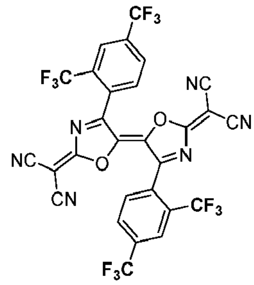
3-17
,

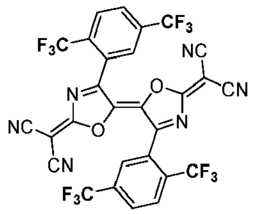

3-18 ,

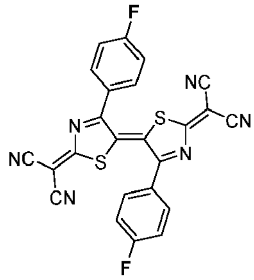

3-19 ,

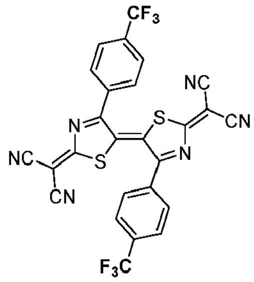

3-20 ,

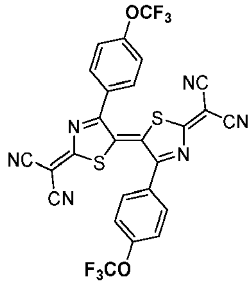

3-21 ,

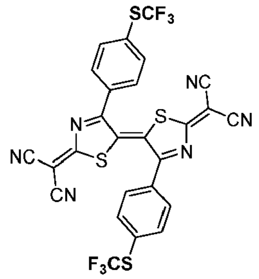

3-22 .

According to an embodiment of the present disclosure, wherein, the device comprises a fourth organic layer containing a fifth organic material, the LUMO energy level of the fifth organic material is denoted as $LUMO_{fifth_organic_material}$, and $LUMO_{fifth_organic_materia}$l < -2.6 eV.
According to an embodiment of the present disclosure, wherein, the device comprises the fourth organic layer containing the fifth organic material, the LUMO energy level of the fifth organic material is denoted as $LUMO_{fifth_organic_material}$, and $LUMO_{fifth_organic_material}$ < -2.8 eV.
According to an embodiment of the present disclosure, wherein, the device comprises an emissive layer, and the fourth organic layer is disposed between the emissive layer and the cathode and in direct contact with the emissive layer.
According to an embodiment of the present disclosure, wherein, the fourth organic layer is an electron transporting layer and in direct contact with the emissive layer.

Combination with Other Materials

The materials described in the present disclosure for a particular layer in an organic light emitting device can be used in combination with various other materials present in the device. The combinations of these materials are described in more detail in U.S. Pat. App. No. 20160359122 at paragraphs 0132-0161, which is incorporated by reference herein in its entirety. The materials described or referred to the disclosure are non-limiting examples of materials that may be useful in combination with the compounds disclosed herein, and one of skill in the art can readily consult the literature to identify other materials that may be useful in combination.
The materials described herein as useful for a particular layer in an organic light emitting device may be used in combination with a variety of other materials present in the device. For example, compound disclosed herein may be used in combination with a wide variety of emissive dopants, hosts, transport layers, blocking layers, injection layers, electrodes and other layers that may be present. The combination of these materials is described in detail in paragraphs 0080-0101 of U.S. Pat. App. No. 20150349273, which is incorporated by reference herein in its entirety. The materials described or referred to the disclosure are non-limiting examples of materials that may be useful in combination with the compounds disclosed herein, and one of skill in the art can readily consult the literature to identify other materials that may be useful in combination.
The device of the present disclosure may include charge injection and transporting layers such as a hole transporting layer, an electron transporting layer and an electron injection layer. The device may further include an emissive layer which contains at least a light-emitting dopant and at least one host compound. The light-emitting dopant may be a fluorescent light-emitting dopant and/or a phosphorescent light-emitting dopant. The device may further include a blocking layer such as a hole blocking layer and an electron blocking layer.
Conventional hole transporting materials in the related art may be used in the hole transporting layer. For

example, the hole transporting layer may typically contain the following hole transporting materials without limitation:

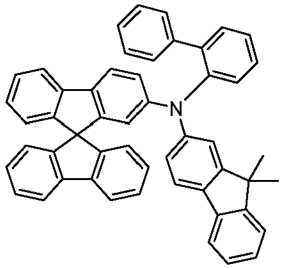 , 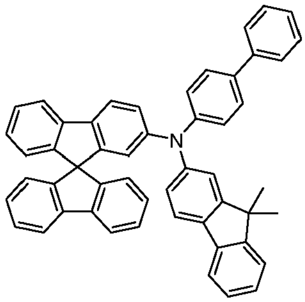 , 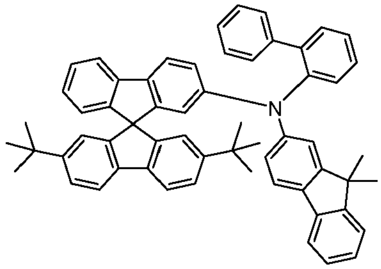 ,

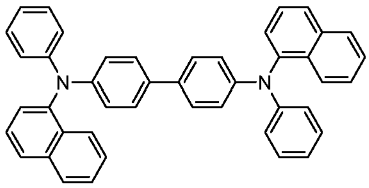 , 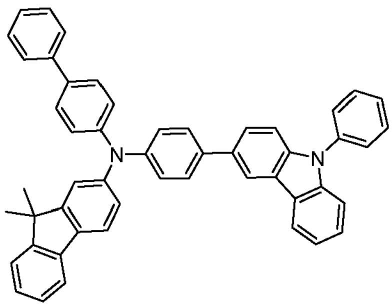 , 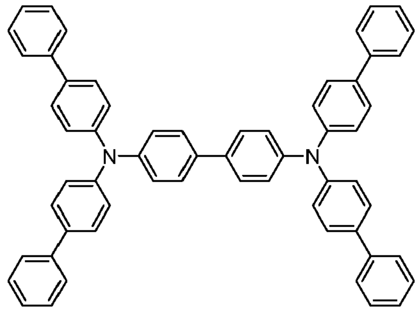 ,

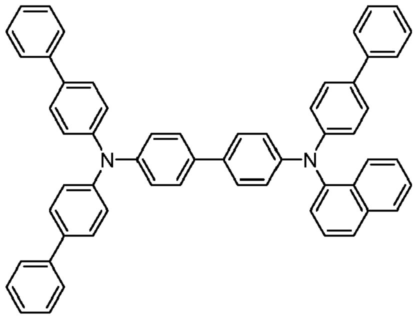 , 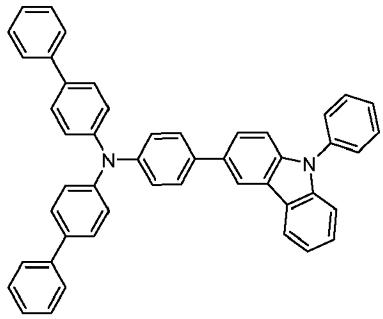 , 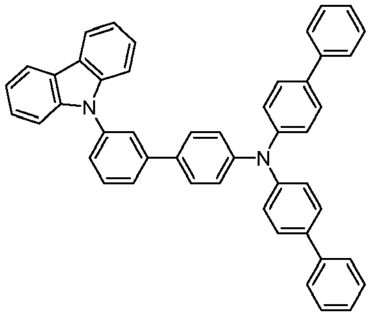 ,

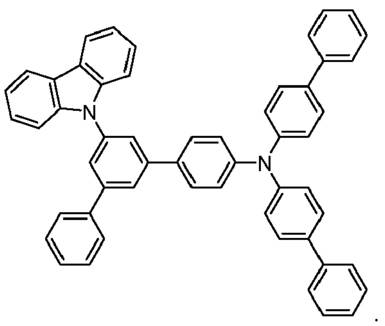 .

Conventional electron transporting materials in the related art may be used in the electron transporting layer. For example, the electron transporting layer may typically contain the following electron transporting materials without limitation:

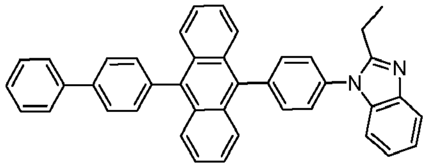,
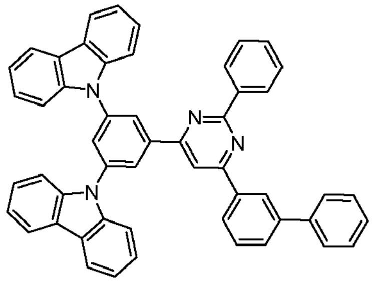,
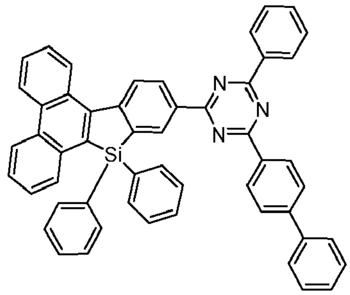,
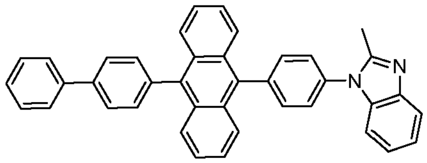,
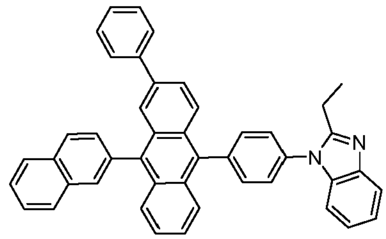,
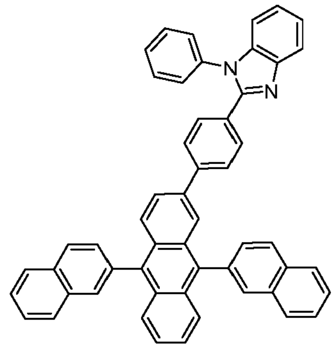,
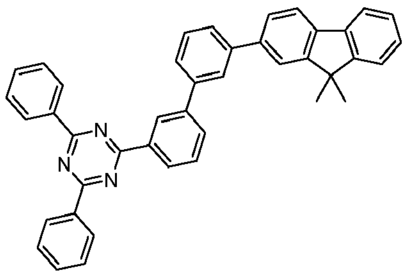,
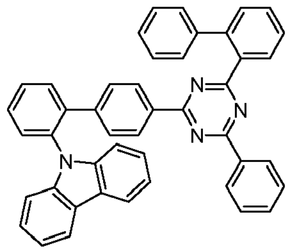,
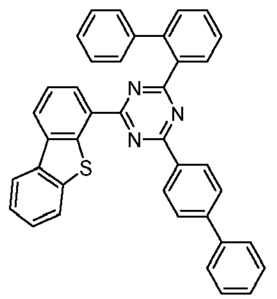,
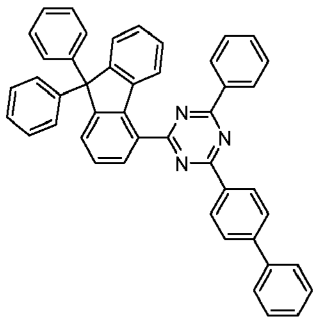,
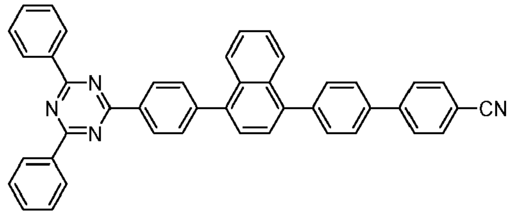,
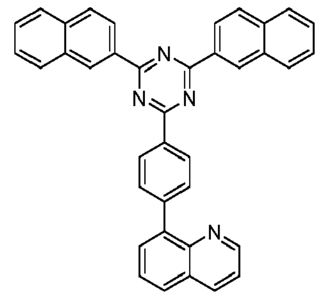.

Conventional light-emitting materials and host materials in the related art may be used in the emissive layer. For example, the emissive layer may typically contain the following fluorescent light-emitting materials and fluorescent host materials without limitation:

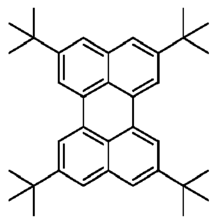
,
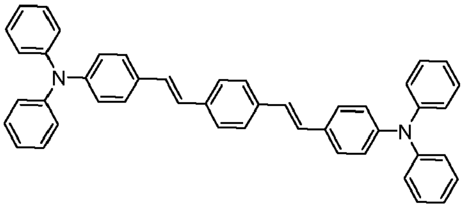
,
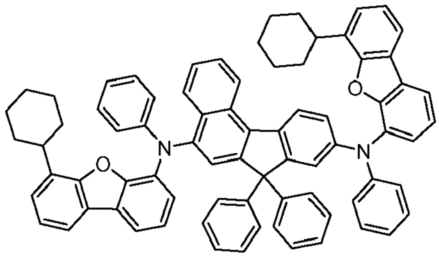
,

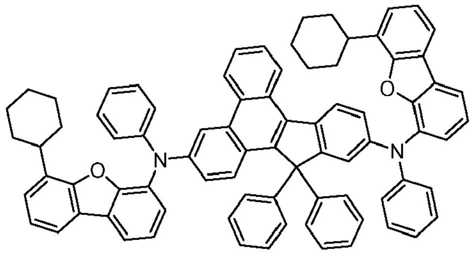
,
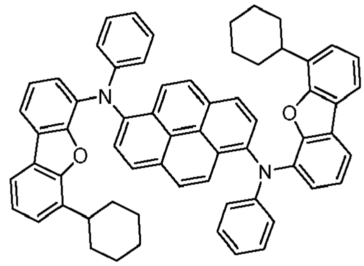
,
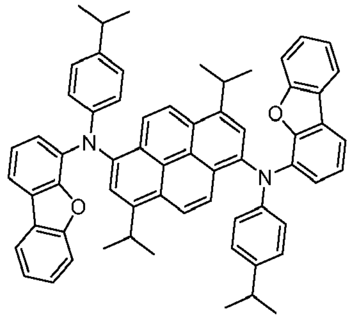
,

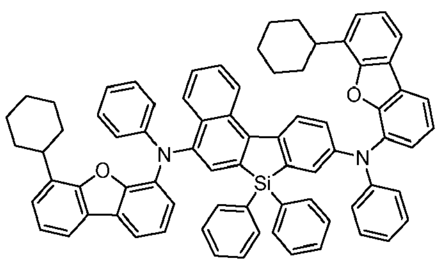
,
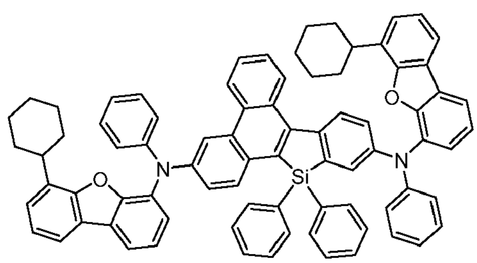
,

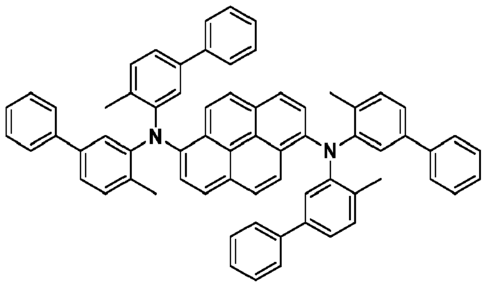
,
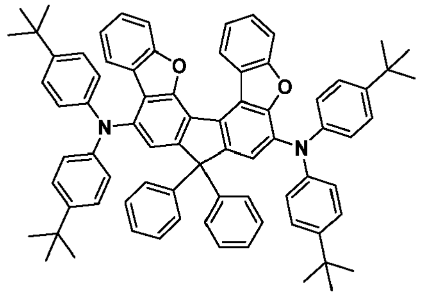
,
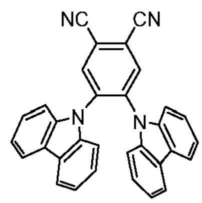
,

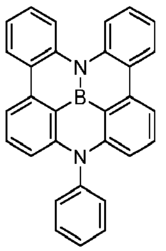
,
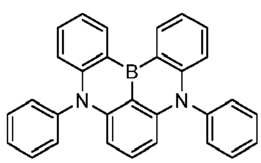
,
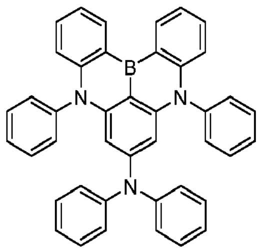
,
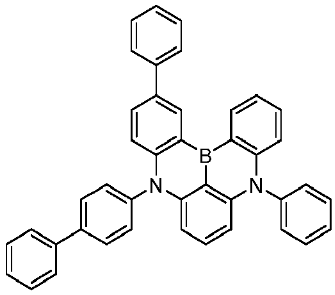
,

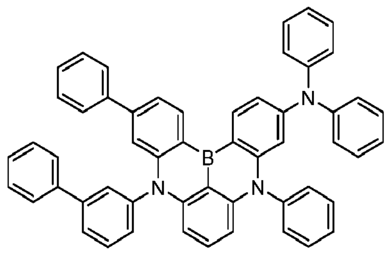,
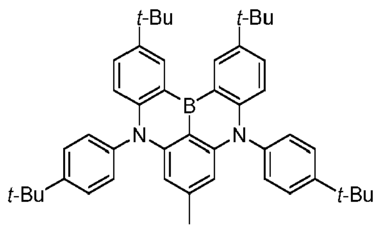,
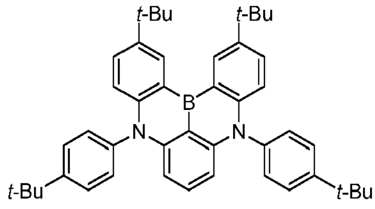,

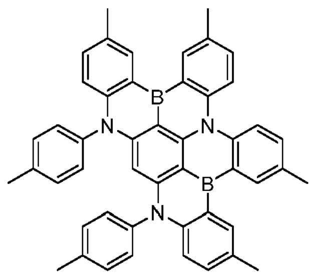,
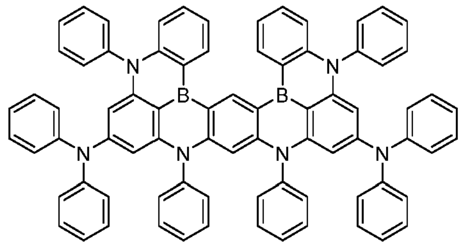,

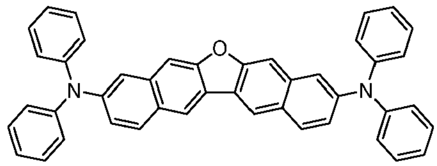,
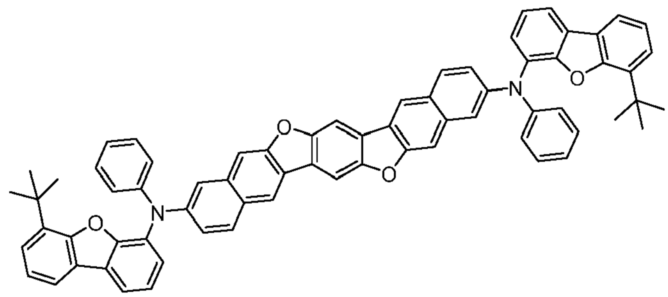,

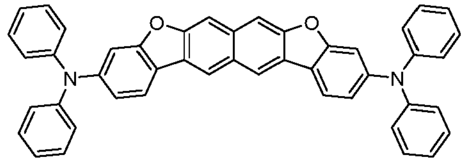,
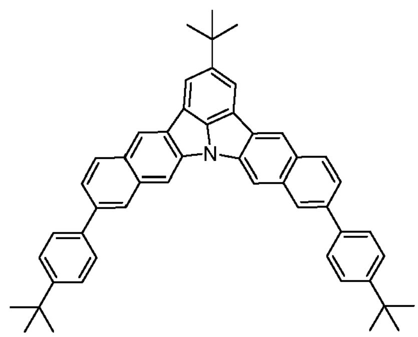,

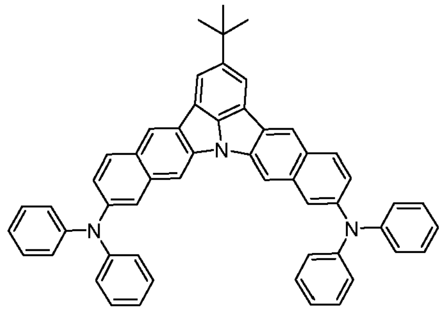,
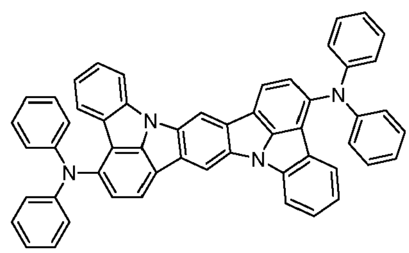,
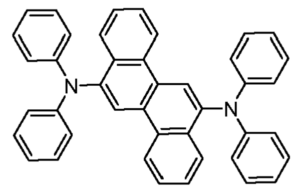,

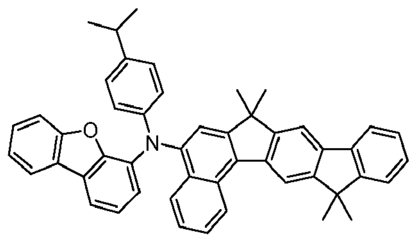
,
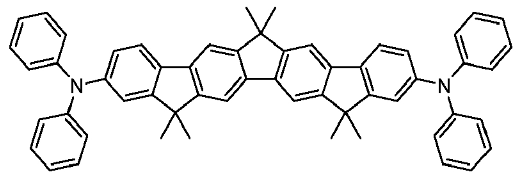
,

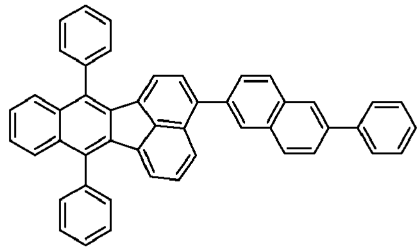
;

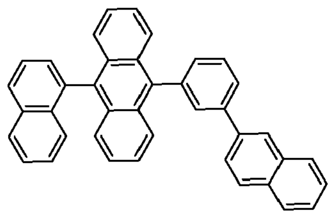
,
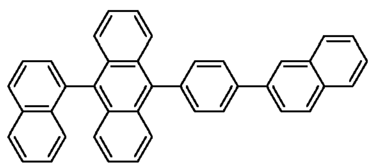
,
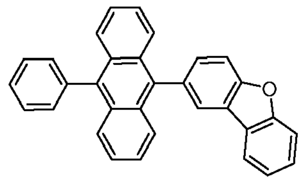
,

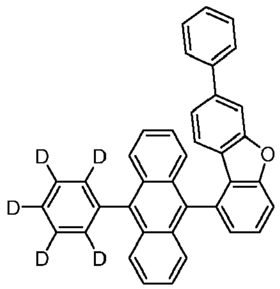
,
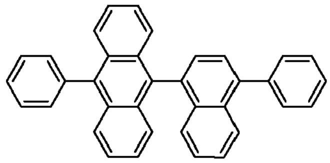
,
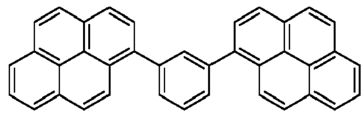
,

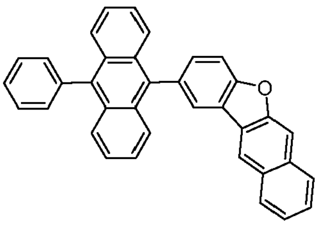
,
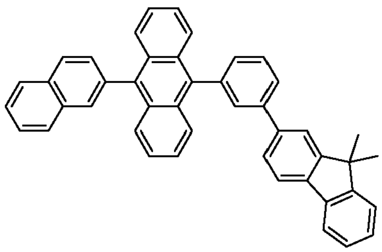
,
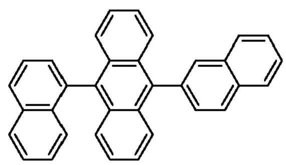
,

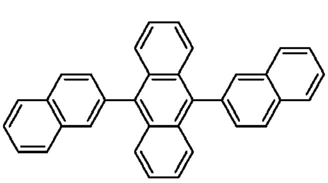
,
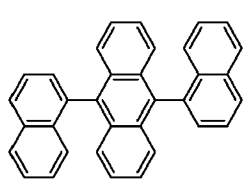
,
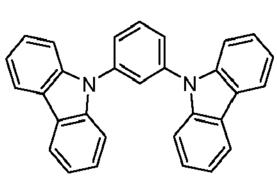
,

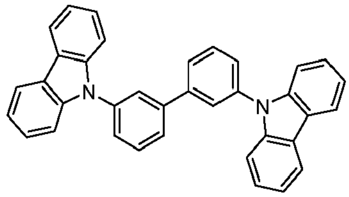, 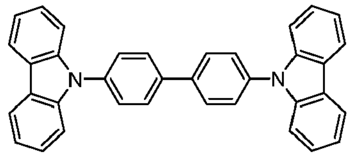, 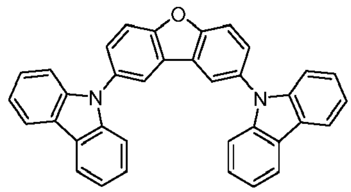.

The emissive layer may also typically contain the following phosphorescent light-emitting materials and phosphorescent host materials without limitation:

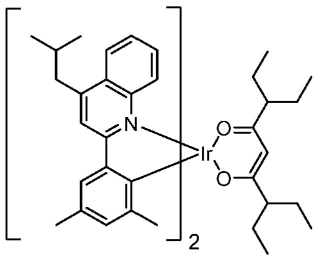, 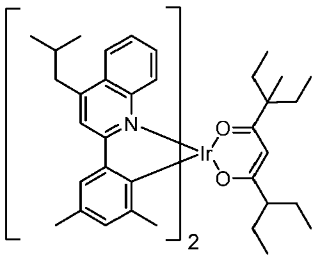, 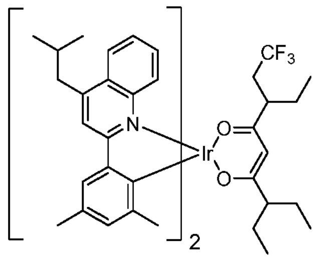,

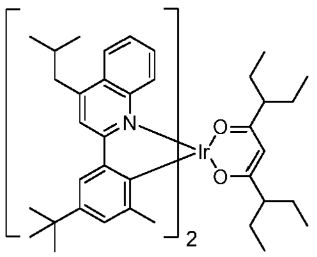, 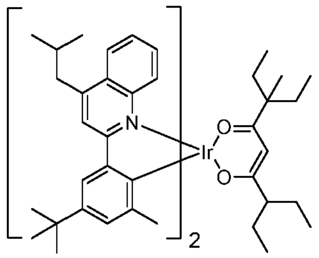, 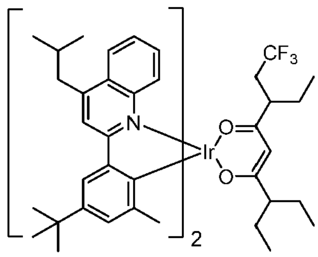,

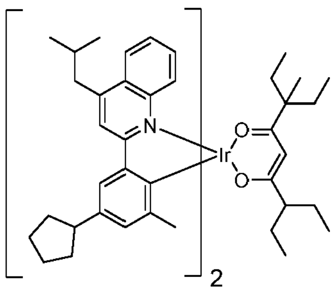, 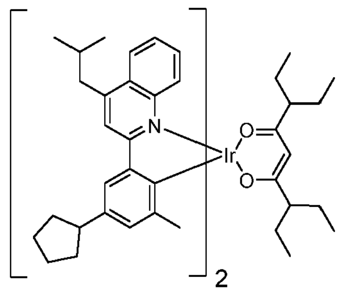, 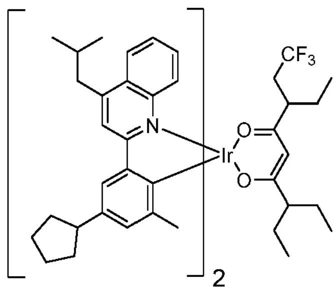,

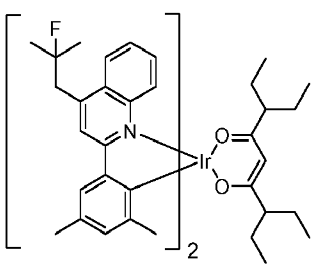, 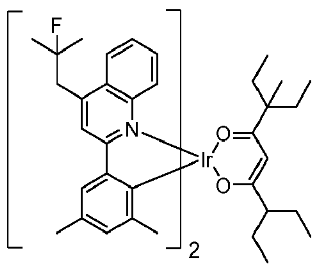, 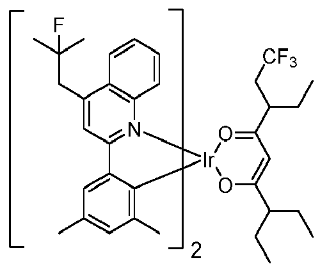,

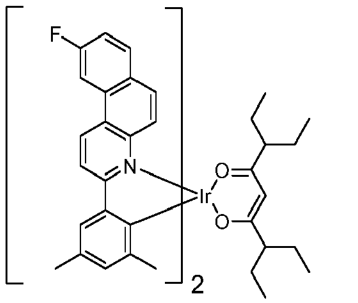,
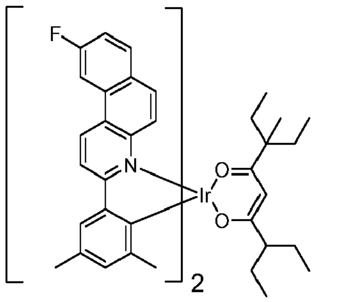,
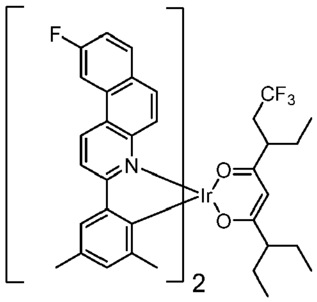,

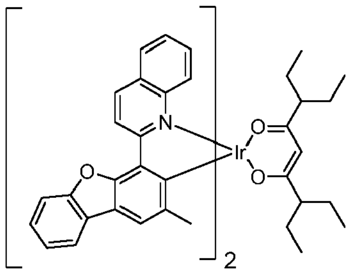,
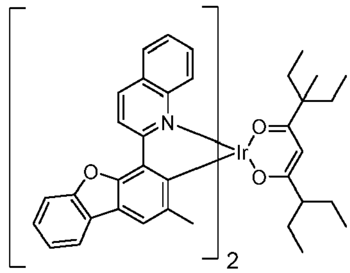,
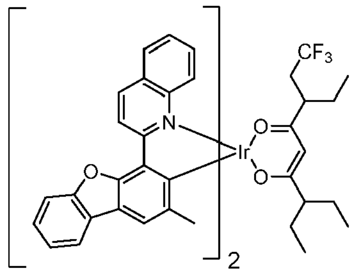,

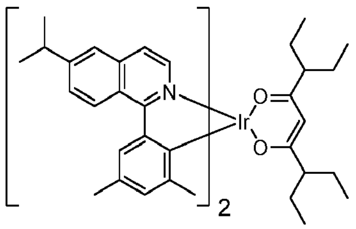,
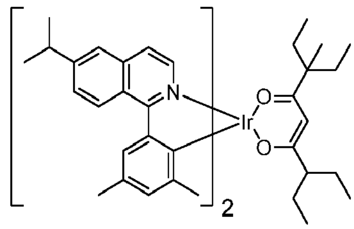,
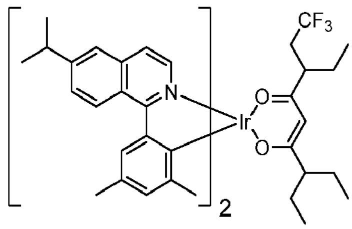,

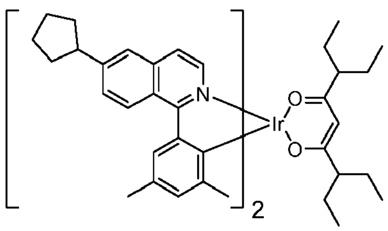,
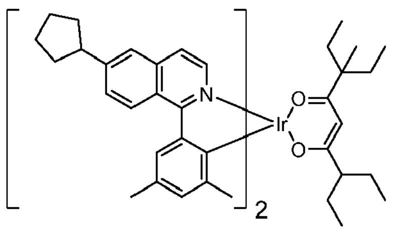,
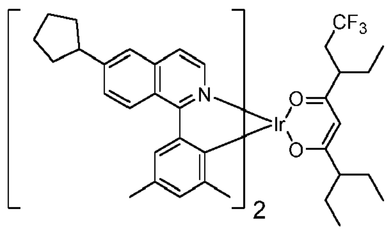,

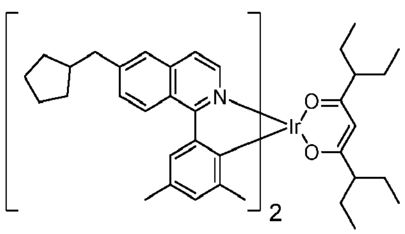,
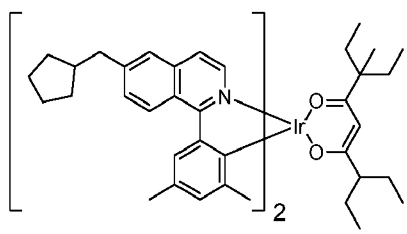,

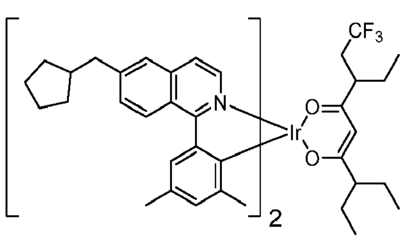,
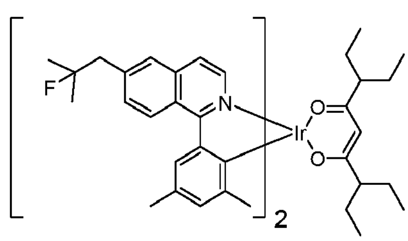,

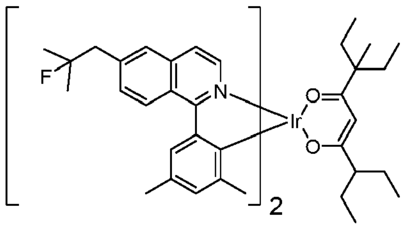,
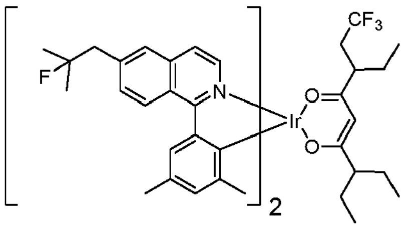,
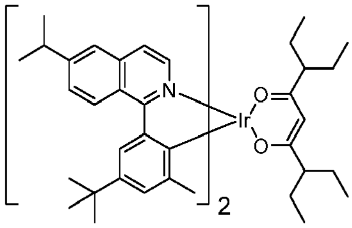,
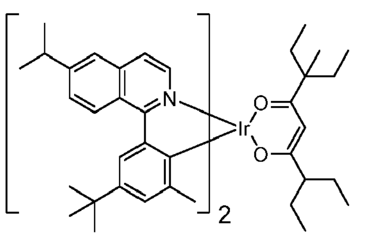,
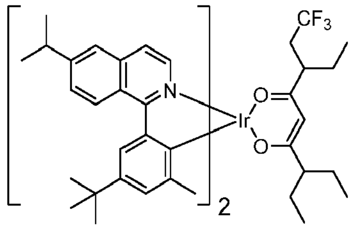,
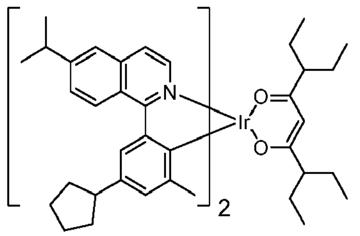,
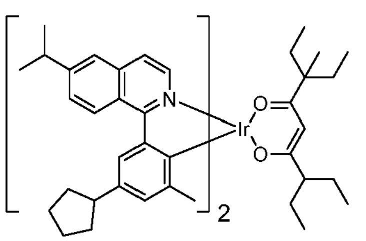,
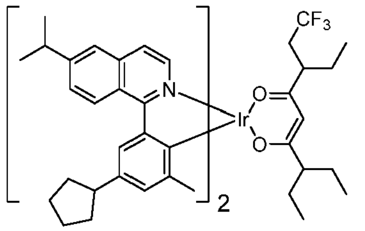,
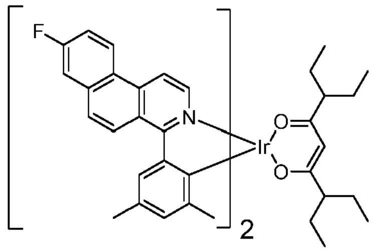,
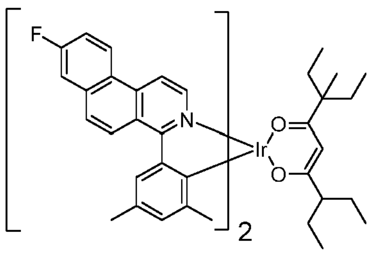,
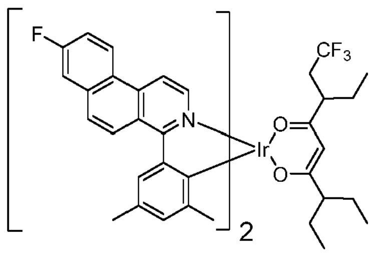,
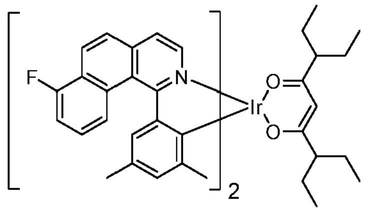,
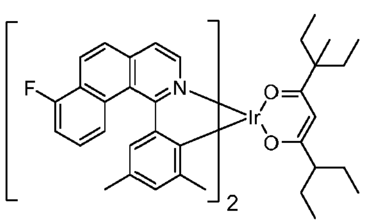,
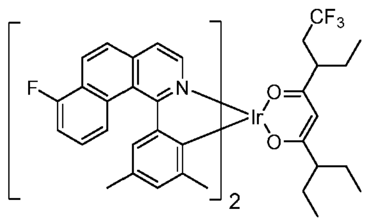,
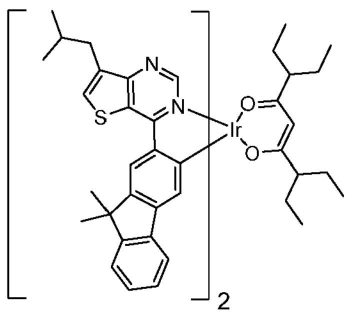,

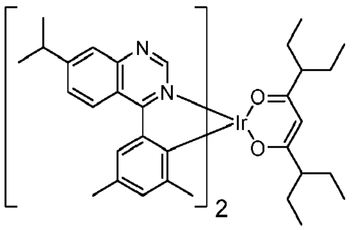 , 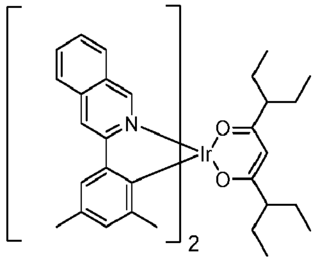 , 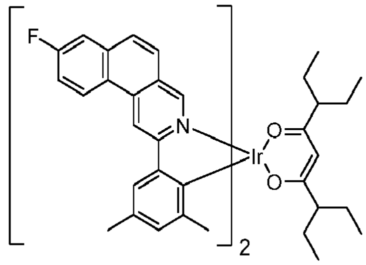 ,

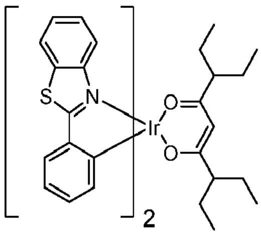 , 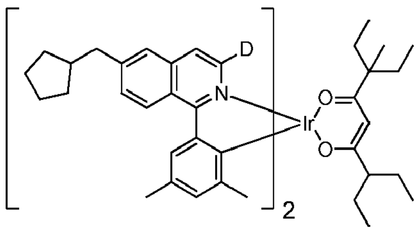 , 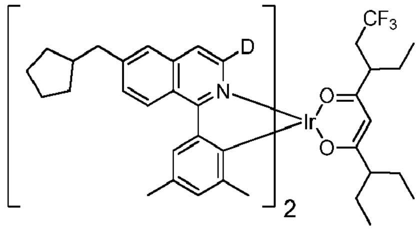 ,

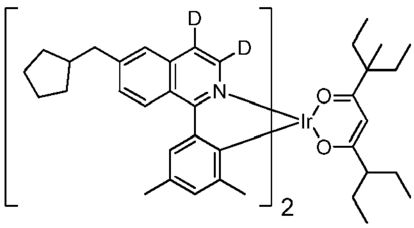 , 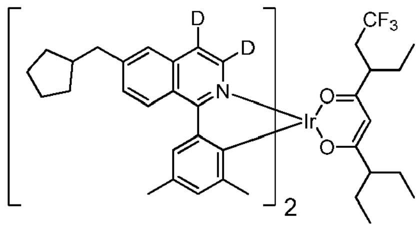 , 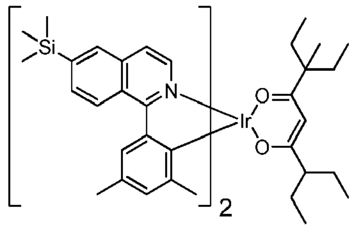 ,

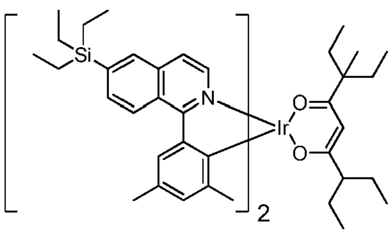 , 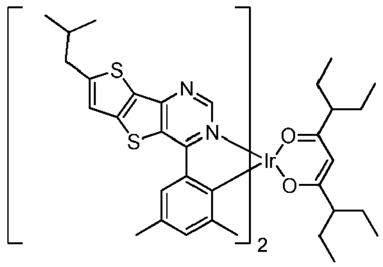 , 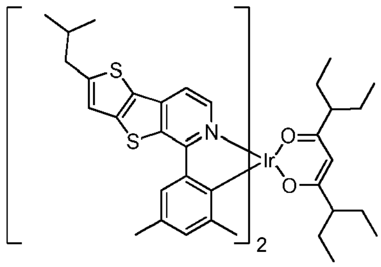 ,

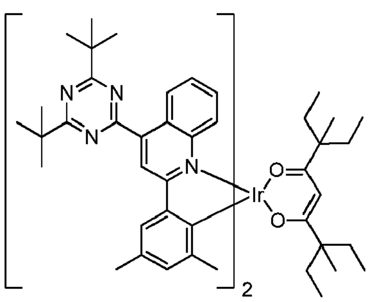 , 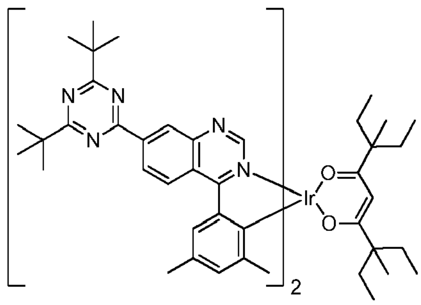 , 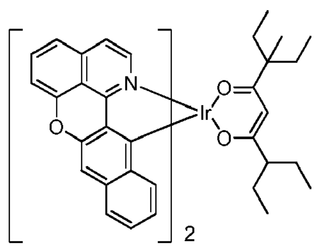 ,

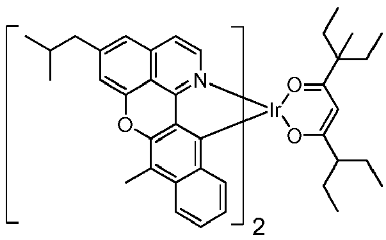 , 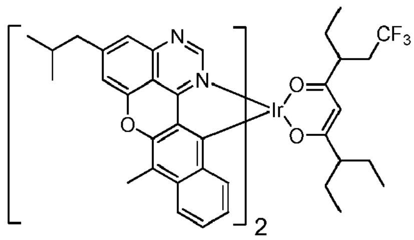 , 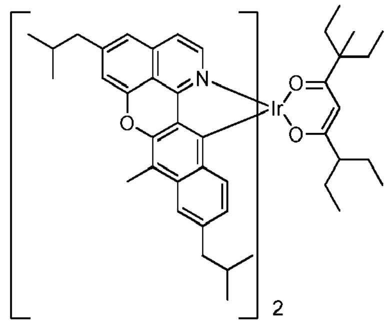 ,

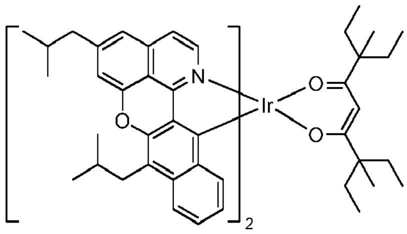 , 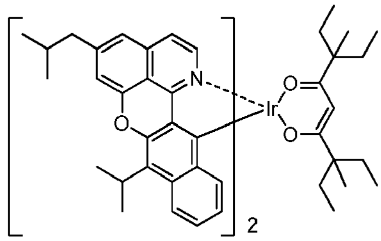 , 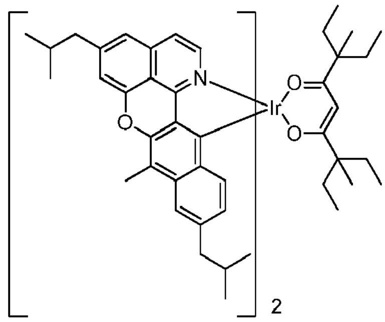 ,

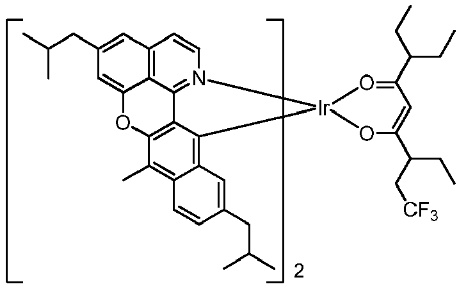 , 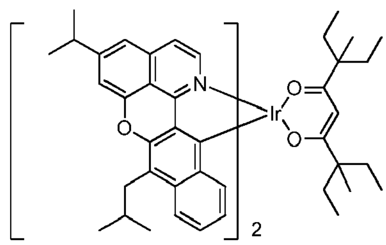 ,

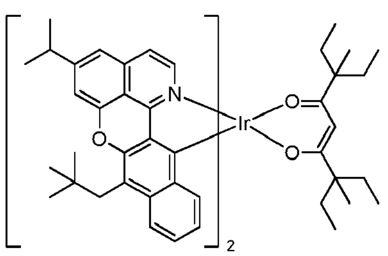 , 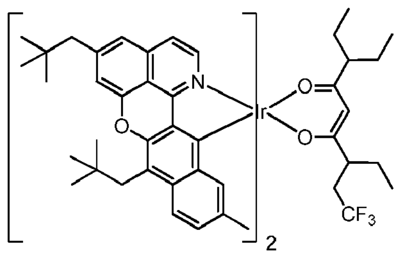 , 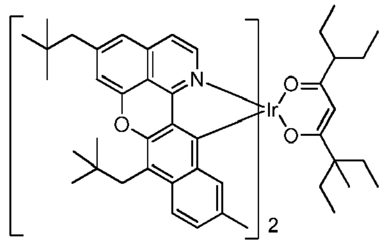 ,

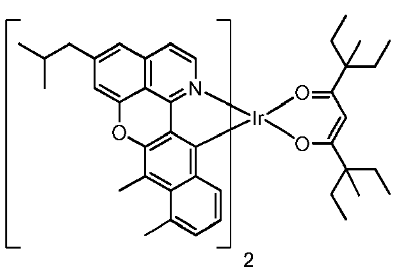 , 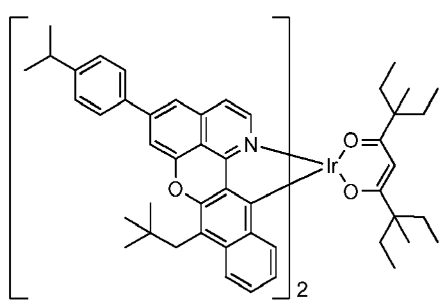 ,

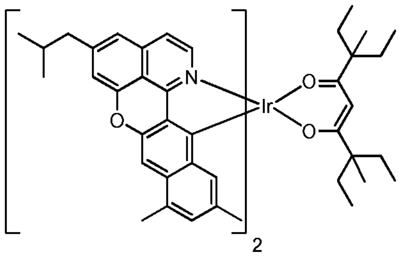 , 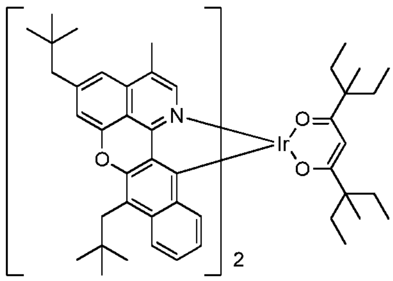 , 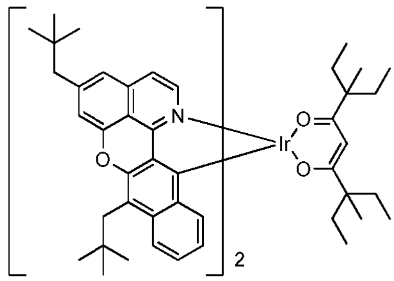 ,

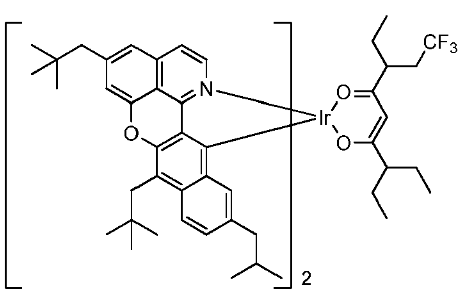 , 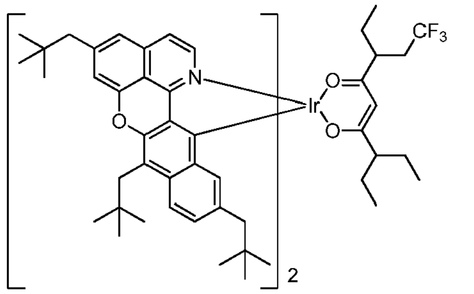 ,

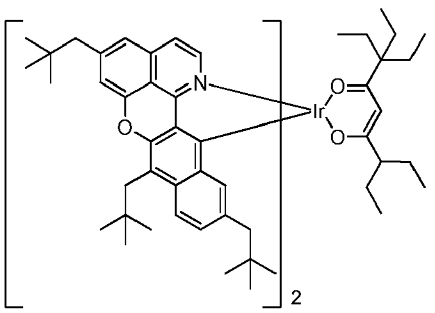 , 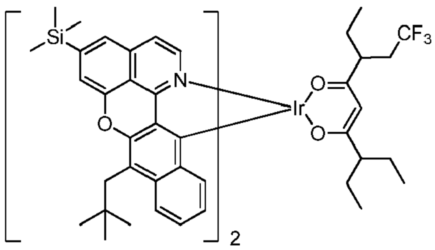 ,

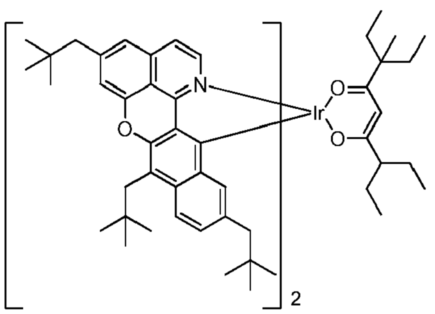 , 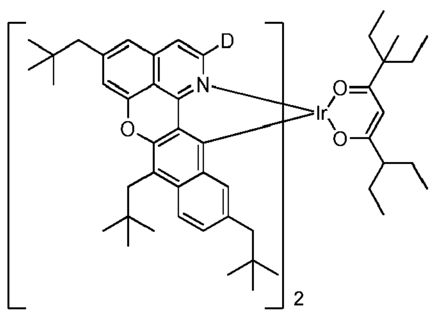 ,

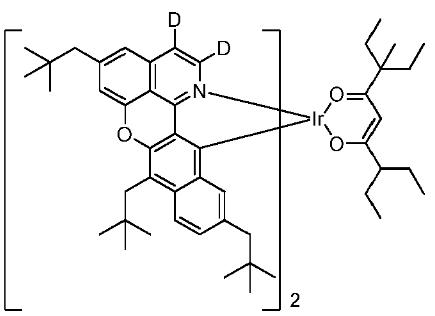 , 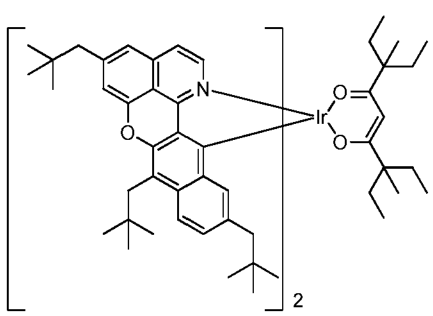 ,

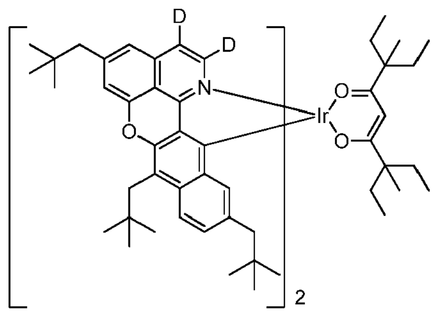,
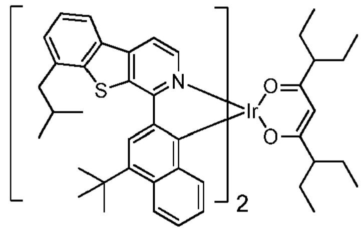,
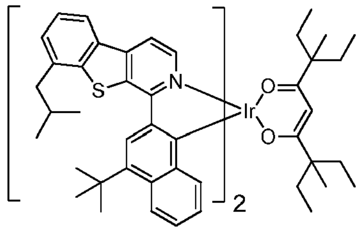,

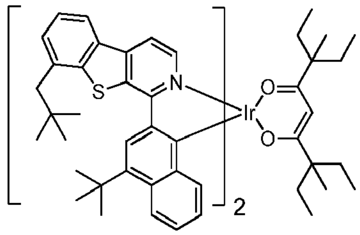,
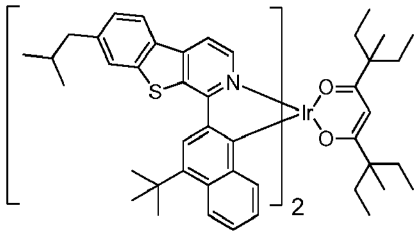,
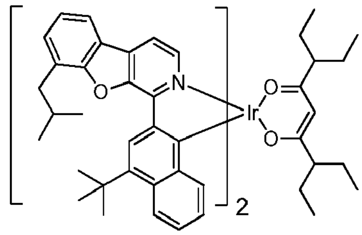,

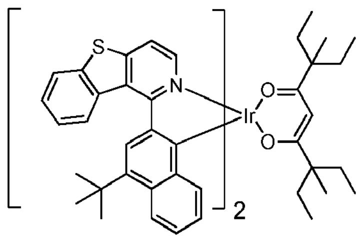,
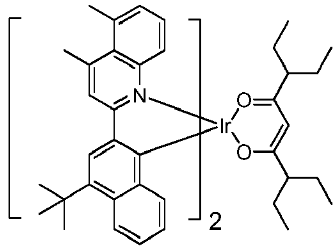,
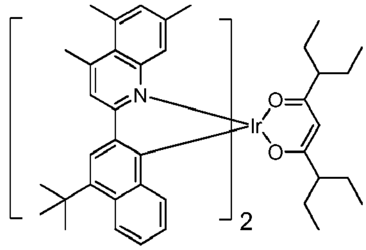,

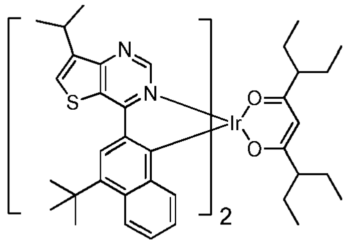,
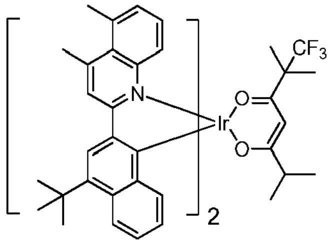,
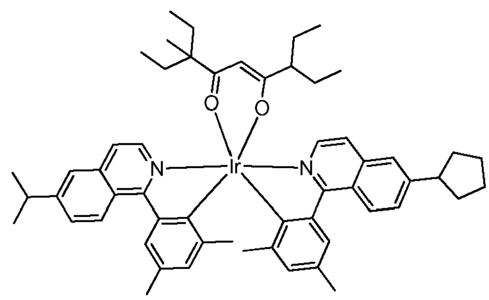,

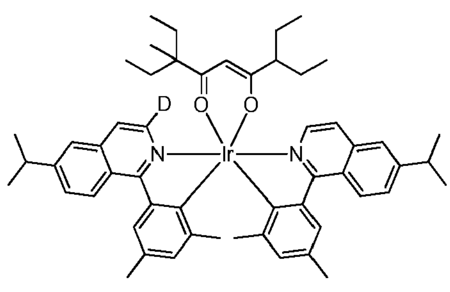,
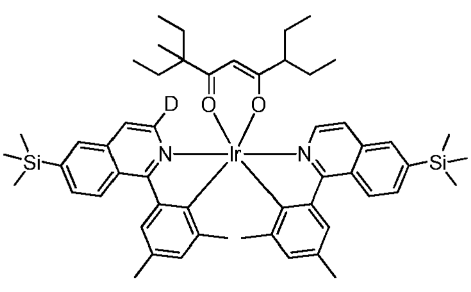,

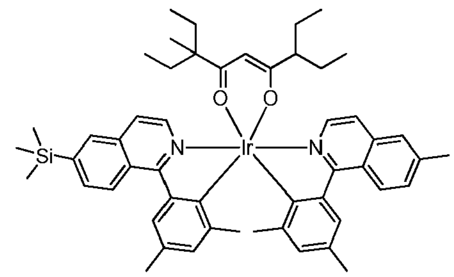
,
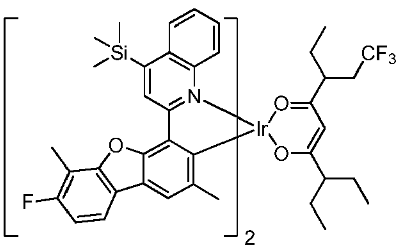
,

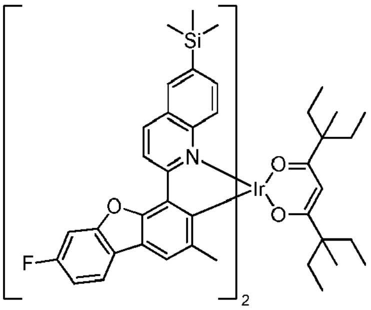
,
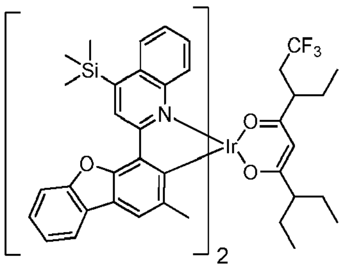
,
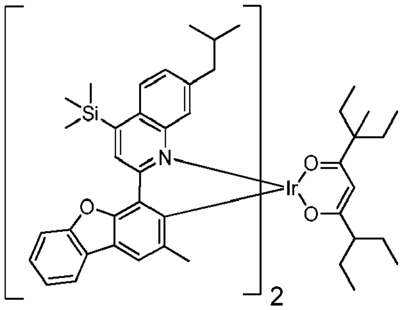
,

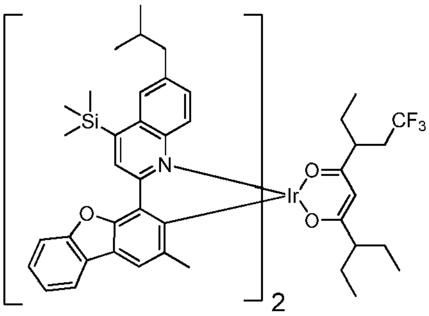
,
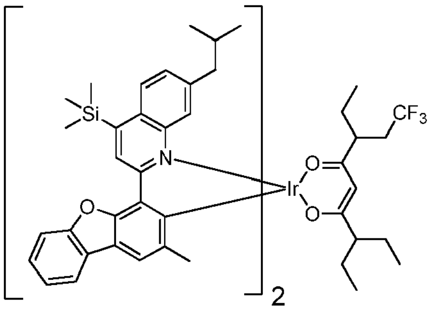
,
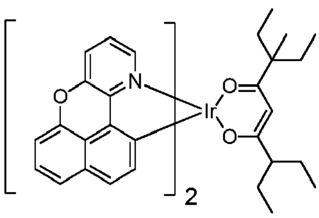
,

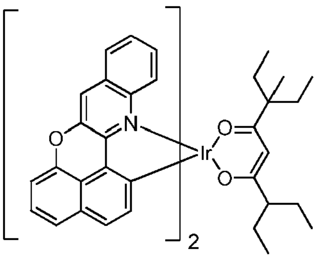
,
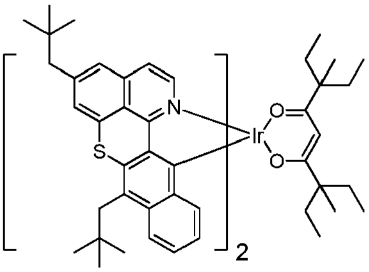
,
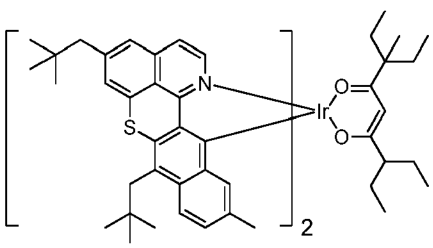
,

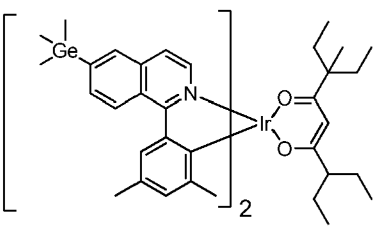
,
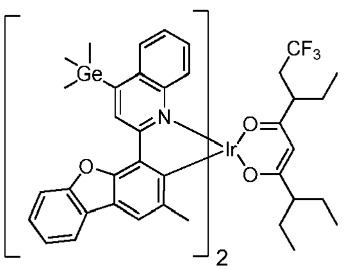
,
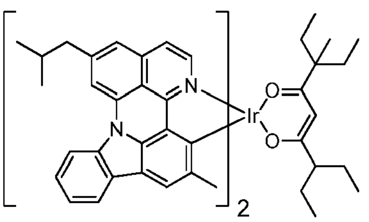
,

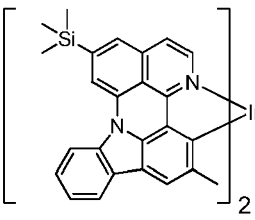,
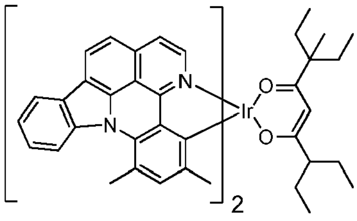;

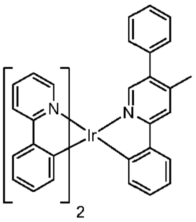,
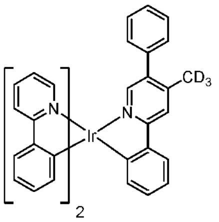,
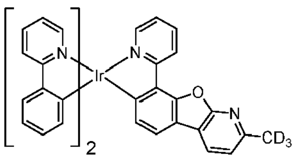,
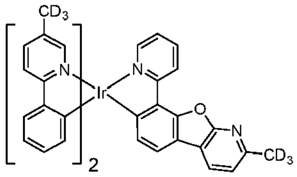,

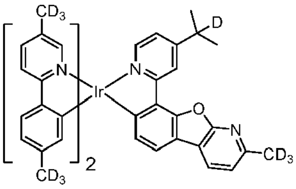,
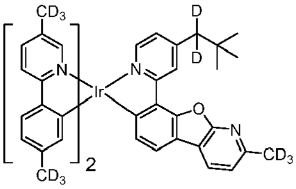,
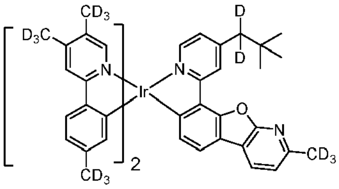,

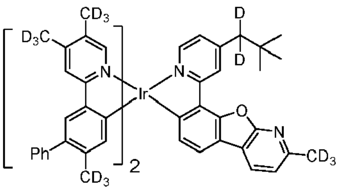,
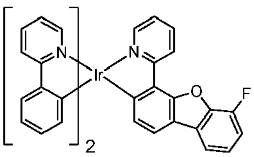,
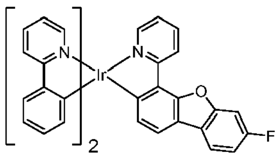,
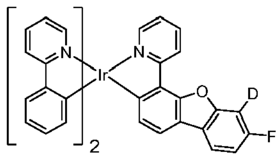,

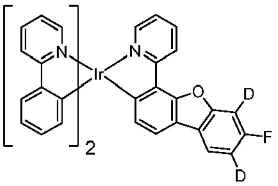,
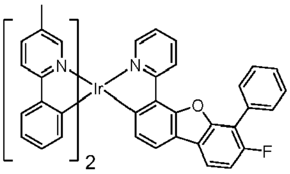,
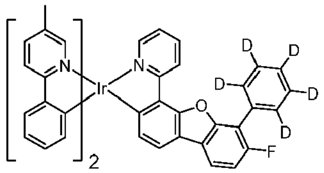,

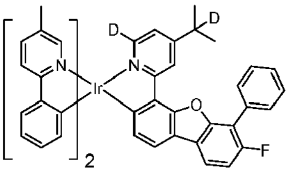,
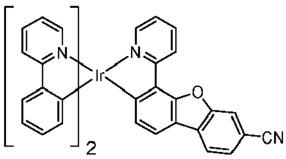,
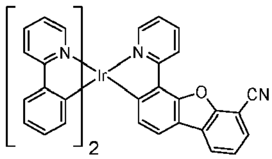,
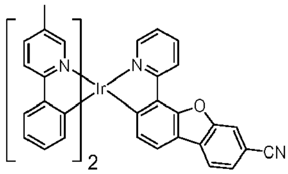,

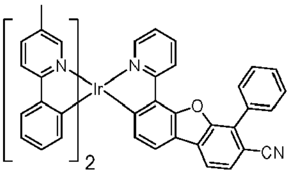,
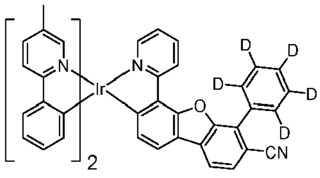,
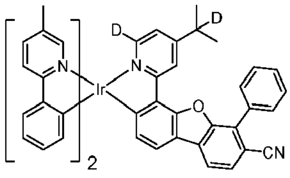,

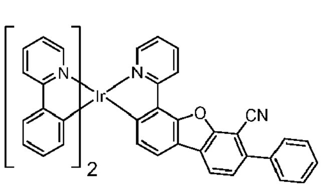 , 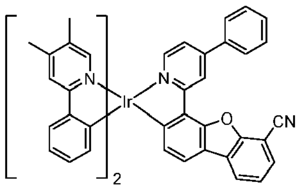 , 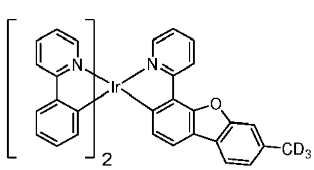 ,

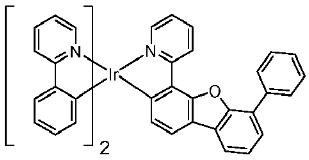 , 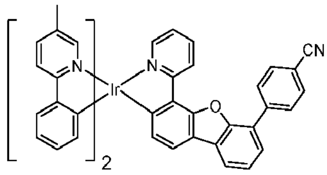 , 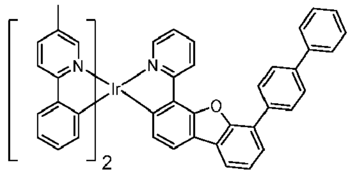 ,

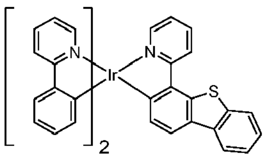 , 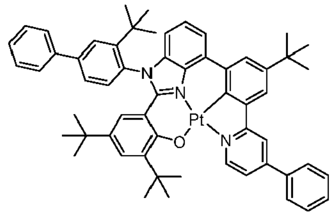 , 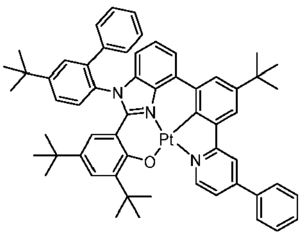 ,

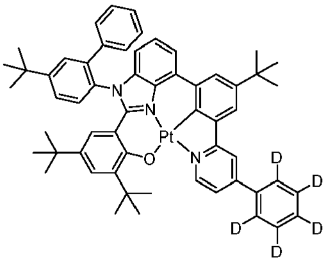 , 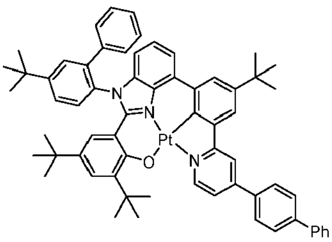 , 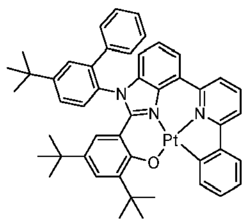 ,

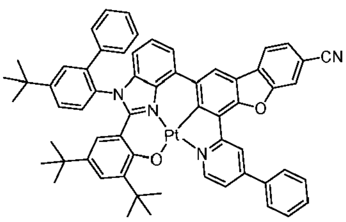 , 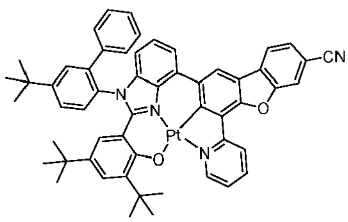 , 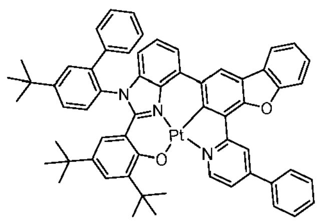 ,

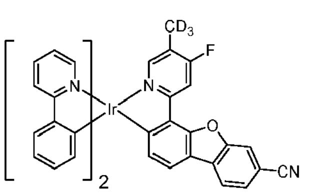 , 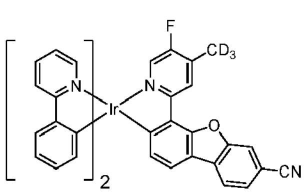 , 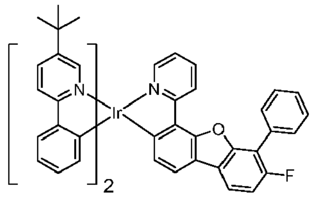 ,

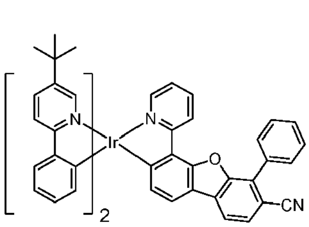 , 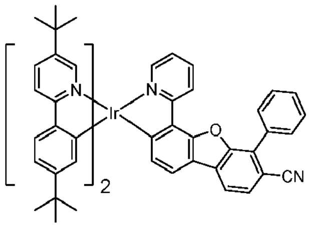 , 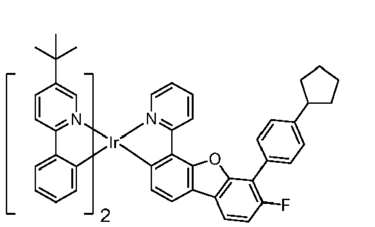 ,

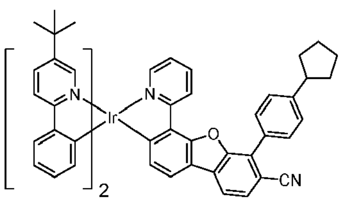 , 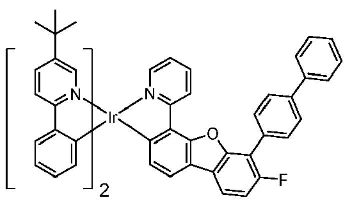 , 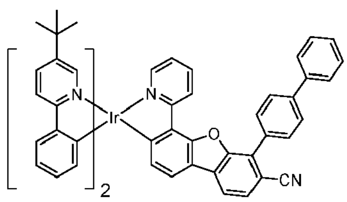 ,

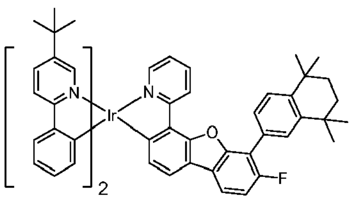 , 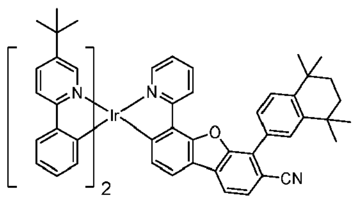 , 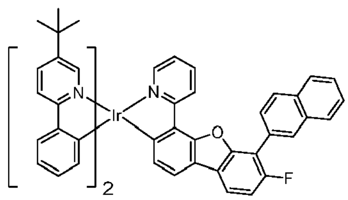 ,

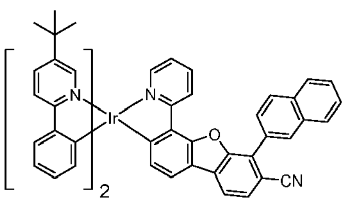 , 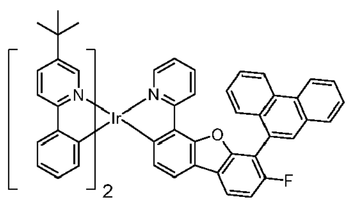 , 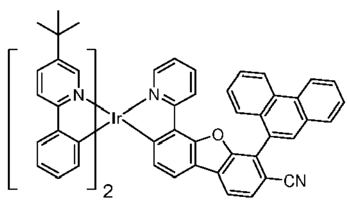 ,

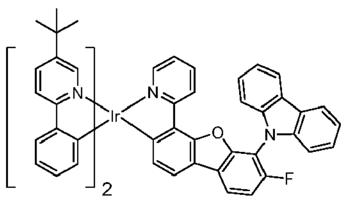 , 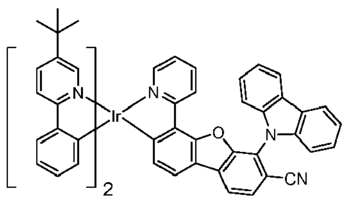 ;

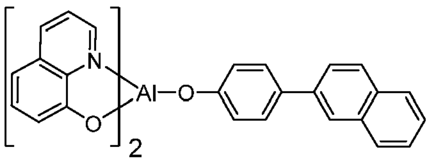 , 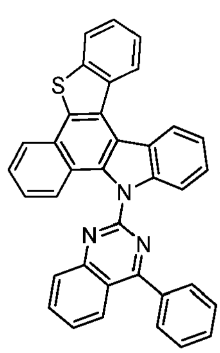 , 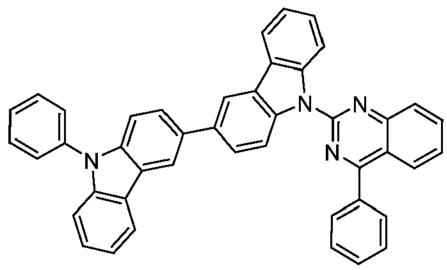 ,

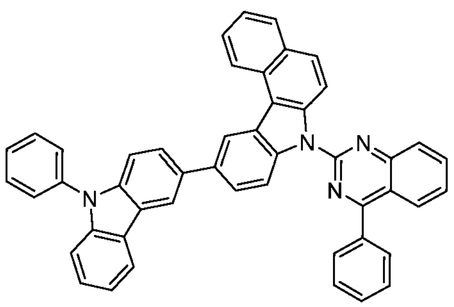
,
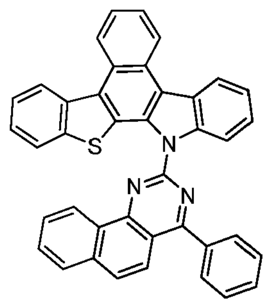
,
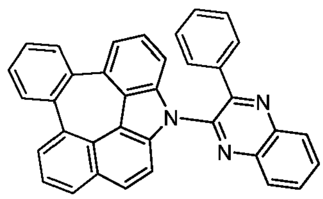
,

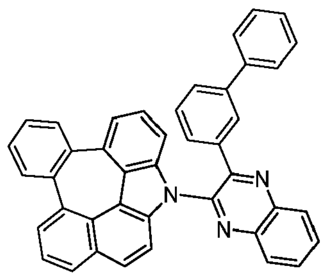
,
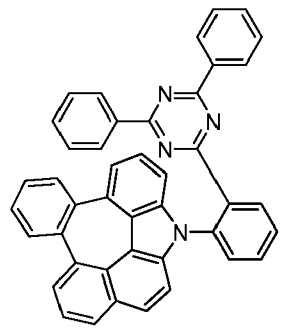
,
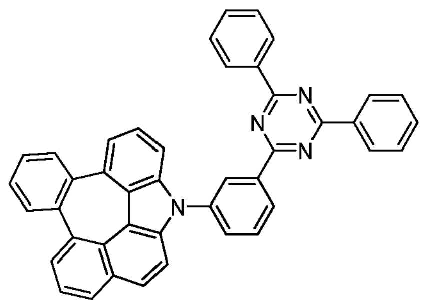
,

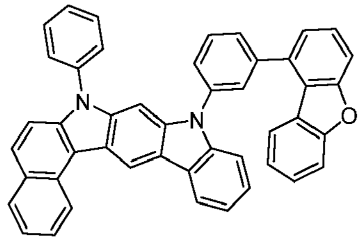
,
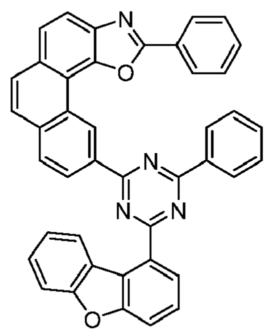
,
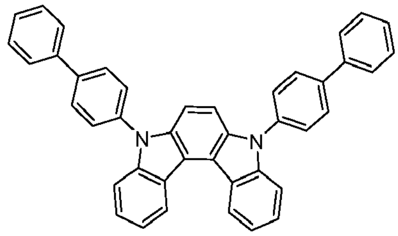
,

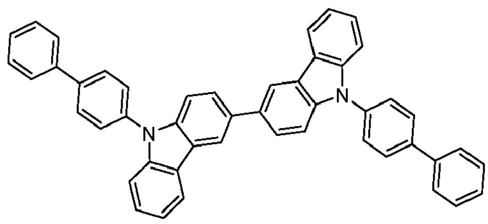
,
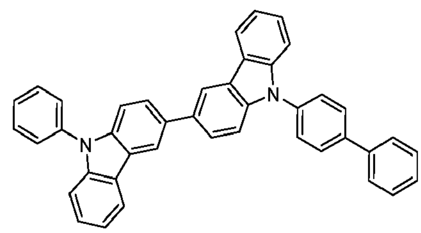
,

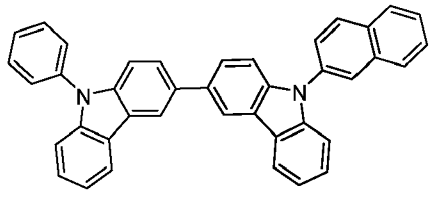
,
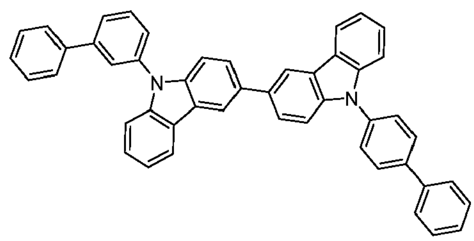
,

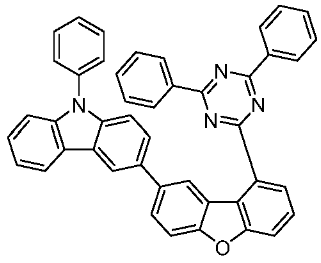,
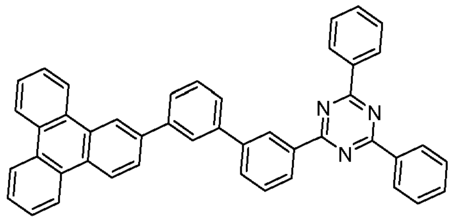,
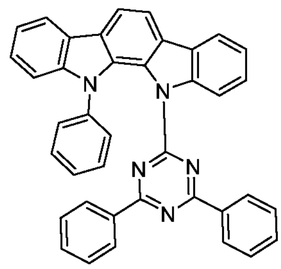,

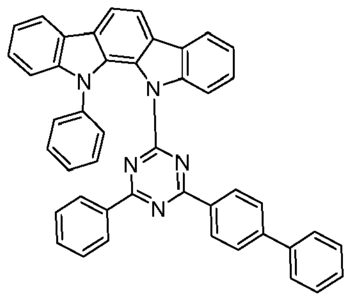,
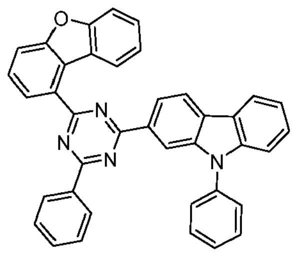,
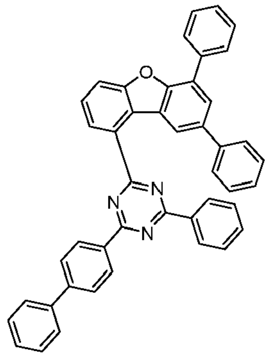,

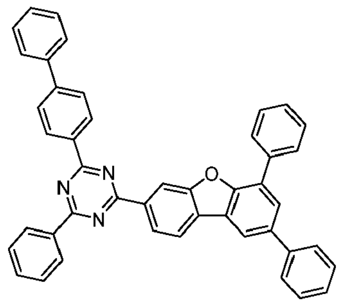.

Conventional electron blocking materials in the related art may be used in the electron blocking layer. For example, the electron blocking layer may typically contain the following electron blocking materials without limitation:

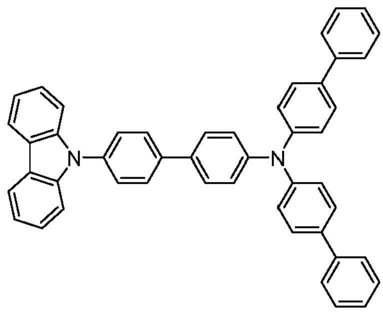,
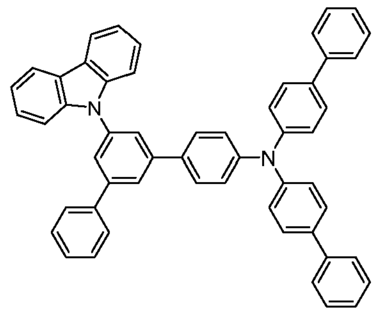,
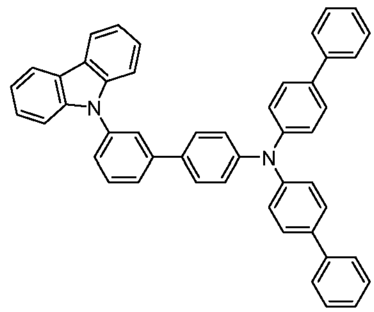,

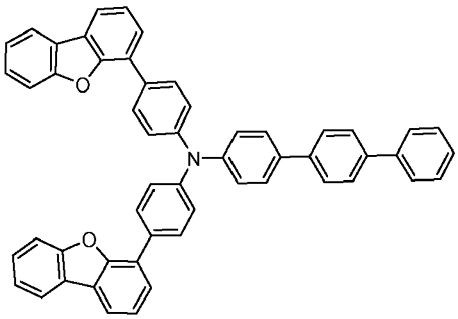,
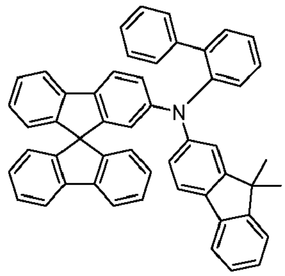.

In the embodiments of the device, the characteristics of the device were also tested using conventional equipment in the art (including, but not limited to, an evaporator produced by ANGSTROM ENGINEERING, an optical testing system produced by SUZHOU FSTAR, a lifetime testing system produced by SUZHOU FSTAR, an ellipsometer produced by BEIJING ELLITOP, etc.) by methods well-known to the persons skilled in the art. As the persons skilled in the art are aware of the above-mentioned equipment use, test methods and other related contents, the inherent data of the sample can be obtained with certainty and without influence, so the above related contents are not further described in this patent.

LUMO energy levels and HOMO energy levels of materials herein are all tested by a cyclic voltammetry method. The test is conducted using an electrochemical workstation modelled CorrTest CS120 produced by Wuhan Corrtest Instruments Corp., Ltd and using a three-electrode working system where a platinum disk electrode serves as a working electrode, an $Ag/AgNO_3$ electrode serves as a reference electrode, and a platinum wire electrode serves as an auxiliary electrode. Anhydrous DCM is used as a solvent, 0.1 mol/L tetrabutylammonium hexafluorophosphate is used as a supporting electrolyte, a compound to be tested is prepared into a solution of $10^{-3}$ mol/L, and nitrogen is introduced into the solution for 10 min to remove oxygen before the test. The parameters of the instrument are set as follows: a scan rate of 100 mV/s, a potential interval of 0.5 mV and a test window of -1 V to 1 V

The LUMO energy level of the first organic material and the HOMO energy level of the second organic material are tested by the preceding cyclic voltammetry method, and the conductivity of the organic layer composed of the first organic material and the second organic material is measured. In a high vacuum (for example, $10^{-6}$ Torr) environment, to-be-tested sample HTM and PD materials are co-deposited through evaporation at a certain doping proportion on a test substrate pre-prepared with aluminum electrodes to form a to-be-tested region with a thickness of 100 nm, a length of 6 mm and a width of 1 mm, the resistance value of the to-be-tested region is obtained by applying a voltage to the electrodes and measuring a current at room temperature, and the conductivity of the given thin film is calculated according to the Ohm's law and the geometric dimensions. Relevant data is shown in the following table:

| First Organic Material | $LUMO_{first_organic_material}$ (eV) | Second Organic Material | $HOMO_{second_organic_material}$ (eV) | $LUMO_{first_organic_material}$ - $HOMOsecond_{_organic_material}$ (eV) | Doping Proportion of the First Organic Material (wt%) | Conductivity of the Organic Layer ($10^{-5}$ S/m) |
|---|---|---|---|---|---|---|
| Compound 1-2 | -4.63 | HT-7 | -5.13 | 0.50 | 3 | 2.4 |
| Compound 1-2 | -4.63 | HT-7 | -5.13 | 0.50 | 20 | 89 |
| Compound 1-2 | -4.63 | HT-7 | -5.13 | 0.50 | 25 | 92 |
| Compound 1-2 | -4.63 | HT-7 | -5.13 | 0.50 | 30 | 95 |
| Compound 1-2 | -4.63 | HT-12 | -5.11 | 0.48 | 20 | 24 |
| Compound 1-2 | -4.63 | HTM-A | -5.09 | 0.46 | 20 | 30 |
| Compound 1-2 | -4.63 | HTM-B | -5.09 | 0.46 | 20 | 11 |

(continued)

| First Organic Material | $LUMO_{first_organic_material}$ (eV) | Second Organic Material | $HOMO_{second_organic_material}$ (eV) | $LUMO_{first_organic_material}$ - $HOMO_{second_organic_material}$ (eV) | Doping Proportion of the First Organic Material (wt%) | Conductivity of the Organic Layer ($10^{-5}$ S/m) |
|---|---|---|---|---|---|---|
| Compound 3-2 | -4.8 | HT-7 | -5.13 | 0.33 | 2 | 2.6 |
| Compound 3-2 | -4.8 | HT-7 | -5.13 | 0.33 | 3 | 7.9 |
| Compound 3-2 | -4.8 | HT-7 | -5.13 | 0.33 | 5 | 39 |
| Compound 3-2 | -4.8 | HT-7 | -5.13 | 0.33 | 10 | 140 |
| Compound PD-1 | -5.04 | HT-7 | -5.13 | 0.09 | 2 | 110 |

Device Example

The working principle of the organic electroluminescent device is specifically described below through several examples. Apparently, the following examples are only for the purpose of illustration and not intended to limit the scope of the present disclosure. Based on the following examples, those skilled in the art can obtain other examples of the present disclosure by conducting improvements on these examples.

Examples 1-1 to 1-5 and Comparative Examples 1-1 to 1-5 are red phosphorescent light-emitting devices.

Example 1-1

The implementation of Example 1-1 is described below. A glass substrate having an indium tin oxide (ITO) anode (with a thickness of 1200 Å) was cleaned, treated with UV ozone and oxygen plasma, dried in a nitrogen-filled glovebox to remove moisture, and then mounted on a substrate holder and placed in a vacuum chamber. Organic layers were sequentially deposited through vacuum thermal evaporation on the ITO anode at a rate of 0.01-10 Å/s and at a vacuum degree of about $10^{-6}$ Torr. HT-7 and Compound 1-2 were co-deposited for use as a hole injection layer (HIL) with a thickness of 100 Å, where Compound 1-2 accounted for 20% of the total weight of the HIL. Compound HT-7 was deposited for use as a hole transporting layer (HTL) with a thickness of 250 Å. Compound EB1 was deposited for use as an electron blocking layer (EBL) with a thickness of 50 Å. A red light-emitting dopant, Compound D-1, was doped into a host compound RH to form a red emissive layer (EML) with a thickness of 400 Å, where the doping proportion of Compound D-1 was 2wt%. Compound HB1 was deposited for use as a hole blocking layer (HBL) with a thickness of 50 Å. On the HBL, Compound ET and LiQ were co-deposited for use as an electron transporting layer (ETL) with a thickness of 350 Å, where LiQ accounted for 60% of the total weight of the ETL. On the ETL, LiQ was deposited for use as an electron injection layer (EIL) with a thickness of 10 Å. Finally, Al was deposited for use as a cathode with a thickness of 1200 Å. After deposition, the device was transferred back to the glovebox and encapsulated with a glass lid to complete the device.

Example 1-2

The implementation of Example 1-2 is the same as that of Example 1-1 except that in the HIL, the doping proportion of Compound 1-2 was adjusted to 25%.

Example 1-3

The implementation of Example 1-3 is the same as that of Example 1-1 except that in the HIL, Compound 1-2 was replaced with Compound 3-2 and the doping proportion of Compound 3-2 was adjusted to 3%.

Example 1-4

The implementation of Example 1-4 is the same as that of Example 1-3 except that in the HIL, the doping proportion of Compound 3-2 was adjusted to 5%.

Example 1-5

The implementation of Example 1-5 is the same as that of Example 1-1 except that in the HIL and the HTL, Compound HT-7 was replaced with Compound HT-12.

Comparative Example 1-1

The implementation of Comparative Example 1-1 is the same as that of Example 1-1 except that in the HIL, the doping proportion of Compound 1-2 was adjusted to 3%.

Comparative Example 1-2

The implementation of Comparative Example 1-2 is the same as that of Example 1-1 except that in the HIL, Compound 1-2 was replaced with Compound PD-1 and the doping proportion of Compound PD-1 was adjusted to 2%.

Comparative Example 1-3

The implementation of Comparative Example 1-3 is the same as that of Example 1-3 except that in the HIL, the doping proportion of Compound 3-2 was adjusted to 2%.

Comparative Example 1-4

The implementation of Comparative Example 1-4 is the same as that of Example 1-1 except that in the HIL and the HTL, Compound HT-7 was replaced with Compound HTM-A.

Comparative Example 1-5

The implementation of Comparative Example 1-5 is the same as that of Example 1-1 except that in the HIL and the HTL, Compound HT-7 was replaced with Compound HTM-B.

Part of the device structures of Examples 1-1 to 1-5 and Comparative Examples 1-1 to 1-5 are shown in the following table, where the HIL is obtained by doping two compounds at a weight ratio as recorded.

Table 1 Part of the device structures of Examples 1-1 to 1-5 and Comparative Examples 1-1 to 1-5

| Device No. | HIL | HTL |
|---|---|---|
| Example 1-1 | HT-7:Compound 1-2 (80:20) (100 Å) | HT-7 (250 Å) |
| Example 1-2 | HT-7:Compound 1-2 (75:25) (100 A) | HT-7 (250 A) |
| Example 1-3 | HT-7:Compound 3-2 (97:3) (100 Å) | HT-7 (250 Å) |
| Example 1-4 | HT-7:Compound 3-2 (95:5) (100 A) | HT-7 (250 A) |
| Example 1-5 | HT-12:Compound 1-2(80:20) (100 Å) | HT-12 (250 Å) |
| Comparative Example 1-1 | HT-7:Compound 1-2 (97:3) (100 Å) | HT-7 (250 Å) |
| Comparative Example 1-2 | HT-7:Compound PD-1 (98:2) (100 Å) | HT-7 (250 Å) |
| Comparative Example 1-3 | HT-7:Compound 3-2 (98:2) (100 Å) | HT-7 (250 Å) |
| Comparative Example 1-4 | HTM-A:Compound 1-2 (80:20) (100 Å) | HTM-A (250 Å) |
| Comparative Example 1-5 | HTM-B:Compound 1-2 (80:20) (100 Å) | HTM-B (250 Å) |

The structures of the compounds used in the devices are shown as follows:

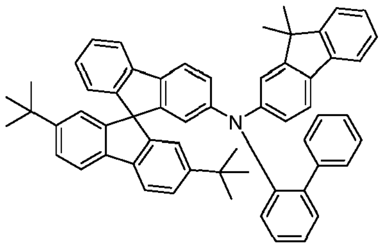

HT-7 ,

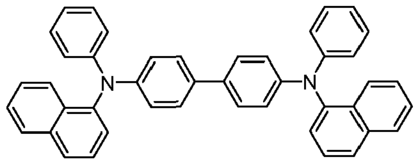

HT-12 ,

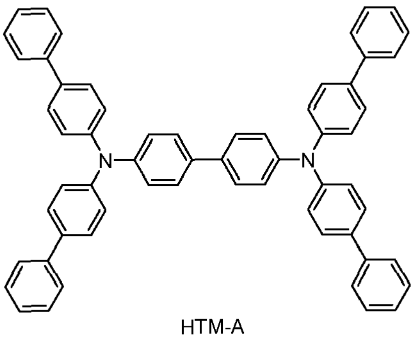

HTM-A ,

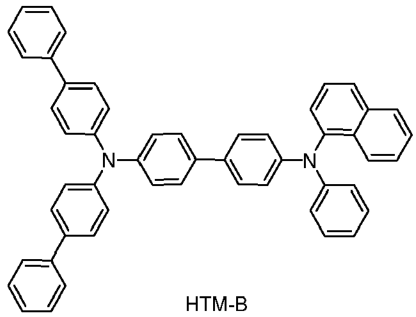

HTM-B ,

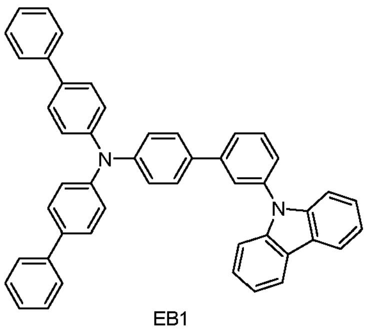

EB1 ,

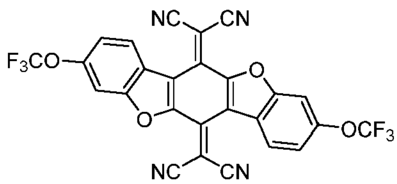

1-2 ,

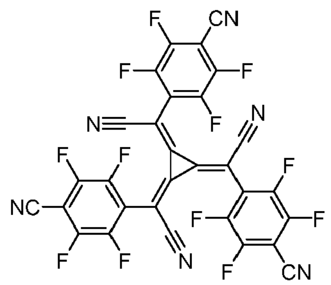

PD-1 ,

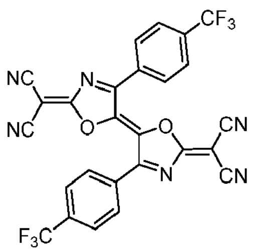

3-2 ,

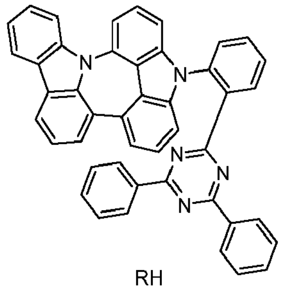

RH ,

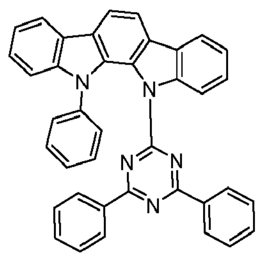

HB1 ,

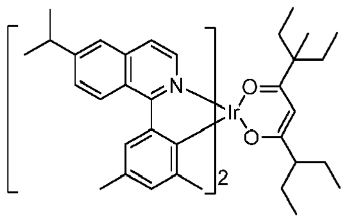

D-1 ,

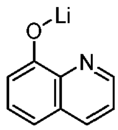
LiQ ,

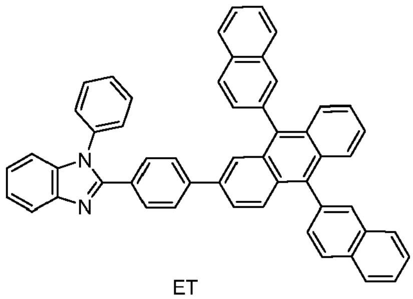
ET .

The device performance of Examples 1-1 to 1-5 and Comparative Examples 1-1 to 1-5 was measured. Color coordinates (CIE), voltages and EQE were measured at a current density of 15 $mA/cm^2$; $\eta$ of the device was calculated according to EQE and voltage with $\xi$ being 1; and the lifetime (LT95) of the device was the time measured for the brightness to decay to 95% of initial brightness at a constant current density of 80 $mA/cm^2$. The data is shown in Table 2.

Table 2 Device data

| Device No. | 15 $mA/cm^2$ | | | | 80 $mA/cm^2$ |
|---|---|---|---|---|---|
| | CIE (x,y) | Voltage (V) | EQE (%) | $\eta$ | LT95 (h) |
| Example 1-1 | (0.685, 0.315) | 3.8 | 31 | 8.16 | 176 |
| Example 1-2 | (0.685, 0.315) | 3.5 | 27 | 7.71 | 184 |
| Example 1-3 | (0.685, 0.315) | 3.8 | 30 | 7.89 | 149 |
| Example 1-4 | (0.685, 0.315) | 3.5 | 27 | 7.71 | 172 |
| Example 1-5 | (0.685, 0.315) | 3.9 | 29 | 7.44 | 153 |
| Comparative Example 1-1 | (0.685, 0.315) | 5.7 | 33 | 5.79 | 62 |
| Comparative Example 1-2 | (0.685, 0.315) | 3.5 | 25 | 7.14 | 164 |
| Comparative Example 1-3 | (0.685, 0.315) | 5.0 | 30 | 6.00 | 80 |
| Comparative Example 1-4 | (0.685, 0.315) | 5.4 | 30 | 5.56 | 28 |
| Comparative Example 1-5 | (0.685, 0.315) | 5.1 | 29 | 5.69 | 61 |

As can be seen from the color coordinates, the color coordinates of the examples shown are consistent with those of the comparative examples.

An OLED with high EQE and a low voltage is an expected good device. If a device has high EQE and a high voltage, the device is unexpected. For example, in Table 2, Comparative Example 1-1 has EQE as high as 33% and a voltage as high as 5.7 V, while the EQE of Example 1-1 is 31% which is slightly lower than that of Comparative Example 1-1 by 6% but still at a very high level and the voltage of Example 1-1 is only 3.8 V which is significantly lower than that of Comparative Example 1-1 by 33%. Therefore, it can be seen that Example 1-1 is an OLED device with excellent overall performance, while Comparative Example 1-1 is not an OLED pursued in the industry.

According to the above analysis, an efficiency-to-voltage ratio ($\eta$) is introduced in the present disclosure for reflecting the overall performance of the device, where $\eta$ = EQE/(voltage $\times$ $\xi$), and $\xi$ denotes a proportion of excitons allowed to be emitted in quantum mechanics. Theoretically, the proportion of excitons allowed to be emitted in both a phosphorescent light-emitting device and a thermally activated delayed fluorescence (TADF) device is 100%, that is, $\xi$ is 1; while the proportion of excitons allowed to be emitted in a fluorescent light-emitting device is 25%, that is, $\xi$ is 0.25. A larger $\eta$ means that the device has a lower voltage and higher EQE and the overall performance is excellent. Therefore, in the present disclosure, $\eta$ greater than 7.19 means that the device is an OLED device with excellent overall performance. Using Example 1-1 as an example, EQE = 31%, V = 3.8 V, and Example 1-1 is a phosphorescent light-emitting device so that $\xi$ is 1, $\eta$ = 31/(3.8 $\times$ 1) = 8.16, and Example 1-1 is a device with excellent overall performance.

As described above, Examples 1-1 to 1-5 and Comparative Examples 1-1 to 1-5 are all phosphorescent light-emitting devices and $\xi$ is 1 for them all.

The same materials are used in the HIL of Example 1-1 and the HIL of Comparative Example 1-1. However, in the HIL of Comparative Example 1-1, the doping proportion of Compound 1-2 is 3%, and the conductivity of the HIL

is only $2.4\times10^{-5}$ S/m, which is too low so that the HIL has a relatively weak hole injection ability and a sharply increased voltage. Although the EQE of Comparative Example 1-1 is as high as 33%, $\eta$ of the device is only 5.79, and the device can only exhibit poor overall device performance. Moreover, the relatively weak hole injection ability of the HIL also makes the device instable. On the contrary, in the HIL of Example 1-1, the doping proportion of Compound 1-2 as the first organic material is 20%, and the conductivity of the HIL is $89\times10^{-5}$ S/m and greater than $3\times10^{-5}$ S/m so that a red light device with excellent overall performance can be obtained using this HIL; at 15 mA/cm$^2$, the voltage is only 3.8 V, the EQE reaches 31%, and $\eta$ reaches 8.16; at 80 mA/cm$^2$, the lifetime (LT95) of the device is 176 h, which is nearly three times longer than that of the device in Comparative Example 1-1. In the present disclosure, it can be seen that the overall performance of the device can be improved by controlling the conductivity of the first organic layer to be greater than or equal to $3\times10^{-5}$ S/m.

In the HIL of Example 1-2, the doping proportion of Compound 1-2 is increased to 25%, and the conductivity of the HIL is increased to $92\times10^{-5}$ S/m so that the voltage of the device is further reduced to 3.5 V and the lifetime of the device is increased to 184 h; although the EQE is slightly reduced to 27%, the EQE is still at a very high level. More importantly, $\eta$ of the device is 7.71, which shows that the device has more excellent overall performance than devices widely used at present, such as Comparative Example 1-2 ($\eta$ is 7.14). In addition, in the HIL of Comparative Example 1-2, the difference between the LUMO energy level of Compound PD-1 and the HOMO energy level of Compound HT-7 is only 0.09 eV and much smaller than 0.30 eV so that when the doping proportion of Compound PD-1 is 2%, the conductivity of the HIL reaches $110\times10^{-5}$ S/m. Although the HIL has a good hole injection ability and achieves a high level of device performance, the difference between the LUMO energy level of Compound PD-1 and the HOMO energy level of Compound HT-7 in the HIL is only 0.09 eV and much smaller than 0.30 eV, which is not conducive to controlling the balance of charge carriers in the device. On the contrary, the device performance of Example 1-2 is further improved based on the high level of Comparative Example 1-2 through the reasonable selection of HIL materials: the efficiency is increased by 8%, the lifetime is extended by 12%, and the voltage remains consistent, which is very rare.

As can be seen from the above comparison, in the present disclosure, the second organic material whose HOMO energy level is less than or equal to -5.1 eV and the first organic material whose LUMO energy level is at least 0.3 eV higher than $HOMO_{second_organic_material}$ are selected for the first organic layer, and the doping proportion of the first organic material is controlled to effectively control the conductivity of the HIL so that the red light devices with excellent overall performance, as shown in Examples 1-1 and 1-2, can be obtained.

In the HIL of Example 1-3, the first organic material is Compound 3-2, and the difference between the LUMO energy level of Compound 3-2 and the HOMO energy level of the second organic material HT-7 is 0.33 eV and greater than 0.3 eV. In the HIL of Comparative Example 1-3, the doping proportion of Compound 3-2 is 2%, and the conductivity of the HIL is $2.6\times10^{-5}$ S/m and smaller than $3\times10^{-5}$ S/m. Due to a relatively low conductivity, it is difficult for holes to be injected from the anode to the HIL, resulting in a relatively high device voltage. $\eta$ of the device is only 6.0 and its lifetime is relatively short. However, in Example 1-3, the doping proportion of Compound 3-2 is increased to 3%, and the conductivity of the HIL is $7.9\times10^{-5}$ S/m and greater than $3\times10^{-5}$ S/m. Compared with Comparative Example 1-3, Example 1-3 has a voltage greatly reduced by 24% to 3.8 V, EQE maintained at a very high level of 30%, and a lifetime extended by 86% so that the red light device with excellent overall performance is obtained.

In Example 1-4, the doping proportion of Compound 3-2 is increased to 5%, and the conductivity of the HIL is increased to $39\times10^{-5}$ S/m so that the device has a voltage further reduced to 3.5 V and a lifetime extended to 172 h. Although the EQE is slightly reduced to 27%, the EQE is still at a very high level. More importantly, $\eta$ is still 7.71. The overall performance of the device is more excellent than the overall performance of the device widely used at present, such as Comparative Example 1-2 ($\eta$ = 7.14). Compared with Comparative Example 1-2, Example 1-4 has efficiency increased by 8%, a lifetime increased by 5%, and a voltage remaining consistent.

To sum up, the comparison of Examples 1-1 to 1-4 with Comparative Examples 1-1 to 1-3 proves that when $HOMO_{second_organic_material} \leq -5.1$ eV and $LUMO_{first_organic_material} - HOMO_{second_organic_material} \geq 0.3$ eV, the conductivity of the first organic layer, the HIL, is controlled by controlling the doping proportion of the first organic material, and when the conductivity of the first organic layer is $\geq 3\times10^{-5}$ S/m, the red light device with excellent overall performance can be obtained.

In addition, the second organic materials used in Example 1-1 and Example 1-5 are HT-7 and HT-12, respectively, and the HOMO energy levels of HT-7 and HT-12 are -5.13 eV and - 5.11 eV, respectively and both smaller than -5.1 eV; $LUMO_{Compound_1-2} - HOMO_{HT-7}$ and $LUMO_{Compound_1-2} - HOMO_{HT-12}$ are both greater than 0.3 eV, and the conductivity of the first organic layer, the HIL, is $8.9\times10^{-4}$ S/m and $2.4\times10^{-4}$ S/m, respectively, both of which are greater than $3\times10^{-5}$ S/m. Therefore, the devices using the above HILs have excellent overall performance; at 15 mA/cm$^2$, their voltages are 3.8 V and 3.9 V respectively, their EQE is 31% and 29% respectively, and their $\eta$ is 8.16 and 7.44, respectively, showing excellent overall performance; at 80 mA/cm$^2$, their LT95 is 176 h and 153 h, respectively, showing an ultra-long device lifetime. The second organic materials used in Comparative Example 1-4 and Comparative Example 1-5 are HTM-A and HTM-B, respectively, and the HOMO energy levels of HTM-A and HTM-B are both -5.09 eV and greater than -5.1 eV. Therefore, even if the energy level differences, $LUMOc_{ompound_1-2} - HOMO_{HTM-A}$ and

$LUMO_{Compound_1-2}$ - $HOMO_{HTM-B}$, are both greater than 0.3 eV and the conductivity is greater than $3\times10^{-5}$ S/m, the overall performance of the devices using the above HILs is not satisfactory: $\eta$ is only 5.56 and 5.69, respectively. Although the EQE is similar to that of Example 1-1, the voltages are relatively high and 5.4 V and 5.1 V, respectively, and the lifetimes are only 28 h and 61 h, respectively.

Examples 2-1 to 2-3 and Comparative Examples 2-1 to 2-3 are green phosphorescent light-emitting devices.

Example 2-1

The implementation of Example 2-1 is described below. A glass substrate having an indium tin oxide (ITO) anode (with a thickness of 800 Å) was cleaned, treated with UV ozone and oxygen plasma, dried in a nitrogen-filled glovebox to remove moisture, and then mounted on a substrate holder and placed in a vacuum chamber. Organic layers were sequentially deposited through vacuum thermal evaporation on the ITO anode at a rate of 0.01-10 Å/s and at a vacuum degree of about $10^{-6}$ Torr. A hole injection layer (HIL) containing HT-7 and Compound 1-2 was deposited, where Compound 1-2 accounted for 20% of the total weight of the HIL with a thickness of 100 Å. Compound HT-7 was deposited for use as a hole transporting layer (HTL) with a thickness of 350 Å. Compound EB2 was used as an electron blocking layer (EBL) with a thickness of 50 Å. Compounds EB2 and GH and a green light-emitting dopant D-2 were co-deposited for use as an emissive layer (EML) with a thickness of 400 Å, where EB2, GH and D-2 accounted for 48%, 48% and 4% of the total weight of the EML, respectively. Compound HB1 was deposited for use as a hole blocking layer (HBL) with a thickness of 50 Å. On the HBL, Compound ET and LiQ were co-deposited for use as an electron transporting layer (ETL) with a thickness of 350 Å, where LiQ accounted for 60% of the total weight of the ETL. On the ETL, LiQ was deposited for use as an electron injection layer (EIL) with a thickness of 10 Å. Finally, Al was deposited for use as a cathode with a thickness of 1200 Å. After evaporation, the device was transferred back to the glovebox and encapsulated with a glass lid to complete the device.

Example 2-2

The implementation of Example 2-2 is the same as that of Example 2-1 except that in the HIL, the doping proportion of Compound 1-2 was adjusted to 25%.

Example 2-3

The implementation of Example 2-3 is the same as that of Example 2-1 except that in the HIL, Compound 1-2 was replaced with Compound 3-2 and the doping proportion of Compound 3-2 was adjusted to 5%.

Comparative Example 2-1

The implementation of Comparative Example 2-1 is the same as that of Example 2-1 except that in the HIL, the doping proportion of Compound 1-2 was adjusted to 3%.

Comparative Example 2-2

The implementation of Comparative Example 2-2 is the same as that of Example 2-1 except that in the HIL, Compound 1-2 was replaced with Compound PD-1 and the doping proportion of Compound PD-1 was adjusted to 2%.

Comparative Example 2-3

The implementation of Comparative Example 2-3 is the same as that of Example 2-3 except that in the HIL, the doping proportion of Compound 3-2 was adjusted to 2%.

Part of the device structures of Examples 2-1 to 2-3 and Comparative Examples 2-1 to 2-3 are shown in the following table, where the HIL is obtained by doping two compounds at a weight ratio as recorded.

Table 3 Part of the device structures of Examples 2-1 to 2-3 and Comparative Examples 2-1 to 2-3

| No. | HIL | HTL |
|---|---|---|
| Example 2-1 | HT-7:Compound 1-2 (80:20) (100 Å) | HT-7 (350 Å) |
| Example 2-2 | HT-7:Compound 1-2(75:25) (100 Å) | HT-7 (350 Å) |
| Example 2-3 | HT-7:Compound 3-2(95:5) (100 Å) | HT-7 (350 Å) |

(continued)

| No. | HIL | HTL |
|---|---|---|
| Comparative Example 2-1 | HT-7:Compound 1-2(97:3) (100 Å) | HT-7 (350 Å) |
| Comparative Example 2-2 | HT-7:Compound PD-1(98:2) (100 Å) | HT-7 (350 Å) |
| Comparative Example 2-3 | HT-7:Compound 3-2(98:2) (100 Å) | HT-7 (350 Å) |

The structures of the new compounds used in the devices are shown as follows:

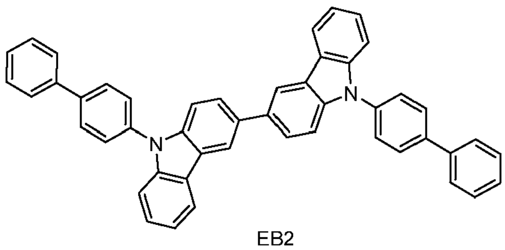
EB2
,

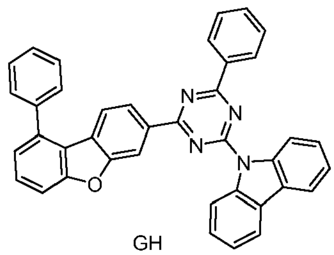
GH
,

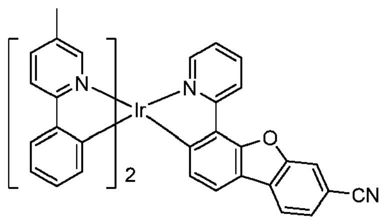
D-2
.

The device performance of Examples 2-1 to 2-3 and Comparative Examples 2-1 to 2-3 was measured. Color coordinates (CIE), voltages and EQE were measured at a current density of 15 mA/cm$^2$; η of the device was calculated according to EQE and voltage with ξ being 1; and the lifetime (LT95) of the device was the time measured for the brightness to decay to 95% of initial brightness at a constant current density of 80 mA/cm$^2$. The data is shown in Table 4.

Table 4 Device data

| Device No. | 15 mA/cm$^2$ | | | | 80 mA/cm$^2$ |
|---|---|---|---|---|---|
| | CIE (x,y) | Voltage (V) | EQE (%) | η | LT95 (h) |
| Example 2-1 | (0.344, 0.632) | 3.7 | 27 | 7.30 | 74 |
| Example 2-2 | (0.344, 0.632) | 3.5 | 26 | 7.43 | 86 |
| Example 2-3 | (0.344, 0.632) | 3.4 | 25 | 7.35 | 95 |
| Comparative Example 2-1 | (0.344, 0.632) | 4.9 | 28 | 5.71 | 25 |
| Comparative Example 2-2 | (0.344, 0.632) | 3.5 | 24 | 6.86 | 71 |
| Comparative Example 2-3 | (0.344, 0.632) | 5.0 | 28 | 5.60 | 29 |

As can be seen from the color coordinates, the color coordinates of the examples shown are consistent with those of the comparative examples.

Examples 2-1 to 2-3 and Comparative Examples 2-1 to 2-3 are all phosphorescent light-emitting devices and ξ is 1 for them all.

The same materials are used in the HIL of Example 2-1 and the HIL of Comparative Example 2-1. However, in the HIL of Comparative Example 2-1, the doping proportion of Compound 1-2 is 3%, and the conductivity of the HIL is only $2.4\times10^{-5}$ S/m, which is too low so that the HIL has a relatively weak hole injection ability and makes the voltage of its device sharply increased. Although the EQE of Comparative Example 2-1 is as high as 28%, η of the device is

only 5.71, and the device can only exhibit poor overall device performance. Moreover, the relatively weak hole injection ability of the HIL also makes the device instable. On the contrary, in the HIL of Example 2-1, the doping proportion of Compound 1-2 as the first organic material is 20%, and the conductivity of the HIL is $89\times10^{-5}$ S/m and greater than $3\times10^{-5}$ S/m so that a green light device with excellent overall performance can be obtained using this HIL; at 15 mA/cm$^2$, the voltage is only 3.7 V, the EQE reaches 27%, and $\eta$ reaches 7.30; at 80 mA/cm$^2$, the lifetime (LT95) of the device is 74 h, which is nearly three times longer than that of the device in Comparative Example 2-1. In the present disclosure, it can be seen that the overall performance of the device can be improved by controlling the conductivity of the first organic layer to be greater than or equal to $3\times10^{-5}$ S/m.

In Example 2-2, the doping proportion of Compound 1-2 is increased to 25%, and the conductivity of the HIL is slightly increased to $92\times10^{-5}$ S/m compared with that when the doping proportion of Compound 1-2 in Example 2-1 is 20% so that the voltage of the device is further reduced to 3.5 V and the lifetime of the device is increased to 86 h; although the EQE is slightly reduced to 26%, $\eta$ of the device is 7.43 so that the device has more excellent overall performance than devices widely used at present, such as Comparative Example 2-2 ($\eta$ = 6.86). In Comparative Example 2-2, the first organic material is Compound PD-1, and the difference between the LUMO energy level of Compound PD-1 and the HOMO energy level of Compound HT-7 is only 0.09 eV and smaller than 0.30 eV; when the doping proportion is 2%, the conductivity reaches $110\times10^{-5}$ S/m. Although the HIL has a good hole injection ability and achieves a high level of device performance, the difference between the LUMO energy level of Compound PD-1 and the HOMO energy level of Compound HT-7 in the HIL is only 0.09 eV and smaller than 0.30 eV, which is not conducive to controlling the balance of charge carriers in the device. On the contrary, the device performance of Example 2-2 is further improved based on the high level of Comparative Example 2-2 through the reasonable selection of HIL materials: the efficiency is increased by 8%, the lifetime is extended by 21%, and the voltage remains consistent, which is very rare.

As can be seen from the above comparison, in the present disclosure, the second organic material whose HOMO energy level is less than or equal to -5.1 eV and the first organic material whose LUMO energy level is at least 0.3 eV higher than $HOMO_{second_organic_material}$ are selected for the first organic layer, and the doping proportion of the first organic material is controlled to effectively control the conductivity of the HIL so that the green light devices with excellent overall performance are obtained.

In Example 2-3, the first organic material is Compound 3-2, the difference between the LUMO energy level of Compound 3-2 and the HOMO energy level of Compound HT-7 is 0.33 eV and greater than 0.3 eV, the doping proportion of Compound 3-2 is 5%, and the conductivity of the HIL is $39\times10^{-5}$ S/m and greater than $3\times10^{-5}$ S/m. The green light device with excellent overall performance is obtained using the above HIL: at 15 mA/cm$^2$, the voltage is only 3.4 V, the EQE is 25%, and $\eta$ is 7.35; at 80 mA/cm$^2$, the lifetime (LT95) of the device reaches 95 h. In contrast, due to a relatively low conductivity in Comparative Example 2-3, it is difficult for holes to be injected from the anode to the HIL, resulting in a relatively high device voltage which is 47% higher than the voltage of Example 2-3; although a decrease of the conductivity of the HIL brings about a small improvement in EQE, $\eta$ is only 5.6. In addition, the difficulty of hole injection causes the instability of the device so that the lifetime of Example 2-3 is 228% longer than that of Comparative Example 2-3. Through the comparison of Example 2-3 with Comparative Example 2-2, it is found that although the conductivity of Comparative Example 2-2 is greater than $3\times10^{-5}$ S/m, since the difference between the LUMO energy level of Compound PD-1 and the HOMO energy level of HT-7 is 0.09 eV and smaller than 0.3 eV, both Example 2-3 and Comparative Example 2-2 ensure hole injection and the voltages thereof are 3.4 V and 3.5 V respectively and basically the same, but Example 2-3 can better balance charge carriers and thus has 7% higher device efficiency and a 34% longer lifetime than Comparative Example 2-2.

To sum up, the comparison of Examples 2-1 to 2-3 with Comparative Examples 2-1 to 2-3 proves that when $HOMO_{second_organic_material} \leq -5.1$ eV and $LUMO_{first_organic_material} - HOMO_{second_organic_material} \geq 0.3$ eV, the conductivity of the first organic layer, the HIL, is controlled by controlling the doping proportion of the first organic material, and when the conductivity of the first organic layer is greater than or equal to $3\times10^{-5}$ S/m, the green light device with excellent overall performance can be obtained.

Examples 3-1 to 3-3 and Comparative Examples 3-1 to 3-3 are blue fluorescent light-emitting devices.

Example 3-1

The implementation of Example 3-1 is described below. A glass substrate having an indium tin oxide (ITO) anode (with a thickness of 800 Å) was cleaned, treated with UV ozone and oxygen plasma, dried in a nitrogen-filled glovebox to remove moisture, and then mounted on a substrate holder and placed in a vacuum chamber. Organic layers were sequentially deposited through vacuum thermal evaporation on the ITO anode at a rate of 0.01-10 Å/s and at a vacuum degree of about $10^{-6}$ Torr. A hole injection layer (HIL) containing HT-7 and Compound 1-2 was deposited, where Compound 1-2 accounted for 20% of the total weight of the HIL with a thickness of 100 Å. Compound HT-7 was deposited for use as a hole transporting layer (HTL) with a thickness of 250 Å. Compound HT-15 was used as an electron blocking layer (EBL) with a thickness of 50 Å. A blue light host compound BH was doped with a blue light dopant, Compound D-3, at a doping proportion of 4 wt% and they were co-deposited for use as a blue emissive layer (EML) with a total thickness of 250 Å. Compound HB2 was deposited for use as a hole blocking layer (HBL) with a thickness of 50 Å. On the HBL, Compound ET and LiQ were co-deposited for use as an electron transporting layer (ETL) with a thickness of 300 Å, where LiQ accounted for 60% of the total weight of the ETL. On the ETL, LiQ was deposited for use as an electron injection layer (EIL) with a thickness of 10 Å. Finally, Al was deposited for use as a cathode with a thickness of 1200 Å. After evaporation, the device was transferred back to the glovebox and encapsulated with a glass lid to complete the device.

Example 3-2

The implementation of Example 3-2 is the same as that of Example 3-1 except that in the HIL, the doping proportion of Compound 1-2 was adjusted to 30%.

Example 3-3

The implementation of Example 3-3 is the same as that of Example 3-1 except that in the HIL, Compound 1-2 was replaced with Compound 3-2 and the doping proportion of Compound 3-2 was adjusted to 10%.

Comparative Example 3-1

The implementation of Comparative Example 3-1 is the same as that of Example 3-1 except that in the HIL, the doping proportion of Compound 1-2 was adjusted to 3%.

Comparative Example 3-2

The implementation of Comparative Example 3-2 is the same as that of Example 3-1 except that in the HIL, Compound 1-2 was replaced with Compound PD-1 and the doping proportion of Compound PD-1 was adjusted to 2%.

Comparative Example 3-3

The implementation of Comparative Example 3-3 is the same as that of Example 3-3 except that in the HIL, the doping proportion of Compound 3-2 was adjusted to 2%.

Part of the device structures of Examples 3-1 to 3-3 and Comparative Examples 3-1 to 3-3 are shown in the following table, where the HIL is obtained by doping two compounds at a weight ratio as recorded.

Table 5 Part of the device structures of Examples 3-1 to 3-3 and Comparative Examples 3-1 to 3-3

| Device No. | HIL | HTL |
|---|---|---|
| Example 3-1 | HT-7:Compound 1-2 (80:20) (100 Å) | HT-7 (250 Å) |
| Example 3-2 | HT-7:Compound 1-2 (70:30) (100 Å) | HT-7 (250 Å) |
| Example 3-3 | HT-7:Compound 3-2 (90:10) (100 Å) | HT-7 (250 Å) |
| Comparative Example 3-1 | HT-7:Compound 1-2 (97:3) (100 Å) | HT-7 (250 Å) |
| Comparative Example 3-2 | HT-7:Compound PD-1 (98:2) (100 Å) | HT-7 (250 Å) |
| Comparative Example 3-3 | HT-7:Compound 3-2 (98:2) (100 Å) | HT-7 (250 Å) |

The structures of the new compounds used in the devices are shown as follows:

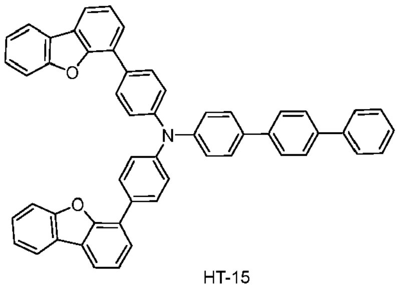

HT-15 ,

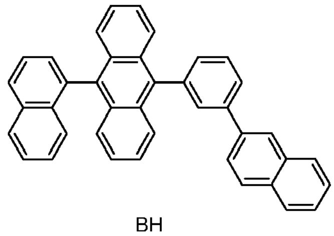

BH ,

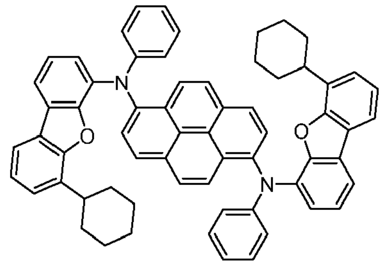

D-3 ,

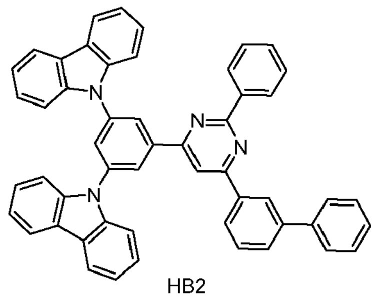

HB2 .

The device performance of Examples 3-1 to 3-3 and Comparative Examples 3-1 to 3-3 was measured. Color coordinates (CIE), voltages and EQE were measured at a current density of 15 mA/cm$^2$; $\eta$ of the device was calculated according to EQE and voltage with $\xi$ being 0.25; and the lifetime (LT95) of the device was the time measured for the brightness to decay to 95% of initial brightness at a constant current density of 80 mA/cm$^2$. The data is shown in Table 6.

Table 6 Device Data

| Device No. | 15mA/cm$^2$ | | | | 80 mA/cm$^2$ |
|---|---|---|---|---|---|
| | CIE (x,y) | Voltage (V) | EQE (%) | $\eta$ | LT95 (h) |
| Example 3-1 | (0.14, 0.10) | 4.4 | 9.0 | 8.18 | 79 |
| Example 3-2 | (0.14, 0.10) | 4.2 | 8.3 | 7.90 | 170 |
| Example 3-3 | (0.14, 0.10) | 4.2 | 8.0 | 7.62 | 149 |
| Comparative Example 3-1 | (0.14, 0.10) | 6.2 | 9.7 | 6.26 | 4 |
| Comparative Example 3-2 | (0.14, 0.10) | 4.4 | 7.9 | 7.18 | 71 |
| Comparative Example 3-3 | (0.14, 0.10) | 6.0 | 9.4 | 6.27 | 6 |

As can be seen from the color coordinates, the color coordinates of the examples shown are consistent with those of the comparative examples.

Examples 3-1 to 3-3 and Comparative Examples 3-1 to 3-3 are all fluorescent light-emitting devices and $\xi$ is 0.25 for them all.

The same materials are used in the HIL of Example 3-1 and the HIL of Comparative Example 3-1. However, in the HIL of Comparative Example 3-1, the doping proportion of Compound 1-2 is 3%, and the conductivity of the HIL is only $2.4\times10^{-5}$ S/m, which is too low so that the HIL has a relatively weak hole injection ability and a sharply increased voltage. Although the EQE of Comparative Example 3-1 is as high as 9.7%, $\eta$ of the device is only 6.26, and the device can only exhibit poor overall device performance. Moreover, the relatively weak hole injection ability of the HIL also makes the device instable. On the contrary, in the HIL of Example 3-1, the doping proportion of Compound 1-2 as the first organic material is 20%, and the conductivity of the HIL is $89\times10^{-5}$ S/m and greater than $3\times10^{-5}$ S/m so that a blue light device with excellent overall performance can be obtained using this HIL; at 15 mA/cm$^2$, the voltage is only 4.4 V, the EQE reaches 9.0%, and $\eta$ reaches 8.18; at 80 mA/cm$^2$, the lifetime (LT95) of the device is 79 h, which is nearly twenty times longer than that of the device in Comparative Example 3-1. In the present disclosure, it can be seen that the overall performance of the device can be improved by controlling the conductivity of the first organic layer to be greater than or equal to $3\times10^{-5}$ S/m.

In the HIL of Example 3-2, the doping proportion of Compound 1-2 is increased to 30%, and the conductivity of the HIL is slightly increased to $92\times10^{-5}$ S/m compared with that when the doping proportion of Compound 1-2 is 20% so that the voltage of the device is further reduced to 4.2 V and the lifetime of the device is increased to 170 h; although the EQE is slightly reduced to 8.3%, $\eta$ still reaches 7.90 so that the device has more excellent overall performance than devices widely used at present, such as Comparative Example 3-2 ($\eta$ is 7.18). In Comparative Example 3-2, the used doping material is Compound PD-1, and the difference between the LUMO energy level of Compound PD-1 and the HOMO energy level of HT-7 is only 0.09 eV; when the doping proportion is 2%, the conductivity reaches $1.1\times10^{-3}$ S/m. Although the HIL has a good hole injection ability and achieves a high level of device performance, the difference between the LUMO energy level of Compound PD-1 and the HOMO energy level of Compound HT-7 in the HIL is only 0.09 eV, which is not conducive to controlling the balance of charge carriers in the device. On the contrary, the device performance of Example 3-2 is further improved based on the high level of Comparative Example 3-2 through the reasonable selection of HIL materials: the efficiency is increased by 5%, the lifetime is extended by 139%, and the voltage remains consistent. To sum up, when $HOMO_{second_organic_material} \leq -5.1$ eV and $LUMO_{first_organic_material} - HOMO_{second_organic_material} \geq 0.3$ eV, the conductivity of the first organic layer, the HIL, is controlled by controlling the doping proportion of the first organic material and the blue light device with excellent overall performance can be obtained.

In the HIL of Example 3-3, the doping material is Compound 3-2, and the difference between the LUMO energy level of Compound 3-2 and the HOMO energy level of HT-7 is 0.33 eV and greater than 0.3 eV so that the conductivity of the HIL can be conveniently controlled by adjusting the doping proportion of Compound 3-2: when the doping proportion of Compound 3-2 is 10%, the conductivity of the HIL is $1.4\times10^{-3}$ S/m and greater than $3\times10^{-5}$ S/m so that the blue light device with excellent overall performance is obtained using the above HIL: at 15 $mA/cm^2$, the voltage is only 4.2 V, the EQE is 8.0%, and $\eta$ is 7.62; at 80 $mA/cm^2$, the lifetime (LT95) of the device reaches 149 h. In contrast, in Comparative Example 3-3, the doping proportion of Compound 3-2 is 2% and the conductivity is only $2.6\times10^{-5}$ S/m. Due to a relatively low conductivity, it is difficult for holes to be injected from the anode to the HIL, resulting in a relatively high device voltage which is 43% higher than the voltage of Example 3-3; although a decrease of the conductivity of the HIL brings about a small improvement in EQE, $\eta$ is only 6.27. The difficulty of hole injection also causes the instability of the device so that the lifetime of Example 3-3 is 23.8 times longer than that of Comparative Example 3-3.

Therefore, the comparison of Examples 3-1 to 3-3 with Comparative Examples 3-1 to 3-3 proves that when $HOMO_{second_organic_material} \leq -5.1$ eV and $LUMO_{first_organic_material} - HOMO_{second_organic_material} \geq 0.3$ eV, the conductivity of the first organic layer, the HIL, is controlled by controlling the doping proportion of the first organic material, and when the conductivity of the first organic layer is $\geq 3\times10^{-5}$ S/m, the blue light device with excellent overall performance can be obtained.

Example 4

The implementation of Example 4 is described below. A glass substrate having an indium tin oxide (ITO) anode (with a thickness of 1200 Å) was cleaned, treated with UV ozone and oxygen plasma, dried in a nitrogen-filled glovebox to remove moisture, and then mounted on a substrate holder and placed in a vacuum chamber. Organic layers were sequentially deposited through vacuum thermal evaporation on the ITO anode at a rate of 0.01-10 Å/s and at a vacuum degree of about $10^{-6}$ Torr. HT-7 and Compound 1-2 were co-deposited for use as a hole injection layer (HIL) with a thickness of 100 Å, where Compound 1-2 accounted for 25% of the total weight of the HIL. Compound HT-7 was deposited for use as a hole transporting layer (HTL) with a thickness of 400 Å. Compound EB1 was deposited for use as an electron blocking layer (EBL) with a thickness of 50 Å. A host compound RH was doped with a red light-emitting dopant, Compound D-4, to form a red emissive layer (EML) with a thickness of 400 Å, where the doping proportion of Compound D-1 was 3 wt%. Compound ET and LiQ were co-deposited for use as an electron transporting layer (ETL) with a thickness of 350 Å, where LiQ accounted for 60% of the total weight of the ETL. On the ETL, LiQ was deposited for use as an electron injection layer (EIL) with a thickness of 10 Å. Finally, Al was deposited for use as a cathode with a thickness of 1200 Å. After evaporation, the device was transferred back to the glovebox and encapsulated with a glass lid to complete the device.

Part of the device structure of Example 4 is shown in the following table, where an organic layer using more than one material is obtained by doping different compounds at a weight ratio as recorded.

Table 7 Part of the device structure of Example 4

| Device No. | HIL | HTL | EBL | EML | ETL | EIL |
|---|---|---|---|---|---|---|
| Example 4 | HT-7:Compound 1-2 (75:25) (100 Å) | HT-7 (400 Å) | EB1 (50 Å) | RH:D-4 (97:3) (400 Å) | ET1:LiQ (40:60) (350 Å) | LiQ (10 Å) |

The structures of the new compounds used in the device are shown as follows:

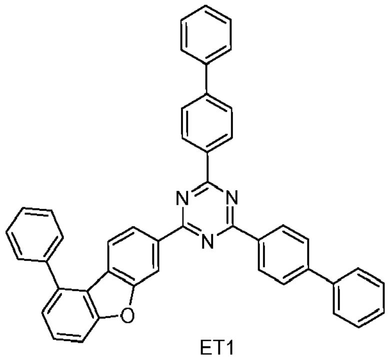
ET1
,
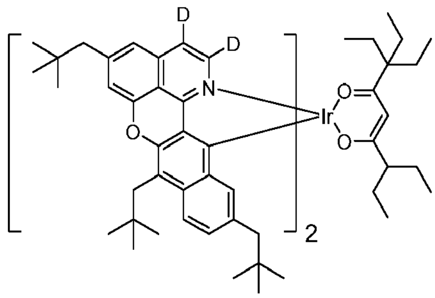
D-4
.

The device performance of Example 4 was measured. Color coordinates (CIE), a voltage and EQE were measured at a current density of 15 mA/cm$^2$; η of the device was calculated according to EQE and voltage with $\xi$ being 1; and the lifetime (LT95) of the device was the time measured for the brightness to decay to 95% of initial brightness at a constant current density of 80 mA/cm$^2$. The data is shown in Table 8.

Table 8 Device data

| Device No. | 15 mA/cm$^2$ | | | | 80 mA/cm$^2$ |
|---|---|---|---|---|---|
| | CIE (x,y) | Voltage (V) | EQE (%) | η | LT95 (h) |
| Example 4 | (0.681, 0.318) | 3.2 | 28.0 | 8.75 | 342 |

In Example 4, ET1 with a relatively deep LUMO energy level and LiQ were co-deposited to form the ETL, the LUMO energy level of ET1 is -2.859 eV and smaller than -2.8 eV, and the ETL is in direct contact with the emissive layer, that is, no additional HBL needs to be used, which is conducive to the preparation of the device. As can be seen from the device data in Table 8, the voltage of Example 4 is only 3.2 V, the EQE reaches 28%, and the lifetime of the device even reaches 342 h. More importantly, η of the device is 8.75 and reaches a very high level, indicating that the device of the present disclosure can achieve very excellent overall performance.

As can be seen from the comparative analysis of the above examples and comparative examples, the first organic material and the second organic material with particular selections are used in the present disclosure as the first organic layer (HIL) and the conductivity of the HIL is controlled by adjusting the concentration of the first organic material so that the conductivity of HIL is $\geq 3\times10^{-5}$ S/m. The organic electroluminescent device including the first organic layer with the above characteristics, which is disclosed in the present disclosure, can exhibit excellent overall performance including a high efficiency-to-voltage ratio (a low voltage and high efficiency) and a long lifetime in devices of different emitting colors and has a great potential to be widely used in commercial devices.

It is to be understood that various embodiments described herein are merely examples and not intended to limit the scope of the present disclosure. Therefore, it is apparent to the persons skilled in the art that the present disclosure as claimed may include variations of specific embodiments and preferred embodiments described herein. Many of materials and structures described herein may be replaced with other materials and structures without departing from the spirit of the present disclosure. It is to be understood that various theories as to why the present disclosure works are not intended to be limitative.

## Claims

**1.** An organic electroluminescent device, comprising:

an anode, a cathode and an organic layer disposed between the anode and the cathode;
wherein the organic layer comprises a first organic layer containing a first organic material and a second organic material;
the lowest unoccupied molecular orbital (LUMO) energy level of the first organic material is denoted as $LUMO_{first_organic_material}$, the highest occupied molecular orbital (HOMO) energy level of the second organic

material is denoted as $HOMO_{second_organic_material}$, $HOMO_{second_organic_material} \leq -5.1$ eV, and $LUMO_{first_organic_material} - HOMO_{second_organic_material} \geq 0.3$ eV; and
the first organic layer has a conductivity greater than or equal to $3 \times 10^{-5}$ S/m.

**2.** An organic electroluminescent device, comprising:

an anode, a cathode and an organic layer disposed between the anode and the cathode;
wherein the organic layer comprises a first organic layer containing a first organic material and a second organic material, wherein the lowest unoccupied molecular orbital (LUMO) energy level of the first organic material is denoted as $LUMO_{first_organic_material}$, the highest occupied molecular orbital (HOMO) energy level of the second organic material is denoted as $HOMO_{second_organic_material}$, and $LUMO_{first_organic_material} - HOMO_{second_organic_material} \geq 0.3$ eV; the first organic layer has a conductivity greater than or equal to $3 \times 10^{-5}$ S/m; and the second organic material has a structure represented by Formula H:

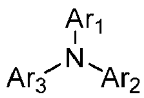

Formula **H** ;

wherein in Formula H,

$Ar_1$, $Ar_2$ and $Ar_3$ are, at each occurrence identically or differently, selected from substituted or unsubstituted aryl having 6 to 30 carbon atoms or substituted or unsubstituted heteroaryl having 3 to 30 carbon atoms;
when $Ar_1$, $Ar_2$ and $Ar_3$ are, at each occurrence identically or differently, selected from substituted aryl having 6 to 30 carbon atoms or substituted heteroaryl having 3 to 30 carbon atoms, the aryl or heteroaryl is substituted with one or more groups selected from the group consisting of: deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl having 6 to 20 carbon atoms, unsubstituted alkylgermanyl having 3 to 20 carbon atoms, unsubstituted arylgermanyl having 6 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents $Ar_1$, $Ar_2$ and $Ar_3$ can be optionally joined to form a ring.

**3.** The organic electroluminescent device according to claim 1 or 2, wherein $LUMO_{first_organic_material} - HOMO_{second_organic_material} \geq 0.33$ eV;

preferably, $LUMO_{first_organic_material} - HOMO_{second_organic_material} \geq 0.4$ eV;
more preferably, $LUMO_{first_organic_material} - HOMO_{second_organic_material} \geq 0.45$ eV.

**4.** The organic electroluminescent device according to claim 1 or 2, wherein $HOMO_{second_organic_material} \leq -5.13$ eV; preferably, $HOMO_{second_organic_material} \leq -5.2$ eV.

**5.** The organic electroluminescent device according to claim 1 or 2, wherein the first organic layer has a conductivity greater than or equal to $5 \times 10^{-5}$ S/m;
preferably, the first organic layer has a conductivity greater than or equal to $7 \times 10^{-5}$ S/m.

**6.** The organic electroluminescent device according to claim 1 or 2, wherein the weight ratio of the first organic material to the first organic layer is 0.1% to 90%;

preferably, the weight ratio of the first organic material to the first organic layer is 1% to 50%;
more preferably, the weight ratio of the first organic material to the first organic layer is 2% to 30%.

**7.** The organic electroluminescent device according to claim 1 or 2, wherein the first organic layer has a thickness of 1-30 nm;
preferably, the first organic layer has a thickness of 5-15 nm.

**8.** The organic electroluminescent device according to claim 1 or 2, wherein the organic electroluminescent device further comprises a second organic layer containing the second organic material;
preferably, the second organic layer has a thickness of 10-200 nm.

**9.** The organic electroluminescent device according to claim 1 or 2, wherein the first organic layer is in direct contact with the anode.

**10.** A first organic electroluminescent device, comprising:

an anode, a cathode and an organic layer disposed between the anode and the cathode;
wherein the organic layer comprises a first organic layer being in direct contact with the anode and containing a first organic material and a second organic material;
the first organic layer has a conductivity greater than or equal to $3\times10^{-5}$ S/m;
an efficiency-to-voltage ratio $\eta$ of the first organic electroluminescent device is greater than or equal to 104% of an efficiency-to-voltage ratio $\eta$ of a second organic electroluminescent device at the same current density;

wherein $\eta$ = EQE/(voltage $\times$ $\xi$ ), and $\xi$ denotes a proportion of excitons allowed to be emitted in quantum mechanics; the second organic electroluminescent device has the same device structure as the first organic electroluminescent device except that: the organic layer that is in direct contact with the anode in the second organic electroluminescent device is a third organic layer containing a third organic material and a fourth organic material, and materials in at least one of the following two groups are the same: group (i): the first organic material and the third organic material, and group (ii): the second organic material and the fourth organic material; and
the third organic layer in the second organic electroluminescent device at least satisfies one of the following requirements:

(1) the highest occupied molecular orbital (HOMO) energy level of the fourth organic material is denoted as $HOMO_{fourth_organic_material}$, and $HOMO_{fourth_organic_material} > -5.1$ eV;
(2) the lowest unoccupied molecular orbital (LUMO) energy level of the third organic material is denoted as $LUMO_{third_organic_material}$, the HOMO energy level of the fourth organic material is denoted as $HOMO_{fourth_organic_material}$, and $LUMO_{third_organic_material} - HOMO_{fourth_organic_material} < 0.3$ eV;
(3) the third organic layer has a conductivity of less than $3\times10^{-5}$ S/m.

**11.** The first organic electroluminescent device according to claim 10, wherein in the first organic electroluminescent device, the LUMO energy level of the first organic material is denoted as $LUMO_{first_organic_material}$, the HOMO energy level of the second organic material is denoted as $HOMO_{second_organic_material}$, and $LUMO_{first_organic_material} - HOMO_{second_organic_material} \geq 0.3$ eV.

**12.** The first organic electroluminescent device according to claim 10, wherein in the first organic electroluminescent device, the HOMO energy level of the second organic material is denoted as $HOMO_{second_organic_material}$, and $HOMO_{second_organic_material} \leq -5.1$ eV.

**13.** The first organic electroluminescent device according to claim 10, wherein EQE of the first organic electroluminescent device is higher than 103% of the EQE of the second organic electroluminescent device at the same current density;

preferably, the EQE of the first organic electroluminescent device is higher than 110% of the EQE of the second organic electroluminescent device;
more preferably, the EQE of the first organic electroluminescent device is higher than 120% of the EQE of the second organic electroluminescent device.

**14.** The first organic electroluminescent device according to claim 10, wherein $\eta$ of the first organic electroluminescent device at 15 $mA/cm^2$ is > 7.19;

preferably, $\eta$ of the first organic electroluminescent device at 15 $mA/cm^2$ is > 7.3;

more preferably, η of the first organic electroluminescent device at 15 mA/cm$^2$ is > 7.4.

**15.** The organic electroluminescent device according to any one of claims 1 to 14, wherein the first organic material has a structure represented by one of Formula 1 to Formula 3:

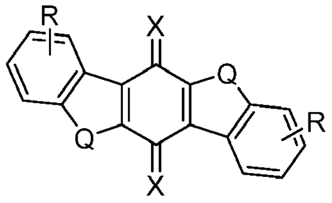
Formula 1 ,
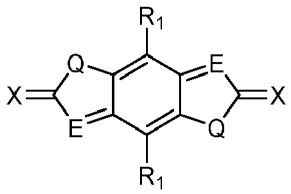
Formula 2 or
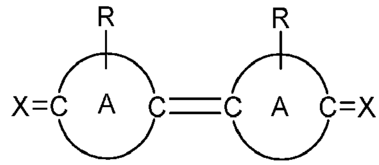
Formula 3 ;

wherein in Formula 1, Formula 2 or Formula 3,

E is, at each occurrence identically or differently, selected from N or $CR_1$;
X is, at each occurrence identically or differently, selected from the group consisting of: NR', CR″R‴, O, S and Se;
the ring A is, at each occurrence identically or differently, a five-membered heterocyclic ring containing one intracyclic double bond, at least one N atom and at least one Q;
Q is, at each occurrence identically or differently, selected from the group consisting of O, S, Se and $NR_N$;
R represents, at each occurrence identically or differently, mono-substitution, multiple substitutions or non-substitution;
R, $R_1$, R′, R″, R‴ and $R_N$ are, at each occurrence identically or differently, selected from the group consisting of: hydrogen, deuterium, halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group, a phosphoroso group, a hydroxyl group, a sulfanyl group, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms and combinations thereof;
at least one of substituents R, $R_1$, R′, R″ and R‴ is a group having at least one electron withdrawing group; and
adjacent substituents R, R', R", R'" can be optionally joined to form a ring;
preferably, the first organic material has a structure represented by Formula 1 or Formula 3.

**16.** The organic electroluminescent device according to claim 15, wherein X is, at each occurrence identically or differently, selected from CR″R‴ or NR', and each of R′, R″ and R‴ is a group having at least one electron withdrawing group; preferably, each of R, R', R" and R'" is a group having at least one electron withdrawing group.

**17.** The organic electroluminescent device according to claim 15 or 16, wherein X is, at each occurrence identically or differently, selected from the group consisting of the following structures:

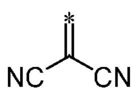
**X-1** ,
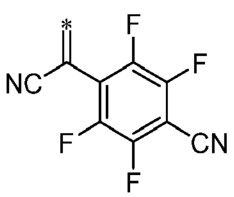
**X-2** ,
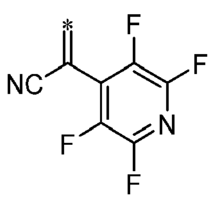
**X-3** ,
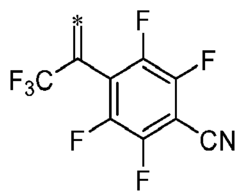
**X-4** ,
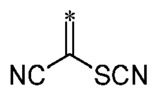
**X-5** ,
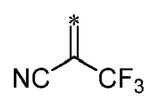
**X-6** ,

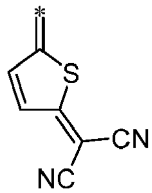

**X-7** ;

preferably, X is selected from X-1.

**18.** The organic electroluminescent device according to claim 15, wherein Q is, at each occurrence identically or differently, selected from O or S.

**19.** The organic electroluminescent device according to claim 15, wherein R and $R_1$ are, at each occurrence identically or differently, selected from the group consisting of: hydrogen, deuterium, halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group, a phosphoroso group, unsubstituted alkyl having 1 to 20 carbon atoms, unsubstituted cycloalkyl having 3 to 20 ring carbon atoms, unsubstituted alkoxy having 1 to 20 carbon atoms, unsubstituted alkenyl having 2 to 20 carbon atoms, unsubstituted aryl having 6 to 30 carbon atoms, unsubstituted heteroaryl having 3 to 30 carbon atoms, any one of the following groups substituted with one or more of halogen, a nitroso group, a nitro group, an acyl group, a carbonyl group, a carboxylic acid group, an ester group, a cyano group, an isocyano group, SCN, OCN, $SF_5$, a boryl group, a sulfinyl group, a sulfonyl group and a phosphoroso group: alkyl having 1 to 20 carbon atoms, cycloalkyl having 3 to 20 ring carbon atoms, alkoxy having 1 to 20 carbon atoms, alkenyl having 2 to 20 carbon atoms, aryl having 6 to 30 carbon atoms and heteroaryl having 3 to 30 carbon atoms, and combinations thereof;

preferably, R and $R_1$ are, at each occurrence identically or differently, selected from the group consisting of: hydrogen, deuterium, methyl, isopropyl, $NO_2$, $SO_2CH_3$, $SCF_3$, $C_2F_5$, $OC_2F_5$, $OCH_3$, diphenylmethylsilyl, phenyl, methoxyphenyl, *p*-methylphenyl, 2,6-diisopropylphenyl, biphenyl, polyfluorophenyl, difluoropyridyl, nitrophenyl, dimethylthiazolyl, vinyl substituted with one or more of CN or $CF_3$, acetenyl substituted with one of CN or $CF_3$, dimethylphosphoroso, diphenylphosphoroso, F, $CF_3$, $OCF_3$, $SF_5$, $SO_2CF_3$, cyano, isocyano, SCN, OCN, trifluoromethylphenyl, trifluoromethoxyphenyl, bis(trifluoromethyl)phenyl, bis(trifluoromethoxy)phenyl, 4-cyanotetrafluorophenyl, phenyl or biphenyl substituted with one or more of F, CN or $CF_3$, tetrafluoropyridyl, pyrimidinyl, triazinyl, diphenylboryl, oxaboraanthryl and combinations thereof.

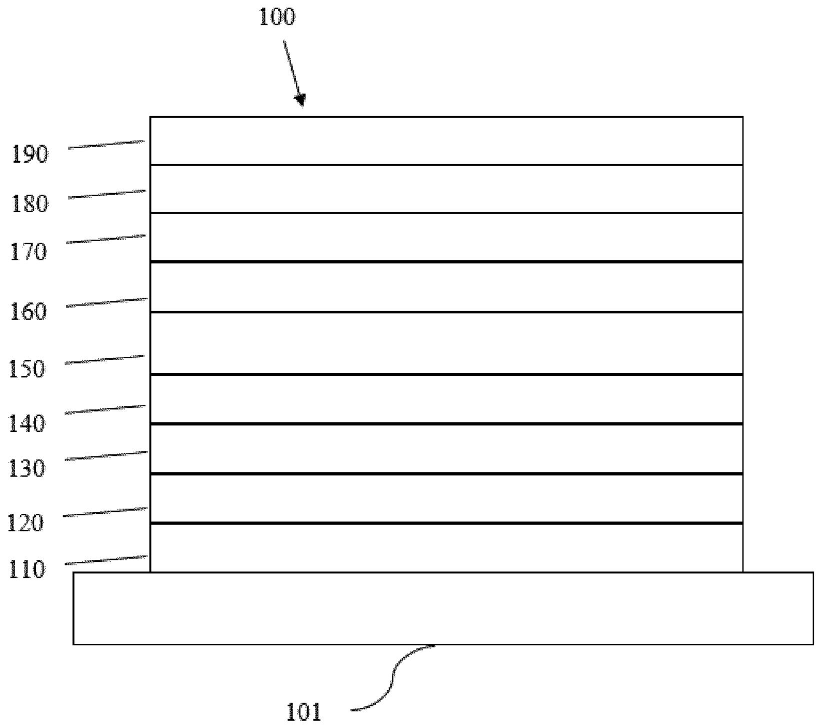
100
190
180
170
160
150
140
130
120
110
101

FIG. 1

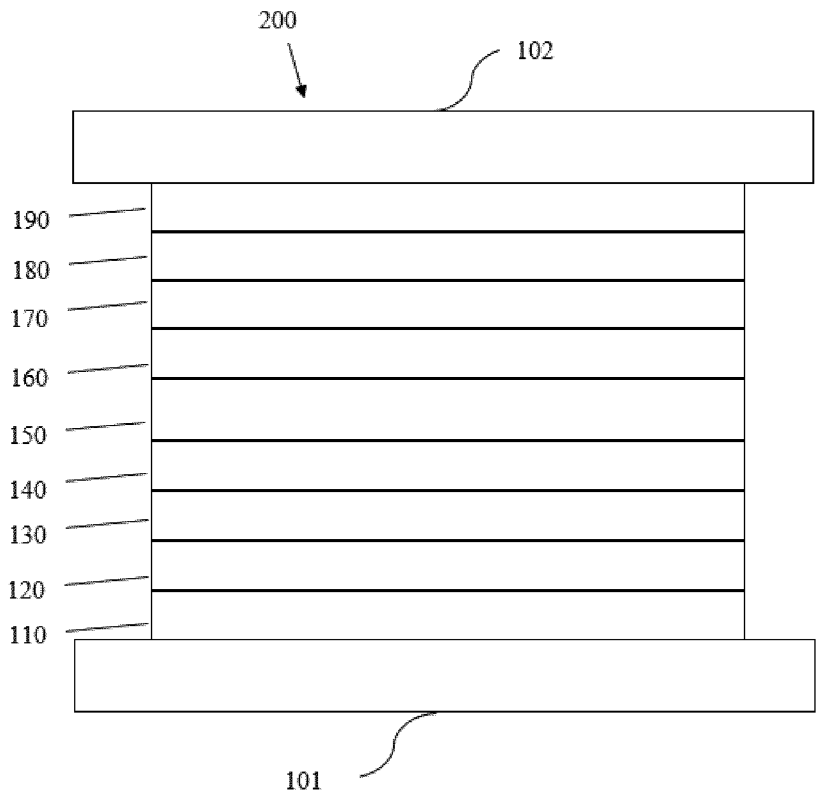
200
102
190
180
170
160
150
140
130
120
110
101

FIG. 2

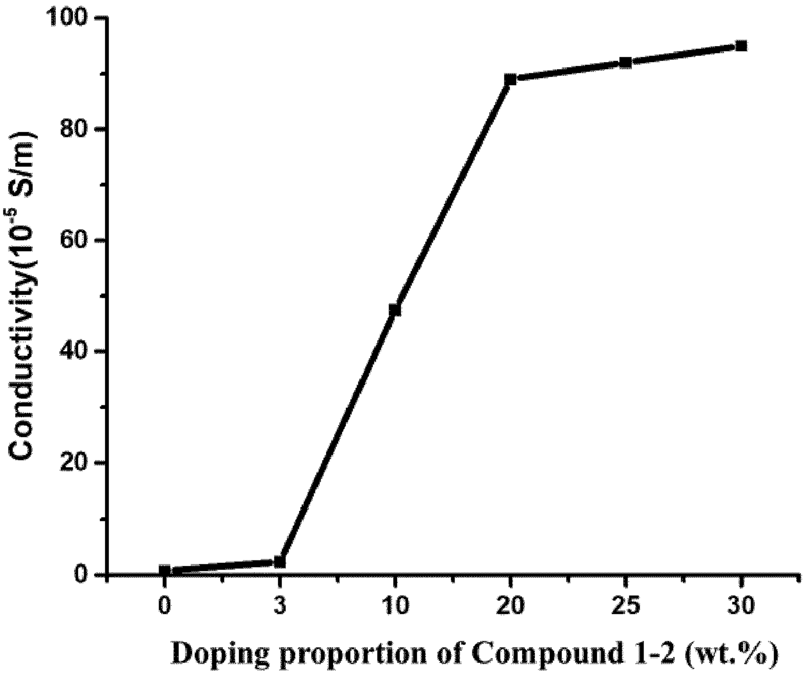
Conductivity(10^-5 S/m)
100
80
60
40
20
0
0
3
10
20
25
30
Doping proportion of Compound 1-2 (wt.%)

FIG. 3

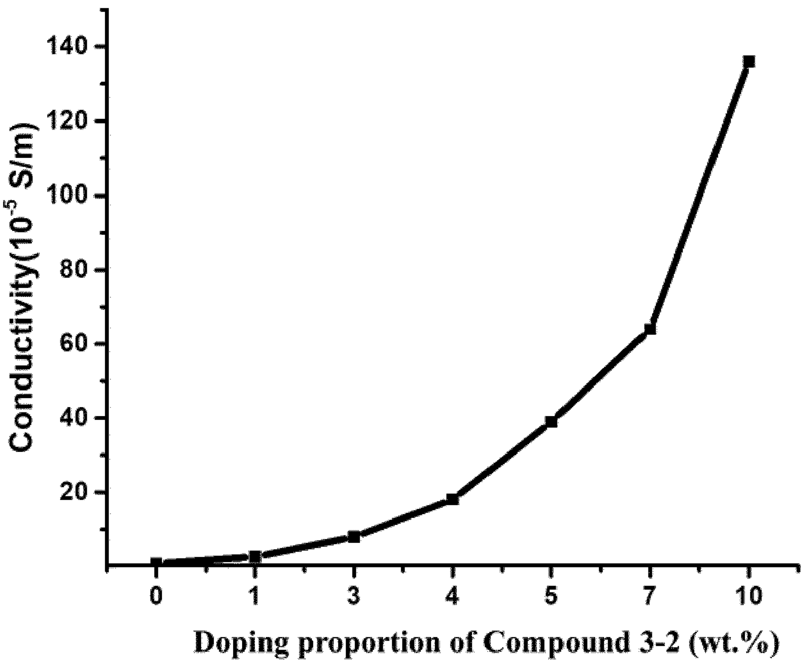
Conductivity(10^-5 S/m)
140
120
100
80
60
40
20
0
1
3
4
5
7
10
Doping proportion of Compound 3-2 (wt.%)

FIG. 4

Europäisches Patentamt
European Patent Office
Office européen des brevets

# EUROPEAN SEARCH REPORT

Application Number
EP 22 18 3727

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/167298 A1 (PANG HUIQING [CN] ET AL) 3 June 2021 (2021-06-03)<br>* examples 1-5 *<br>----- | 1-19 | INV.<br>H01L51/50<br><br>ADD.<br>H01L51/30 |
| X | US 2010/289008 A1 (JANG JUN-GI [KR] ET AL) 18 November 2010 (2010-11-18)<br>* example 1 *<br>----- | 1-19 | |
| T | KROGER M ET AL: "P-type doping of organic wide band gap materials by transition metal oxides: A case-study on Molybdenum trioxide",<br>ORGANIC ELECTRONICS, ELSEVIER, AMSTERDAM, NL,<br>vol. 10, no. 5, 1 August 2009 (2009-08-01), pages 932-938, XP026235906,<br>ISSN: 1566-1199, DOI: 10.1016/J.ORGEL.2009.05.007<br>[retrieved on 2009-05-10]<br>----- | | |
| T | MARKUS GANTENBEIN ET AL: "New 4,4′-Bis(9-carbazolyl)–Biphenyl Derivatives with Locked Carbazole–Biphenyl Junctions: High-Triplet State Energy Materials",<br>CHEMISTRY OF MATERIALS,<br>vol. 27, no. 5, 10 March 2015 (2015-03-10), pages 1772-1779, XP055191916,<br>ISSN: 0897-4756, DOI: 10.1021/cm5045754<br>----- | | TECHNICAL FIELDS SEARCHED (IPC)<br><br>H01L |
| T | TING ZHANG ET AL: "A CBP derivative as bipolar host for performance enhancement in phosphorescent organic light-emitting diodes",<br>JOURNAL OF MATERIALS CHEMISTRY C,<br>vol. 1, no. 4, 1 January 2013 (2013-01-01), pages 757-764, XP055191881,<br>ISSN: 2050-7526, DOI: 10.1039/C2TC00305H<br>-----<br>-/-- | | |

The present search report has been drawn up for all claims

1

| Place of search | Date of completion of the search | Examiner |
|---|---|---|
| Munich | 10 November 2022 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 22 18 3727

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | JUNG-HWAN PARK ET AL: "New Bipolar Green Host Materials Containing Benzimidazole-Carbazole Moiety in Phosphorescent OLEDs", BULLETIN OF THE KOREAN CHEMICAL SOCIETY, vol. 32, no. 3, 20 March 2011 (2011-03-20), pages 841-846, XP055191890, ISSN: 0253-2964, DOI: 10.5012/bkcs.2011.32.3.841 ----- | | |
| T | NAMDAS EBINAZAR ET AL: "Simple color tuning of phosphorescent dendrimer light emitting diodes", APPLIED PHYSICS LETTERS, AMERICAN INSTITUTE OF PHYSICS, 2 HUNTINGTON QUADRANGLE, MELVILLE, NY 11747, vol. 86, no. 16, 11 April 2005 (2005-04-11), pages 161104-161104, XP012065079, ISSN: 0003-6951, DOI: 10.1063/1.1899256 ----- | | |
| | | | TECHNICAL FIELDS SEARCHED (IPC) |

The present search report has been drawn up for all claims

1

| Place of search | Date of completion of the search | Examiner |
|---|---|---|
| Munich | 10 November 2022 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 22 18 3727

This annex lists the patent family members relating to the patent documents cited in the above-mentioned European search report. The members are as contained in the European Patent Office EDP file on
The European Patent Office is in no way liable for these particulars which are merely given for the purpose of information.

10-11-2022

| Patent document cited in search report | Publication date | Patent family member(s) | Publication date |
|---|---|---|---|
| US 2021167298 A1 | 03-06-2021 | CN 112909188 A | 04-06-2021 |
| | | JP 7164892 B2 | 02-11-2022 |
| | | JP 2021090055 A | 10-06-2021 |
| | | KR 20210070215 A | 14-06-2021 |
| | | US 2021167298 A1 | 03-06-2021 |
| US 2010289008 A1 | 18-11-2010 | CN 101400757 A | 01-04-2009 |
| | | EP 1994118 A1 | 26-11-2008 |
| | | JP 5064482 B2 | 31-10-2012 |
| | | JP 5576430 B2 | 20-08-2014 |
| | | JP 2009530809 A | 27-08-2009 |
| | | JP 2012186496 A | 27-09-2012 |
| | | KR 20070093881 A | 19-09-2007 |
| | | TW I376980 B | 11-11-2012 |
| | | US 2010289008 A1 | 18-11-2010 |
| | | WO 2007105906 A1 | 20-09-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 7279704 B
- US 5844363 A
- US 20030230980
- US 6303238 B, Thompson
- US 5703436 A
- US 5707745 A
- US 6097147 A
- US 20040174116
- US 7968146 B
- US 20160359122 A
- US 20150349273 A


### Non-patent literature cited in the description


- **TANG ; VAN SLYKE.** Eastman Kodak reported an organic light-emitting device, which includes an arylamine hole transporting layer and a tris-8-hydroxyquinolato-aluminum layer as an electron transporting layer and a light-emitting layer. *Applied Physics Letters,* 1987, vol. 51 (12), 913-915
- **M. A. ABKOWITZ et al.** studied and compared, in their paper. *J. Phys. Chem. B,* 2000, vol. 104, 3948-3952